(19) Europäisches Patentamt
European Patent Office
Office européen des brevets

(11) EP 4 266 094 A1

(12) # EUROPEAN PATENT APPLICATION
published in accordance with Art. 153(4) EPC

(43) Date of publication:
**25.10.2023 Bulletin 2023/43**

(21) Application number: **21906553.9**

(22) Date of filing: **13.12.2021**

(51) International Patent Classification (IPC):
***G02B 5/22*** (2006.01) ***C08K 5/34*** (2006.01)
***C08L 101/12*** (2006.01) ***H01L 27/144*** (2006.01)
***H01L 27/146*** (2006.01) ***H01L 31/0232*** (2014.01)

(52) Cooperative Patent Classification (CPC):
**C08K 5/34; C08L 101/12; G02B 5/22;
H01L 27/144; H01L 27/146; H01L 31/0232**

(86) International application number:
**PCT/JP2021/045750**

(87) International publication number:
**WO 2022/131191 (23.06.2022 Gazette 2022/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.12.2020 JP 2020208234**

(71) Applicant: **FUJIFILM Corporation
Tokyo 106-8620 (JP)**

(72) Inventor: **YAGI, Kazunari
Haibara-gun, Shizuoka 421-0396 (JP)**

(74) Representative: **HGF
HGF Limited
1 City Walk
Leeds LS11 9DX (GB)**

(54) **COMPOSITION, MEMBRANE, OPTICAL FILTER, SOLID IMAGE PICKUP ELEMENT, IMAGE DISPLAY APPARATUS, AND INFRARED RAY SENSOR**

(57) Provided are a composition containing an infrared absorber and a curable compound, in which the infrared absorber contains a compound represented by Formula (1) and a compound other than the compound represented by Formula (1); a film formed of the composition; an optical filter; a solid-state imaging element; an image display device; and an infrared sensor.

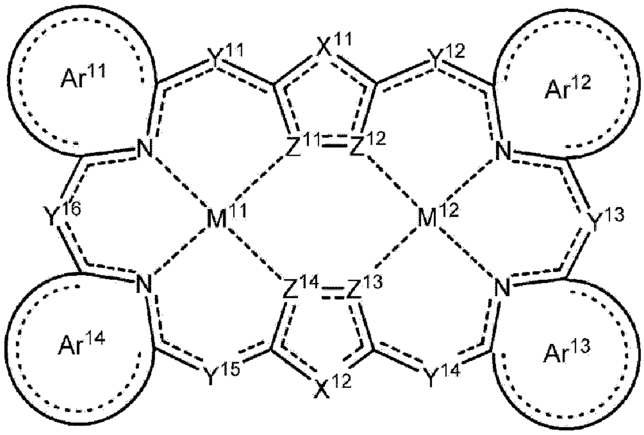

(1)

EP 4 266 094 A1

FIG. 1

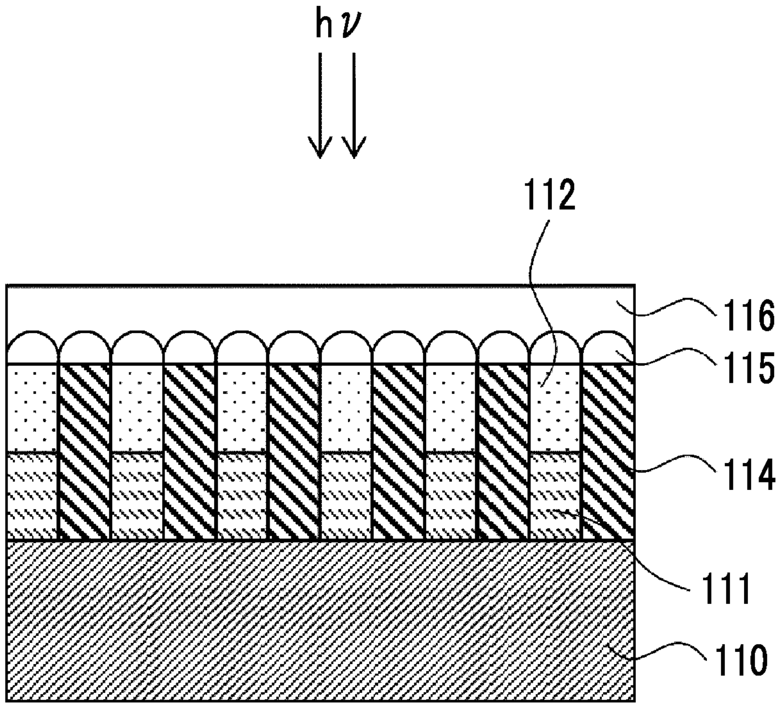

## Description

## BACKGROUND OF THE INVENTION

1. Field of the Invention

The present invention relates to a composition containing an infrared absorber and a curable compound. The present invention also relates to a film formed of the composition, an optical filter, a solid-state imaging element, an image display device, and an infrared sensor.

2. Description of the Related Art

A charge coupled device (CCD) or a complementary metal-oxide semiconductor (CMOS), which are solid-state imaging elements of color images, has been used in video cameras, digital still cameras, mobile phones with camera function, and the like. Silicon photodiodes having sensitivity to infrared rays are used in a light receiving section of these solid-state imaging elements. Therefore, an infrared cut filter may be provided to correct visual sensitivity. The infrared cut filter is manufactured by using a composition containing an infrared absorber and a curable compound.

In addition, an infrared transmitting filter can also be manufactured using a composition containing an infrared absorber and a curable compound. By containing the infrared absorber in the infrared transmitting filter, an infrared region of light (infrared rays) transmitted by the infrared transmitting filter can be shifted to a longer wavelength side.

As described above, an optical filter such as an infrared cut filter and an infrared transmitting filter is formed of the composition containing the infrared absorber and the curable compound.

On the other hand, Patent Literature 1 discloses an invention relating to an invention two-photon absorbing material that is a compound in which 6 to 20 units of a pyrrole ring are bonded through a methine group having an aryl group which may have a substituent to form a ring, in which cyclic porphyrins having a (2n) $\pi$-electron system (n is a natural number of 12 to 42) are used in the entire ring or cyclic porphyrins having a (4n + 2) $\pi$-electron system (n is a natural number of 6 to 20) in the entire ring electron system are used.

[CITATION LIST]

[Patent Literature]

[Patent Literature 1] JP2006-209059A

## SUMMARY OF THE INVENTION

In recent years, there has been a demand for further improvement in spectral characteristics of a film formed of the composition containing an infrared absorber and a curable compound. For example, there is a demand for excellent shielding properties of infrared rays in a wider wavelength range. In addition, there is a demand for further improvement in performance of heat resistance and light resistance.

Therefore, an object of the present invention is to provide a composition with which a film having excellent heat resistance, light resistance, and infrared shielding properties can be formed. Another object of the present invention is to provide a film formed of the composition, an optical filter, a solid-state imaging element, an image display device, and an infrared sensor.

As a result of study on a composition containing an infrared absorber and a curable compound, the present inventor has found that, by using, as the infrared absorber, an infrared absorber containing a compound represented by Formula (1) and a compound other than the compound represented by Formula (1), or by using, as the infrared absorber, an infrared absorber containing a metal complex in which a porphyrin compound having (4n + 2) $\pi$ electrons (n is an integer of 6 to 15) constituting the shortest ring which can resonate around a metal atom is coordinated to the metal atom and a compound other than the metal complex, it is possible to form a film that has excellent shielding properties of infrared rays in a wide wavelength range and that has excellent heat resistance and light resistance, thereby completing the present invention. Therefore, the present invention provides the following.

<1> A composition comprising:

an infrared absorber; and
a curable compound,
in which the infrared absorber contains a compound represented by Formula (1) and a compound other than

the compound represented by Formula (1),

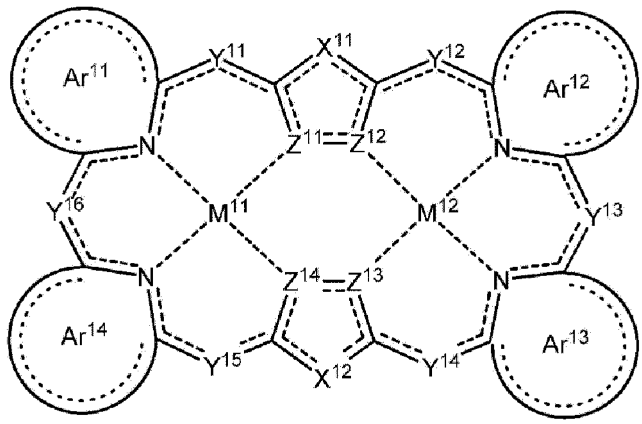

(1)

in Formula (1), $Ar^{11}$ to $Ar^{14}$ each independently represent a 5-membered nitrogen-containing aromatic ring which may be fused to form a polycyclic aromatic ring,

$Y^{11}$ to $Y^{16}$ each independently represent a nitrogen atom or $CR^{Y11}$, where $R^{Y11}$ represents a hydrogen atom or a substituent,

$X^{11}$ and $X^{12}$ each independently represent a nitrogen atom or $CR^{X11}$, where $R^{X11}$ represents a hydrogen atom or a substituent,

$Z^{11}$ and $Z^{14}$ each independently represent a carbon atom or a nitrogen atom,

$M^{11}$ and $M^{12}$ each independently represent a metal atom to which a ligand may be coordinated,

a bond shown by a dotted line between $Z^{11}$ and $M^{11}$ represents a covalent bond in a case where $Z^{11}$ is the carbon atom, and represents a coordinate bond or a covalent bond in a case where $Z^{11}$ is the nitrogen atom,

a bond shown by a dotted line between $Z^{12}$ and $M^{12}$ represents a covalent bond in a case where $Z^{12}$ is the carbon atom, and represents a coordinate bond or a covalent bond in a case where $Z^{12}$ is the nitrogen atom,

a bond shown by a dotted line between $Z^{13}$ and $M^{12}$ represents a covalent bond in a case where $Z^{13}$ is the carbon atom, and represents a coordinate bond or a covalent bond in a case where $Z^{13}$ is the nitrogen atom,

a bond shown by a dotted line between $Z^{14}$ and $M^{11}$ represents a covalent bond in a case where $Z^{14}$ is the carbon atom, and represents a coordinate bond or a covalent bond in a case where $Z^{14}$ is the nitrogen atom,

a bond shown by a dotted line between $M^{11}$ and N represents a coordinate bond or a covalent bond, and

a bond shown by a dotted line between $M^{12}$ and N represents a coordinate bond or a covalent bond.

<2> The composition according to <1>,
in which the compound other than the compound represented by Formula (1) is a compound in which a maximal absorption wavelength is present on a shorter wavelength side than the compound represented by Formula (1).

<3> The composition according to <1> or <2>,

in which the compound represented by Formula (1) is at least one selected from a compound represented by Formula (1-1) or a compound represented by Formula (1-2),

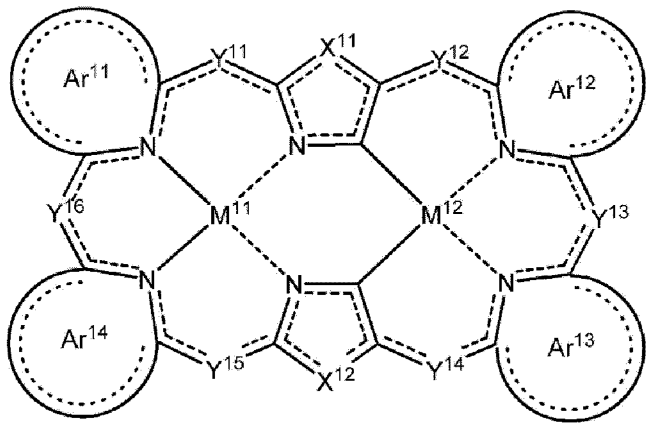

(1-1)

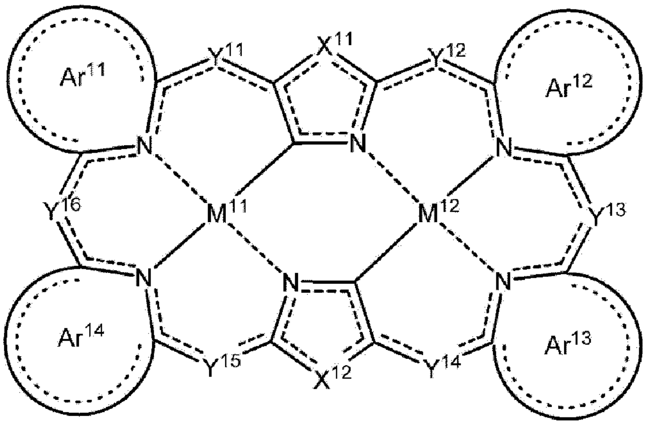

(1-2)

in Formula (1-1) and Formula (1-2), $Ar^{11}$ to $Ar^{14}$ each independently represent a 5-membered nitrogen-containing aromatic ring which may be fused to form a polycyclic aromatic ring,

$Y^{11}$ to $Y^{16}$ each independently represent a nitrogen atom or $CR^{Y11}$, where $R^{Y11}$ represents a hydrogen atom or a substituent,

$X^{11}$ and $X^{12}$ each independently represent a nitrogen atom or $CR^{X11}$, where $R^{X11}$ represents a hydrogen atom or a substituent,

$M^{11}$ and $M^{12}$ each independently represent a metal atom to which a ligand may be coordinated,

a bond shown by a dotted line between $M^{11}$ and N represents a coordinate bond, and a bond shown by a solid line between $M^{11}$ and N represents a covalent bond, and

a bond shown by a dotted line between $M^{12}$ and N represents a coordinate bond, and a bond shown by a solid line between $M^{12}$ and N represents a covalent bond.

<4> The composition according to any one of <1> to <3>,
in which a maximal absorption wavelength of the compound represented by Formula (1) is present in a wavelength range of 1200 to 1500 nm.
<5> A composition comprising:

an infrared absorber; and
a curable compound,
in which the infrared absorber contains a metal complex in which a porphyrin compound having (4n + 2) $\pi$ electrons constituting a shortest ring which is capable of resonating around a metal atom is coordinated to the metal atom, and a compound other than the metal complex, where n is an integer of 6 to 15.

<6> The composition according to <5>,
in which the compound other than the metal complex is a compound in which a maximal absorption wavelength is present on a shorter wavelength side than the metal complex.
<7> The composition according to <5> or <6>,
in which a maximal absorption wavelength of the metal complex is present in a wavelength range of 1200 to 1500 nm.
<8> The composition according to any one of <1> to <7>,
in which the curable compound contains a resin having an acid group.
<9> The composition according to any one of <1> to <8>,
in which the curable compound contains a polymerizable compound.
<10> The composition according to any one of <1> to <9>,
in which the curable compound contains a resin having a glass transition temperature of 150°C or higher.
<11> A film formed of the composition according to any one of <1> to <10>.
<12> An optical filter comprising:
the film according to <11>.
<13> A solid-state imaging element comprising:
the film according to <11>.
<14> An image display device comprising:
the film according to <11>.
<15> An infrared sensor comprising:
the film according to <11>.

According to the present invention, it is possible to provide a composition with which a film having excellent heat resistance, light resistance, and infrared shielding properties can be formed, a film, an optical filter, a solid-state imaging element, an image display device, and an infrared sensor.

## BRIEF DESCRIPTION OF THE DRAWINGS

Fig. 1 is a schematic diagram indicating an embodiment of an infrared sensor.

## DESCRIPTION OF THE PREFERRED EMBODIMENTS

Hereinafter, the details of the present invention will be described.

In the present specification, numerical ranges represented by "to" include numerical values before and after "to" as lower limit values and upper limit values.

In the present specification, unless specified as a substituted group or as an unsubstituted group, a group (atomic group) denotes not only a group (atomic group) having no substituent but also a group (atomic group) having a substituent. For example, "alkyl group" denotes not only an alkyl group having no substituent (unsubstituted alkyl group) but also an alkyl group having a substituent (substituted alkyl group).

In the present specification, unless specified otherwise, "exposure" denotes not only exposure using light but also drawing using a corpuscular beam such as an electron beam or an ion beam. Examples of the light used for exposure include an actinic ray or radiation, for example, a bright light spectrum of a mercury lamp, a far ultraviolet ray represented by excimer laser, an extreme ultraviolet ray (EUV light), an X-ray, or an electron beam.

In the present specification, "(meth)acrylate" denotes either or both of acrylate and methacrylate, "(meth)acryl" denotes either or both of acryl and methacryl, and "(meth)acryloyl" denotes either or both of acryloyl and methacryloyl.

In the present specification, a weight-average molecular weight and a number-average molecular weight are defined as values in terms of polystyrene measured by gel permeation chromatography (GPC).

In the present specification, in a chemical formula, Me represents a methyl group, Et represents an ethyl group, Bu represents a butyl group, and Ph represents a phenyl group.

In the present specification, infrared rays denote light (electromagnetic wave) having a wavelength in a range of 700 to 2500 nm.

In the present specification, a total solid content denotes the total mass of all the components of the composition excluding a solvent.

In the present specification, a pigment means a coloring material which is hardly dissolved in a solvent.

In the present specification, the term "step" denotes not only an individual step but also a step which is not clearly distinguishable from another step as long as an effect expected from the step can be achieved.

<Composition>

A first aspect of the composition according to the present invention is a composition containing an infrared absorber and a curable compound, in which the infrared absorber contains a compound represented by Formula (1) and a compound other than the compound represented by Formula (1).

In addition, a second aspect of the composition according the present invention is a composition containing an infrared absorber and a curable compound, in which the infrared absorber contains a metal complex in which a porphyrin compound having $(4n + 2)\pi$ electrons constituting the shortest ring which can resonate around a metal atom is coordinated to the metal atom, and a compound other than the metal complex. n is an integer of 6 to 15.

In the above-described compound represented by Formula (1) and the above-described metal complex (hereinafter, both are collectively referred to as a specific infrared absorbing compound), due to rigidity of a molecule derived from multidentate-coordinated metal center, heat resistance and light resistance are excellent. In addition, since the above-described specific infrared absorbing compound has a wide $\pi$-conjugated system, the maximal absorption wavelength is present on the longer wavelength side, and shielding properties of infrared rays on the relatively long wavelength side are excellent. By using, as the infrared absorber, the above-described specific infrared absorbing compound and a compound other than the specific infrared absorbing compound (hereinafter, also referred to as other infrared absorbing compounds), it is possible to form a film having excellent heat resistance and light resistance and excellent shielding properties of infrared rays in a wider wavelength range. That is, with the composition according to the embodiment of the present invention, it is possible to form a film having excellent heat resistance, light resistance, and infrared shielding properties. Among these, in a case where a compound having a maximal absorption wavelength on the shorter wavelength side than the specific infrared absorbing compound is used as the other infrared absorbing compounds, it is possible to form a film having more excellent light resistance. Although the detailed reason for obtaining such an effect is not known, it is presumed that energy absorbed by the other infrared absorbing compounds can be moved to the specific infrared

absorbing compound side having excellent light resistance and dissipated, and decomposition or the like of the other infrared absorbing compounds can be suppressed.

The composition according to the embodiment of the present invention can be used as a composition for an optical filter. Examples of the type of the optical filter include an infrared cut filter and an infrared transmitting filter. In addition, the composition according to the embodiment of the present invention is preferably used for an infrared sensor. More specifically, the composition according to the embodiment of the present invention is preferably used as a composition for the above-described optical filter of an infrared sensor having the optical filter.

Hereinafter, each of the components used in the composition according to the embodiment of the present invention will be described.

<<Infrared absorber>>

The composition according to the embodiment of the present invention contains an infrared absorber. The infrared absorber used in the composition according to the embodiment of the present invention contains a compound represented by Formula (1) and a compound other than the compound represented by Formula (1), or contains a metal complex in which a porphyrin compound having (4n + 2) $\pi$ electrons (n is an integer of 6 to 15) constituting the shortest ring which can resonate around a metal atom is coordinated to the metal atom. Hereinafter, the compound represented by Formula (1) and the above-described metal complex are collectively referred to as a specific infrared absorbing compound.

(Specific infrared absorbing compound)

First, a metal complex used as the specific infrared absorbing compound will be described.

The metal complex used as the specific infrared absorbing compound is a compound in which a porphyrin compound having (4n + 2) $\pi$ electrons (n is an integer of 6 to 15) constituting the shortest ring which can resonate around a metal atom is coordinated to the metal atom.

Examples of the metal atom coordinated by the above-described porphyrin compound include Mg, Al, Si, Ti, V, Cr, Mn, Fe, Co, Ni, Cu, Zn, Mo, Ru, Rh, Pd, Ag, Pt, Au, and Er, and from the viewpoint of chemical stability of the metal complex, the metal atom is preferably a metal atom of Group 3 to 14, and more preferably a metal atom of Group 3 to 14 and a 3rd or 4th period. A ligand may be coordinated to these metal atoms. Examples of the ligand include a heterocyclic compound (for example, pyridine, pyrimidine, imidazole, pyrazole, triazole, tetrazole, quinoline, 1,10-phenanthroline, and the like), a protonic compound (for example, water, methanol, ethanol, and the like), an amine compound (for example, triethylamine, N,N,N',N'-tetramethylenediamine, ethylenediamine tetraacetic acid, N,N,N',N",N"-pentamethyldiethylenetriamine, and the like), an amide compound (for example, N,N-dimethylacetamide, N-methylpyrrolidone, and the like), dimethylsulfoxide, sulfolane, a nitrile compound (for example, acetonitrile and the like), and a $\pi$-electron ligand (cyclopentadiene anion, norbornadiene, and the like).

Examples of the above-described porphyrin compound include a compound having a structure in which pyrrole rings are bonded through a methine group which may have a substituent to form a ring. The number of pyrrole rings constituting the porphyrin ring included in the above-described porphyrin compound is preferably 6 to 12, more preferably 6 to 8, and still more preferably 6. Specific examples of the porphyrin ring include a hexaphyrin ring, a heptaphyrin ring, an octaphyrin ring, a nonaphyrin ring, decaphyrins, an undecaphyrin ring, and a dodecaphyrin ring. The porphyrin ring of the porphyrin compound may have a substituent. Examples of the substituent include a substituent T described later. In addition, adjacent substituents may be bonded to each other to form a ring.

The metal complex used as the specific infrared absorbing compound is preferably a compound represented by Formula (1) described later.

Next, a compound represented by Formula (1) used as the specific infrared absorbing compound will be described.

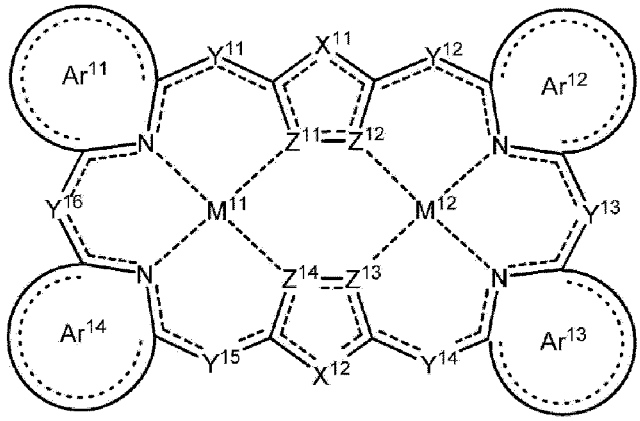

(1)

In Formula (1), $Ar^{11}$ to $Ar^{14}$ each independently represent a 5-membered nitrogen-containing aromatic ring which may be fused to form a polycyclic aromatic ring,

$Y^{11}$ to $Y^{16}$ each independently represent a nitrogen atom or $CR^{Y11}$, where $R^{Y11}$ represents a hydrogen atom or a substituent,
$X^{11}$ and $X^{12}$ each independently represent a nitrogen atom or $CR^{X11}$, where $R^{X11}$ represents a hydrogen atom or a substituent,
$Z^{11}$ and $Z^{14}$ each independently represent a carbon atom or a nitrogen atom,
$M^{11}$ and $M^{12}$ each independently represent a metal atom to which a ligand may be coordinated,
a bond shown by a dotted line between $Z^{11}$ and $M^{11}$ represents a covalent bond in a case where $Z^{11}$ is the carbon atom, and represents a coordinate bond or a covalent bond in a case where $Z^{11}$ is the nitrogen atom,
a bond shown by a dotted line between $Z^{12}$ and $M^{12}$ represents a covalent bond in a case where $Z^{12}$ is the carbon atom, and represents a coordinate bond or a covalent bond in a case where $Z^{12}$ is the nitrogen atom,
a bond shown by a dotted line between $Z^{13}$ and $M^{12}$ represents a covalent bond in a case where $Z^{13}$ is the carbon atom, and represents a coordinate bond or a covalent bond in a case where $Z^{13}$ is the nitrogen atom,
a bond shown by a dotted line between $Z^{14}$ and $M^{11}$ represents a covalent bond in a case where $Z^{14}$ is the carbon atom, and represents a coordinate bond or a covalent bond in a case where $Z^{14}$ is the nitrogen atom,
a bond shown by a dotted line between $M^{11}$ and N represents a coordinate bond or a covalent bond, and
a bond shown by a dotted line between $M^{12}$ and N represents a coordinate bond or a covalent bond.

$Ar^{11}$ to $Ar^{14}$ in Formula (1) each independently represent a 5-membered nitrogen-containing aromatic ring which may be fused to form a polycyclic aromatic ring. Examples of the nitrogen-containing aromatic ring represented by $Ar^{11}$ to $Ar^{14}$ include a pyrrole ring, an imidazole ring, a pyrazole ring, an oxazole ring, a thiazole ring, a triazole ring, a tetrazole ring, and a fused ring containing these rings. Examples of the fused ring include an indole ring, an isoindole ring, a benzimidazole ring, a benzoxazole ring, a benzothiazole ring, a benzotriazole ring, and a purine ring. The nitrogen-containing aromatic ring represented by $Ar^{11}$ to $Ar^{14}$ is preferably a pyrrole ring or a fused ring containing the ring, and more preferably a pyrrole ring. The nitrogen-containing aromatic ring represented by $Ar^{11}$ to $Ar^{14}$ may have a substituent. Examples of the substituent include groups mentioned as the substituent T described later, and a halogen atom, an alkoxy group, an aryloxy group, an alkoxycarbonyl group, or an aminocarbonyl group is preferable.

$Y^{11}$ to $Y^{16}$ in Formula (1) each independently represent a nitrogen atom or $CR^{Y11}$, preferably $CR^{Y11}$. $R^{Y11}$ represents a hydrogen atom or a substituent. Examples of the substituent represented by $R^{Y11}$ include groups mentioned as the substituent T described later, and an alkyl group, an aryl group, or a heteroaryl group is preferable and an aryl group is more preferable. These groups may further have a substituent. Examples of the further substituent include groups mentioned as the substituent T described later, and a halogen atom, an alkyl group, an alkoxy group, an aryloxy group, an alkoxycarbonyl group, or an aminocarbonyl group is preferable. In a case where the nitrogen-containing aromatic ring represented by $Ar^{11}$ to $Ar^{14}$ has a substituent, $R^{Y11}$ may be bonded to the substituent to form a ring.

$X^{11}$ and $X^{12}$ in Formula (1) each independently represent a nitrogen atom or $CR^{X11}$. Examples of the substituent represented by $R^{X11}$ include groups mentioned as the substituent T described later, and an alkyl group or an aryl group is preferable.

$Z^{11}$ and $Z^{14}$ in Formula (1) each independently represent a carbon atom or a nitrogen atom. It is preferable that any one of $Z^{11}$ or $Z^{12}$ is a carbon atom and the other is a nitrogen atom. In addition, it is preferable that any one of $Z^{13}$ or $Z^{14}$ is a carbon atom and the other is a nitrogen atom.

As a preferred combination of $X^{11}$, $X^{12}$, $Z^{11}$, $Z^{12}$, $Z^{13}$, and $Z^{14}$, a first aspect or a second aspect shown below

is preferable, and from the reason that it is chemically stable and provides more excellent heat resistance and light resistance, a first aspect is more preferable.

First aspect: aspect in which $X^{11}$ and $X^{12}$ are carbon atoms, any one of $Z^{11}$ or $Z^{12}$ is a carbon atom and the other is a nitrogen atom, and any one of $Z^{13}$ or $Z^{14}$ is a carbon atom and the other is a nitrogen atom
Second aspect: aspect in which $X^{11}$ and $X^{12}$ are nitrogen atoms and $Z^{11}$ to $Z^{14}$ are carbon atoms

Examples of the metal atom represented by $M^{11}$ and $M^{12}$ in Formula (1) include Mg, Al, Si, Ti, V, Cr, Mn, Fe, Co, Ni, Cu, Zn, Mo, Ru, Rh, Pd, Ag, Pt, Au, and Er, and from the viewpoint of chemical stability of the metal complex, the metal atom is preferably a metal atom of Group 3 to 14, and more preferably a metal atom of Group 3 to 14 and a 3rd or 4th period. A ligand may be coordinated to these metal atoms. Examples of the ligand include a heterocyclic compound (for example, pyridine, pyrimidine, imidazole, pyrazole, triazole, tetrazole, quinoline, 1,10-phenanthroline, and the like), a protonic compound (for example, water, methanol, ethanol, and the like), an amine compound (for example, triethylamine, N,N,N',N'-tetramethylenediamine, ethylenediamine tetraacetic acid, N,N,N',N",N"-pentamethyldiethylenetriamine, and the like), an amide compound (for example, N,N-dimethylacetamide, N-methylpyrrolidone, and the like), dimethylsulfoxide, sulfolane, a nitrile compound (for example, acetonitrile and the like), and a $\pi$-electron ligand (cyclopentadiene anion, norbornadiene, and the like).
The metal atom represented by $M^{11}$ and the metal atom represented by $M^{12}$ in Formula (1) may be different from each other, from the viewpoint of ease of production, the metal atoms are preferably the same.
Examples of the substituent T include the following groups: a halogen atom (for example, a fluorine atom, a chlorine atom, a bromine atom, and an iodine atom), an alkyl group (preferably an alkyl group having 1 to 30 carbon atoms), an alkenyl group (preferably an alkenyl group having 2 to 30 carbon atoms), an alkynyl group (preferably an alkynyl group having 2 to 30 carbon atoms), an aryl group (preferably an aryl group having 6 to 30 carbon atoms), a heteroaryl group (preferably a heteroaryl group having 1 to 30 carbon atoms), an amino group (preferably an amino group having 0 to 30 carbon atoms), an alkoxy group (preferably an alkoxy group having 1 to 30 carbon atoms), an aryloxy group (preferably an aryloxy group having 6 to 30 carbon atoms), a heteroaryloxy group (preferably a heteroaryloxy group having 1 to 30 carbon atoms), an acyl group (preferably an acyl group having 2 to 30 carbon atoms), an alkoxycarbonyl group (preferably an alkoxycarbonyl group having 2 to 30 carbon atoms), an aryloxycarbonyl group (preferably an aryloxycarbonyl group having 7 to 30 carbon atoms), a heteroaryloxycarbonyl group (preferably a heteroaryloxycarbonyl group having 2 to 30 carbon atoms), an acyloxy group (preferably an acyloxy group having 2 to 30 carbon atoms), an acylamino group (preferably an acylamino group having 2 to 30 carbon atoms), an aminocarbonylamino group (preferably an aminocarbonylamino group having 2 to 30 carbon atoms), an alkoxycarbonylamino group (preferably an alkoxycarbonylamino group having 2 to 30 carbon atoms), an aryloxycarbonylamino group (preferably an aryloxycarbonylamino group having 7 to 30 carbon atoms), a sulfamoyl group (preferably a sulfamoyl group having 0 to 30 carbon atoms), a sulfamoylamino group (preferably a sulfamoylamino group having 0 to 30 carbon atoms), a carbamoyl group (preferably a carbamoyl group having 1 to 30 carbon atoms), an alkylthio group (preferably an alkylthio group having 1 to 30 carbon atoms), an arylthio group (preferably an arylthio group having 6 to 30 carbon atoms), a heteroarylthio group (preferably a heteroarylthio group having 1 to 30 carbon atoms), an alkylsulfonyl group (preferably an alkylsulfonyl group having 1 to 30 carbon atoms), an alkylsulfonylamino group (preferably an alkylsulfonylamino group having 1 to 30 carbon atoms), an arylsulfonyl group (preferably an arylsulfonyl group having 6 to 30 carbon atoms), an arylsulfonylamino group (preferably an arylsulfonylamino group having 6 to 30 carbon atoms), a heteroarylsulfonyl group (preferably a heteroarylsulfonyl group having 1 to 30 carbon atoms), a heteroarylsulfonylamino group (preferably a heteroarylsulfonylamino group having 1 to 30 carbon atoms), an alkylsulfinyl group (preferably an alkylsulfinyl group having 1 to 30 carbon atoms), an arylsulfinyl group (preferably an arylsulfinyl group having 6 to 30 carbon atoms), a heteroarylsulfinyl group (preferably a heteroarylsulfinyl group having 1 to 30 carbon atoms), a ureide group (preferably a ureide group having 1 to 30 carbon atoms), a hydroxy group, a nitro group, a carboxyl group, a sulfo group, a phosphoric acid group, a carboxylic acid amide group, a sulfonic acid amide group, an imide group, a phosphino group, a mercapto group, a cyano group, an alkylsulfino group, an arylsulphino group, an arylazo group, a heteroarylazo group, a phosphinyl group, a phosphinyloxy group, a phosphinylamino group, a silyl group, a hydradino group, and an imino group. In a case where the above-described groups can be further substituted, the groups may further have a substituent. Examples of the further substituent include the groups described regarding the substituent T above.
It is preferable that the compound represented by Formula (1) is at least one selected from a compound represented by Formula (1-1) or a compound represented by Formula (1-2). In the composition according to the embodiment of the present invention, as the compound represented by Formula (1), only one of the compound represented by Formula (1-1) or the compound represented by Formula (1-2) may be contained, or both the compound represented by Formula (1-1) and the compound represented by Formula (1-2) may be contained. In a case where both the compound represented by Formula (1-1) and the compound represented by Formula (1-2) are contained, by reducing crystallinity of the compound, it is possible to improve storage stability of the composition and form a film in which generation of

foreign matter or the like is suppressed. In the case where both the compound represented by Formula (1-1) and the compound represented by Formula (1-2) are contained, a content of the compound represented by Formula (1-1) is preferably 10 to 1000 parts by mass and more preferably 30 to 300 parts by mass with respect to 100 parts by mass of the compound represented by Formula (1-2).

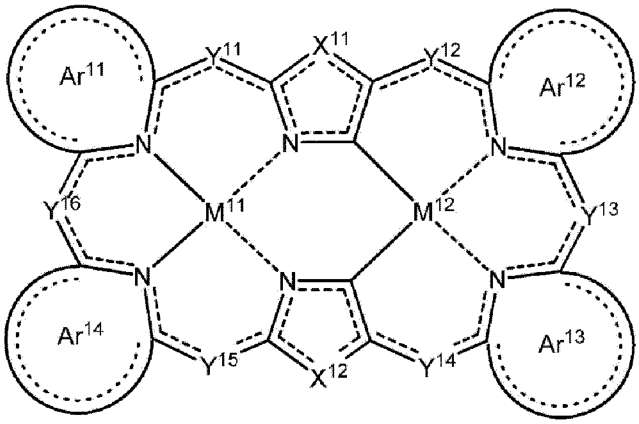

(1-1)

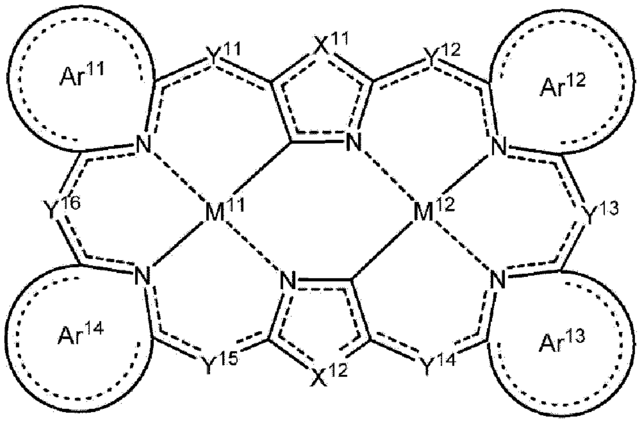

(1-2)

In Formula (1-1) and Formula (1-2), $Ar^{11}$ to $Ar^{14}$ each independently represent a 5-membered nitrogen-containing aromatic ring which may be fused to form a polycyclic aromatic ring,

$Y^{11}$ to $Y^{16}$ each independently represent a nitrogen atom or $CR^{Y11}$, where $R^{Y11}$ represents a hydrogen atom or a substituent,
$X^{11}$ and $X^{12}$ each independently represent a nitrogen atom or $CR^{X11}$, where $R^{X11}$ represents a hydrogen atom or a substituent,
$M^{11}$ and $M^{12}$ each independently represent a metal atom to which a ligand may be coordinated,
a bond shown by a dotted line between $M^{11}$ and N represents a coordinate bond, and a bond shown by a solid line between $M^{11}$ and N represents a covalent bond, and
a bond shown by a dotted line between $M^{12}$ and N represents a coordinate bond, and a bond shown by a solid line between $M^{12}$ and N represents a covalent bond.

$Ar^{11}$ to $Ar^{14}$, $Y^{11}$ to $Y^{16}$, $X^{11}$, $X^{12}$, $M^{11}$, and $M^{12}$ in Formula (1-1) and Formula (1-2) have the same meanings as $Ar^{11}$ to $Ar^{14}$, $Y^{11}$ to $Y^{16}$, $X^{11}$, $X^{12}$, $M^{11}$, and $M^{12}$ in Formula (1), and preferred ranges thereof are also the same.
The compound represented by Formula (1-1) is preferably a compound represented by Formula (1-1-1). In addition, the compound represented by Formula (1-2) is preferably a compound represented by Formula (1-2-1).

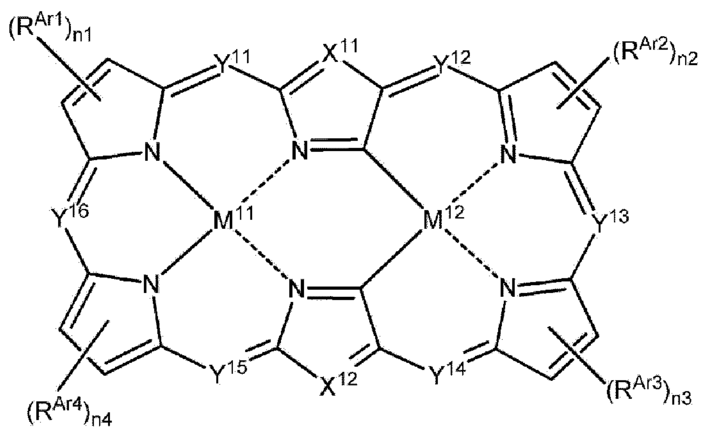

(1-1-1)

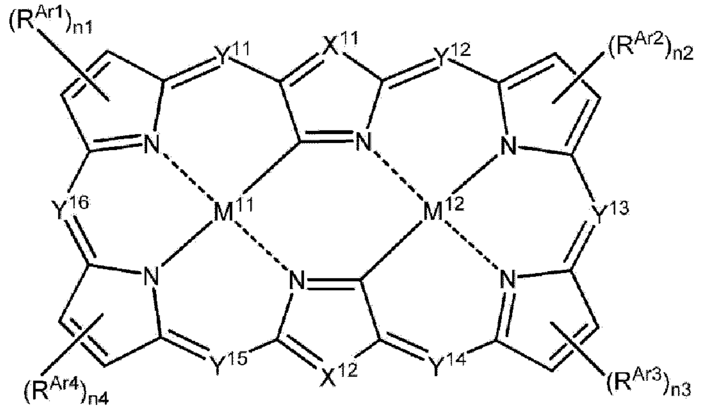

(1-2-1)

In Formula (1-1-1) and Formula (1-2-1), $Y^{11}$ to $Y^{16}$ each independently represent a nitrogen atom or $CR^{Y11}$, where $R^{Y11}$ represents a hydrogen atom or a substituent,

$X^{11}$ and $X^{12}$ each independently represent a nitrogen atom or $CR^{X11}$, where $R^{X11}$ represents a hydrogen atom or a substituent,
$R^{Ar1}$ to $R^{Ar4}$ each independently represent a substituent and $R^{Ar1}$ to $R^{Ar4}$ may be bonded to $R^{Y11}$ to form a ring,
n1 to n4 each independently represent an integer of 0 to 2,
in a case where n1 is 2, two $R^{Ar1}$'s may be bonded to each other to form a ring,
in a case where n2 is 2, two $R^{Ar2}$'s may be bonded to each other to form a ring,
in a case where n3 is 2, two $R^{Ar3}$'s may be bonded to each other to form a ring,
in a case where n4 is 2, two $R^{Ar4}$'s may be bonded to each other to form a ring,
$M^{11}$ and $M^{12}$ each independently represent a metal atom to which a ligand may be coordinated,
a bond shown by a dotted line between $M^{11}$ and N represents a coordinate bond, and a bond shown by a solid line between $M^{11}$ and N represents a covalent bond, and
a bond shown by a dotted line between $M^{12}$ and N represents a coordinate bond, and a bond shown by a solid line between $M^{12}$ and N represents a covalent bond.

$Y^{11}$ to $Y^{16}$, $X^{11}$, $X^{12}$, $M^{11}$, and $M^{12}$ in Formula (1-1-1) and Formula (1-2-1) have the same meanings as $Y^{11}$ to $Y^{16}$, $X^{11}$, $X^{12}$, $M^{11}$, and $M^{12}$ in Formula (1), and preferred ranges thereof are also the same.

Examples of the substituent represented by $R^{Ar1}$ to $R^{Ar4}$ include groups mentioned as the substituent T described above, and a halogen atom, an alkyl group, an alkoxy group, an aryloxy group, an alkoxycarbonyl group, or an aminocarbonyl group is preferable.

n1 to n4 each independently represent an integer of 0 to 2, preferably 0 or 1 and more preferably 0.

The compound represented by Formula (1-1) is preferably a compound represented by Formula (1-1-2). In addition, the compound represented by Formula (1-2) is preferably a compound represented by Formula (1-2-2).

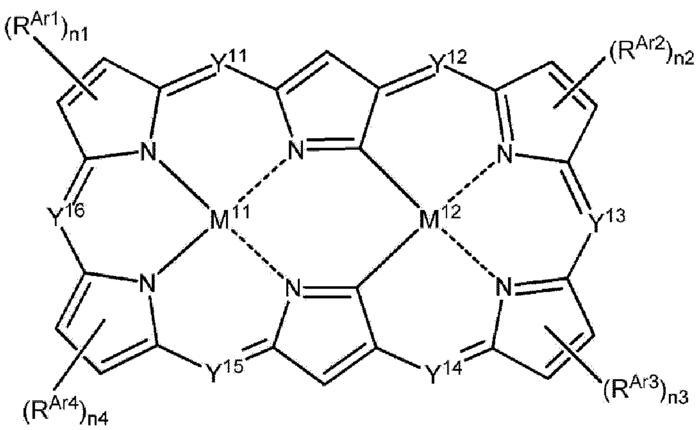

(1-1-2)

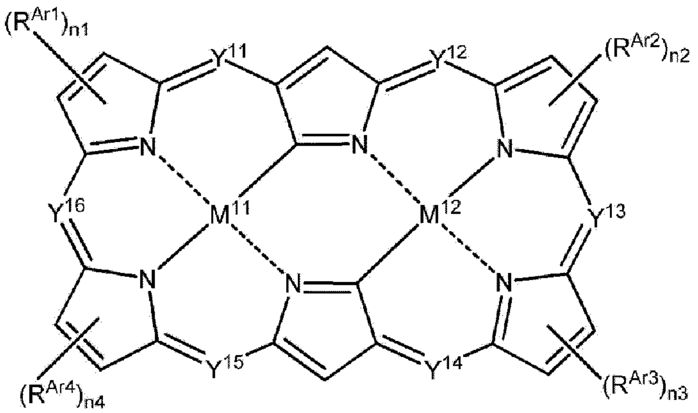

(1-2-2)

In Formula (1-1-2) and Formula (1-2-2), $Y^{11}$ to $Y^{16}$ each independently represent a nitrogen atom or $CR^{Y11}$, where $R^{Y11}$ represents a hydrogen atom or a substituent,

$R^{Ar1}$ to $R^{Ar4}$ each independently represent a substituent and $R^{Ar1}$ to $R^{Ar4}$ may be bonded to $R^{Y11}$ to form a ring,
n1 to n4 each independently represent an integer of 0 to 2,
in a case where n1 is 2, two $R^{Ar1}$'s may be bonded to each other to form a ring,
in a case where n2 is 2, two $R^{Ar2}$'s may be bonded to each other to form a ring,
in a case where n3 is 2, two $R^{Ar3}$'s may be bonded to each other to form a ring,
in a case where n4 is 2, two $R^{Ar4}$'s may be bonded to each other to form a ring,
$M^{11}$ and $M^{12}$ each independently represent a metal atom to which a ligand may be coordinated,
a bond shown by a dotted line between $M^{11}$ and N represents a coordinate bond, and a bond shown by a solid line between $M^{11}$ and N represents a covalent bond, and
a bond shown by a dotted line between $M^{12}$ and N represents a coordinate bond, and a bond shown by a solid line between $M^{12}$ and N represents a covalent bond.

$Y^{11}$ to $Y^{16}$, $M^{11}$, and $M^{12}$ in Formula (1-1-2) and Formula (1-2-2) have the same meanings as $Y^{11}$ to $Y^{16}$, $M^{11}$, and $M^{12}$ in Formula (1), and preferred ranges thereof are also the same. $R^{Ar1}$ to $R^{Ar4}$, and n1 to n4 in Formula (1-1-2) and Formula (1-2-2) have the same meanings as $R^{Ar1}$ to $R^{Ar4}$, and n1 to n4 in Formula (1-1-1) and Formula (1-2-1), and preferred ranges thereof are also the same.

The compound represented by Formula (1-1) is preferably a compound represented by Formula (1-1-3). In addition, the compound represented by Formula (1-2) is preferably a compound represented by Formula (1-2-3).

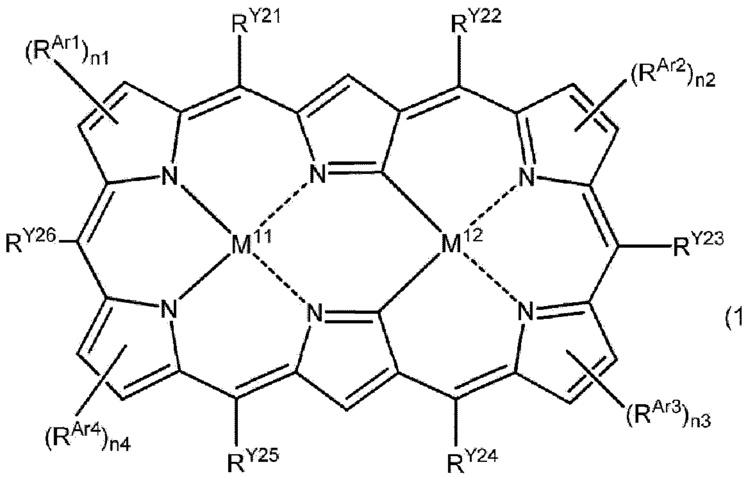

(1-1-3)

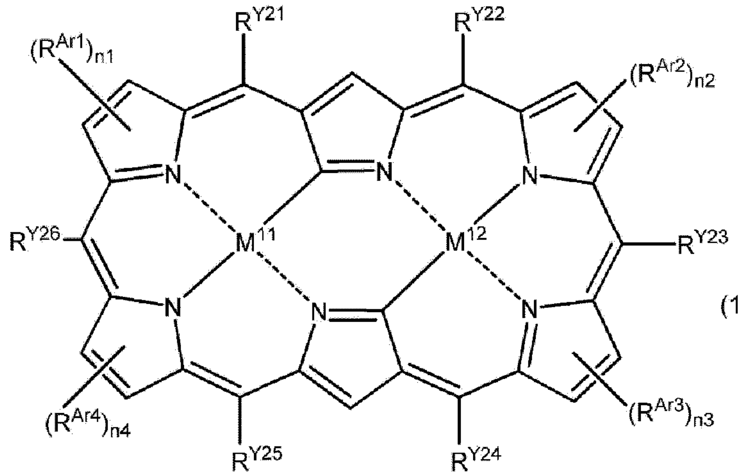

(1-2-3)

In Formula (1-1-3) and Formula (1-2-3), $R^{Y21}$ to $R^{Y26}$ each independently represent a hydrogen atom or a substituent,

$R^{Ar1}$ to $R^{Ar4}$ each independently represent a substituent,
n1 to n4 each independently represent an integer of 0 to 2,
in a case where n1 is 1 or 2, $R^{Ar1}$ and $R^{Y26}$ may be bonded to each other to form a ring,
in a case where n2 is 1 or 2, $R^{Ar2}$ and $R^{Y23}$ may be bonded to each other to form a ring,
in a case where n3 is 1 or 2, $R^{Ar3}$ and $R^{Y23}$ may be bonded to each other to form a ring,
in a case where n4 is 1 or 2, $R^{Ar4}$ and $R^{Y26}$ may be bonded to each other to form a ring,
in a case where n1 is 2, two $R^{Ar1}$'s may be bonded to each other to form a ring,
in a case where n2 is 2, two $R^{Ar2}$'s may be bonded to each other to form a ring,
in a case where n3 is 2, two $R^{Ar3}$'s may be bonded to each other to form a ring,
in a case where n4 is 2, two $R^{Ar4}$'s may be bonded to each other to form a ring,
$M^{11}$ and $M^{12}$ each independently represent a metal atom to which a ligand may be coordinated,
a bond shown by a dotted line between $M^{11}$ and N represents a coordinate bond, and a bond shown by a solid line between $M^{11}$ and N represents a covalent bond, and
a bond shown by a dotted line between $M^{12}$ and N represents a coordinate bond, and a bond shown by a solid line between $M^{12}$ and N represents a covalent bond.

$M^{11}$ and $M^{12}$ in Formula (1-1-3) and Formula (1-2-3) have the same meanings as $M^{11}$ and $M^{12}$ in Formula (1), and preferred ranges thereof are also the same. $R^{Ar1}$ to $R^{Ar4}$, and n1 to n4 in Formula (1-1-3) and Formula (1-2-3) have the same meanings as $R^{Ar1}$ to $R^{Ar4}$, and n1 to n4 in Formula (1-1-1) and Formula (1-2-1), and preferred ranges thereof are also the same.

Examples of the substituent represented by $R^{Y21}$ to $R^{Y26}$ in Formula (1-1-3) and Formula (1-2-3) include the

groups mentioned as the substituent T described above, and an alkyl group, an aryl group, or a heteroaryl group is preferable and an aryl group is more preferable. These groups may further have a substituent. Examples of the further substituent include the groups mentioned as the substituent T described above, and a halogen atom, an alkyl group, an alkoxy group, an aryloxy group, an alkoxycarbonyl group, or an aminocarbonyl group is preferable.

The maximal absorption wavelength of the specific infrared absorbing compound is preferably present in a wavelength range of 1200 to 1500 nm, more preferably present in a wavelength range of 1300 to 1500 nm, and still more preferably present in a wavelength range of 1400 to 1500 nm.

It is preferable that an inclination of a long wavelength end of an absorption spectrum of the specific infrared absorbing compound is steep. In an absorption spectrum standardized by an absorbance at the absorption maximal wavelength, a difference between a wavelength at which the absorbance on the long wavelength side is 0.5 and the absorption maximal wavelength is preferably 200 nm or less, more preferably 150 nm or less, and still more preferably 100 nm or less.

It is preferable that a molar absorption coefficient (ε) of the specific infrared absorbing compound is high. The molar absorption coefficient at the absorption maximal wavelength is preferably 20,000 or more, more preferably 50,000 or more, and still more preferably 100,000 or more.

The specific infrared absorbing compound can be used as either a pigment or a dye.

Specific examples of the specific infrared absorbing compound include compounds having the following structures. In the following structural formulae, Mes represents a 2,4,6-trimethylphenyl group (mesityl group), and Ph represents a phenyl group. The porphyrin compound coordinated to the metal atoms of A001 to A017 is a porphyrin compound having a 26 π-electron system porphyrin ring. $C_{12}H_{25}$ of A008 is a linear chain.

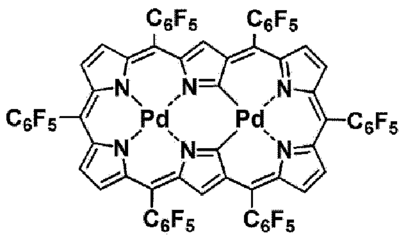

A001

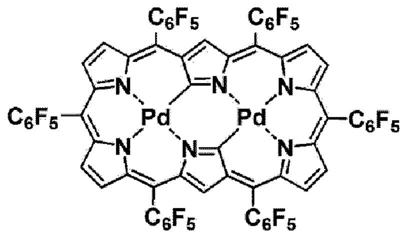

A002

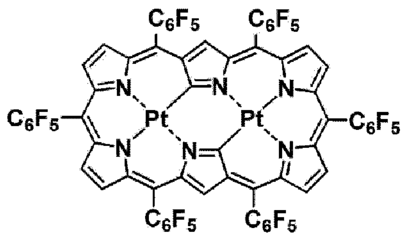

A003

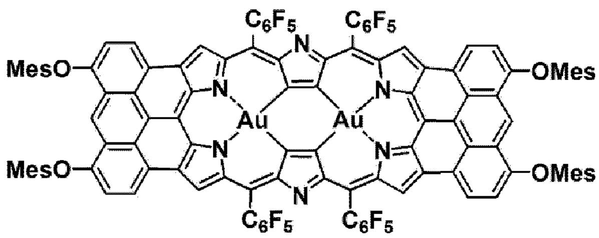

A004

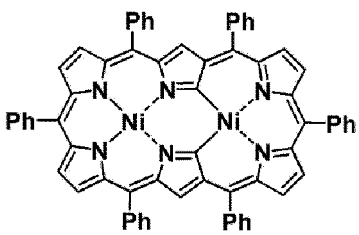

A005

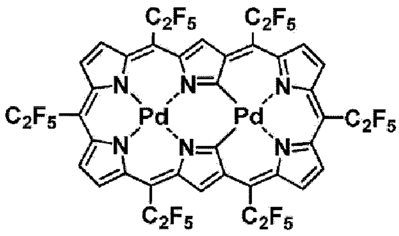

A006

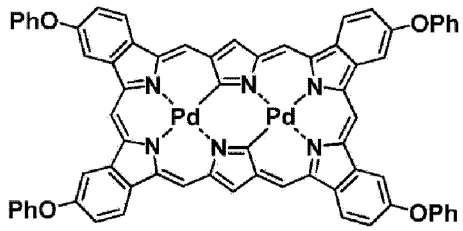

A007

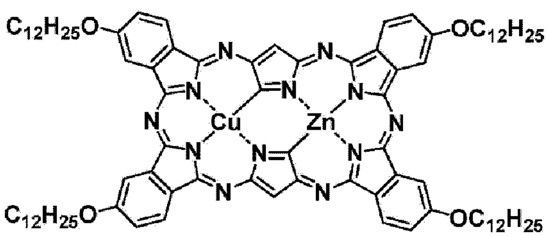

A008

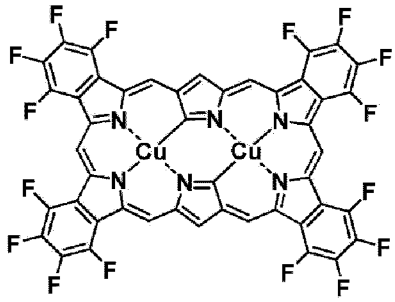

A009

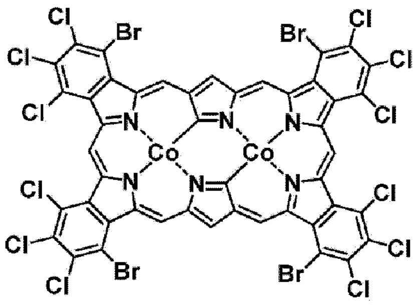

A010

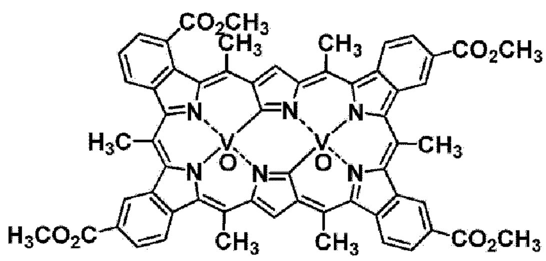

A011

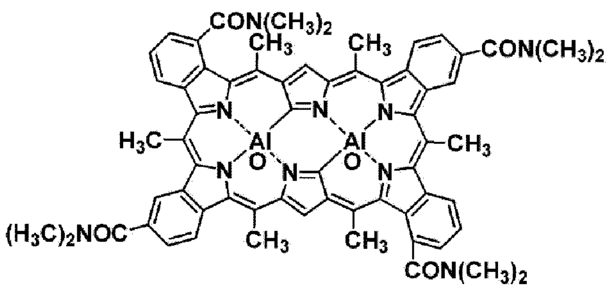

A012

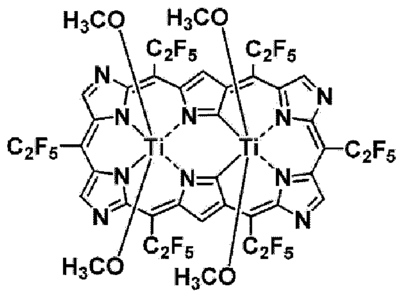

A013

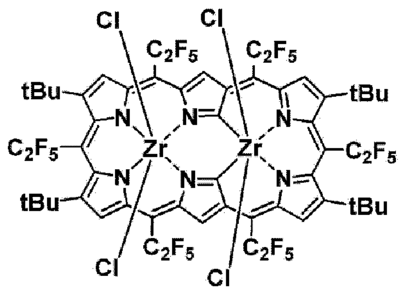

A014

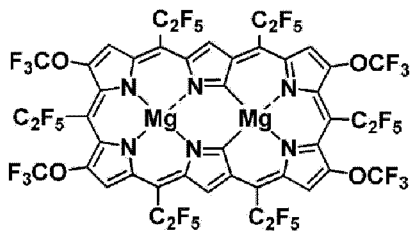

A015

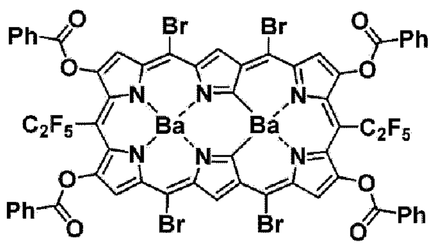

A016

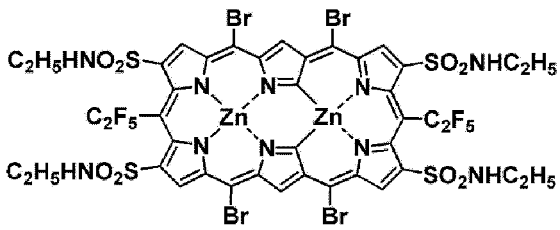

A017

(Other infrared absorbing compounds)

The infrared absorber used in the composition according to the embodiment of the present invention contains a compound other than the above-described specific infrared absorbing compound (hereinafter, also referred to as other infrared absorbing compounds).

The other infrared absorbing compounds may be a compound in which the maximal absorption wavelength is present in the longer wavelength side than the specific infrared absorbing compound, but from the reason that it is possible to form a cured film which has excellent shielding properties of infrared rays in a wide wavelength range and has more excellent light resistance, it is preferable that the other infrared absorbing compounds are a compound in which the maximal absorption wavelength is present in the shorter wavelength side than the specific infrared absorbing compound.

A difference between the maximal absorption wavelength of the specific infrared absorbing compound and the maximal absorption wavelength of the other infrared absorbing compounds is preferably 100 to 400 nm, more preferably 150 to 400 nm, and still more preferably 200 to 400 nm.

In addition, the maximal absorption wavelength of the other infrared absorbing compounds is preferably present in a wavelength range of 600 to 1350 nm, more preferably present in a wavelength range of 650 to 1350 nm, and still more preferably present in a wavelength range of 700 to 1300 nm.

The other infrared absorbing compounds may be a dye or a pigment. Examples of the other infrared absorbing compounds include a pyrrolopyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride. From the reason that a film having high resistance and having excellent heat

resistance and light resistance is obtained, a pyrrolopyrrole compound, a squarylium compound, a croconium compound, or a phthalocyanine compound is preferable. Examples of the pyrrolopyrrole compound include compounds described in paragraph Nos. 0016 to 0058 of JP2009-263614A, compounds described in paragraph Nos. 0037 to 0052 of JP2011-068731A, and compounds described in paragraph Nos. 0010 to 0033 of WO2015/166873A. Examples of the squarylium compound include compounds described in paragraph Nos. 0044 to 0049 of JP2011-208101A, compounds described in paragraph Nos. 0060 and 0061 of JP6065169B, compounds described in paragraph No. 0040 of WO2016/181987A, compounds described in JP2015-176046A, compounds described in paragraph No. 0072 of WO2016/190162A, compounds described in paragraph Nos. 0196 to 0228 of JP2016-074649A, compounds described in paragraph No. 0124 of JP2017-067963A, compounds described in WO2017/135359A, compounds described in JP2017-114956A, compounds described in JP6197940B, and compounds described in WO2016/120166A. Examples of the cyanine compound include compounds described in paragraph Nos. 0044 and 0045 of JP2009-108267A, compounds described in paragraph Nos. 0026 to 0030 of JP2002-194040A, compounds described in JP2015-172004A, compounds described in JP2015-172102A, compounds described in JP2008-088426A, compounds described in paragraph No. 0090 of WO2016/190162A, and compounds described in JP2017-031394A. Examples of the croconium compound include compounds described in JP2017-082029A. Examples of the iminium compound include compounds described in JP2008-528706A, compounds described in JP2012-012399A, compounds described in JP2007-092060A, and compounds described in paragraph Nos. 0048 to 0063 of WO2018/043564A. Examples of the phthalocyanine compound include compounds described in paragraph No. 0093 of JP2012-077153A, oxytitanium phthalocyanine described in JP2006-343631A, compounds described in paragraph Nos. 0013 to 0029 of JP2013-195480A, vanadium phthalocyanine compounds described in JP6081771B, and compounds described in WO2020/071470A. Examples of the naphthalocyanine compound include compounds described in paragraph No. 0093 of JP2012-077153A. Examples of the dithiolene metal complex include compounds described in JP5733804B. Examples of the metal oxide include indium tin oxide, antimony tin oxide, zinc oxide, Al-doped zinc oxide, fluorine-doped tin dioxide, niobium-doped titanium dioxide, and tungsten oxide. The details of tungsten oxide can be found in paragraph Nos. 0080 of JP2016-006476A, the content of which is incorporated herein by reference. Examples of the metal boride include lanthanum boride. Examples of a commercially available product of the lanthanum boride include $LaB_6$-F (manufactured by Japan New Metals Co., Ltd.). In addition, compounds described in WO2017/119394A can also be used as the metal boride. Examples of a commercially available product of indium tin oxide include F-ITO (manufactured by DOWAHIGHTECH CO., LTD.).

In addition, as the other infrared absorbing compounds, squarylium compounds described in JP2017-197437A, squarylium compounds described in JP2017-025311A, squarylium compounds described in WO2016/154782A, squarylium compounds described in JP5884953B, squarylium compounds described in JP6036689B, squarylium compounds described in JP5810604B, squarylium compounds described in paragraph Nos. 0090 to 0107 of WO2017/213047A, pyrrole ring-containing compounds described in paragraph Nos. 0019 to 0075 of JP2018-054760A, pyrrole ring-containing compounds described in paragraph Nos. 0078 to 0082 of JP2018-040955A, pyrrole ring-containing compounds described in paragraph Nos. 0043 to 0069 of JP2018-002773A, squarylium compounds having an aromatic ring at the $\alpha$-amide position described in paragraph Nos. 0024 to 0086 of JP2018-041047A, amide-linked squarylium compounds described in JP2017-179131A, compounds having a pyrrole bis-type squarylium skeleton or a croconium skeleton described in JP2017-141215A, dihydrocarbazole bis-type squarylium compounds described in JP2017-082029, asymmetric compounds described in paragraph Nos. 0027 to 0114 of JP2017-068120A, pyrrole ring-containing compounds (carbazole type) described in JP2017-067963A, phthalocyanine compounds described in JP6251530B, squarylium compounds described in JP2020-075959A, copper complex described in KR10-2019-0135217A, and the like can also be used.

A content of the infrared absorber in the total solid content of the composition according to the embodiment of the present invention is preferably 0.5% to 80% by mass. The upper limit is preferably 75% by mass or less and more preferably 70% by mass or less. The lower limit is preferably 1% by mass or more and more preferably 3% by mass or more.

A content of the specific infrared absorbing compound in the total solid content of the composition is preferably 0.5% by mass or more, more preferably 2% by mass or more, and still more preferably 4% by mass or more. In addition, the upper limit of the content of the specific infrared absorbing compound is preferably 80% by mass or less, more preferably 70% by mass or less, and still more preferably 60% by mass or less. The composition according to the embodiment of the present invention may contain only one kind of specific infrared absorbing compound, or may include two or more kinds thereof. In a case of containing two or more kinds thereof, the total amount thereof is preferably within the above-described range.

In addition, a content of the other infrared absorbing compounds is preferably 1 to 500 parts by mass with respect to 100 parts by mass of the specific infrared absorbing compound. The upper limit is preferably 300 parts by mass or less and more preferably 200 parts by mass or less. The lower limit is preferably 10 parts by mass or more and more preferably 30 parts by mass or more. The composition according to the embodiment of the present invention may contain only one kind of other infrared absorbing compounds, or may include two or more kinds thereof. In a case of containing two or more kinds thereof, the total amount thereof is preferably within the above-described range.

«Curable compound»

The composition according to the embodiment of the present invention contains a curable compound. Examples of the curable compound include a polymerizable compound and a resin. The resin may be a non-polymerizable resin (resin not having a polymerizable group), or may be a polymerizable resin (resin having a polymerizable group). Examples of the polymerizable group include an ethylenically unsaturated bond-containing group, a cyclic ether group, a methylol group, and an alkoxymethyl group. Examples of the ethylenically unsaturated bond-containing group include a vinyl group, a vinylphenyl group, a (meth)allyl group, a (meth)acryloyl group, a (meth)acryloyloxy group, and a (meth)acryloylamide group. Among these, a (meth)allyl group, a (meth)acryloyl group, or a (meth)acryloyloxy group is preferable, and a (meth)acryloyloxy group is more preferable. Examples of the cyclic ether group include an epoxy group and an oxetanyl group, and an epoxy group is preferable. The polymerizable compound preferably contains a polymerizable monomer.

It is preferable that the curable compound contains at least a resin. In addition, in a case where the composition according to the embodiment of the present invention is used as a composition for photolithography, it is preferable to use a resin as a curable compound and a polymerizable monomer (monomer-type polymerizable compound), and it is more preferable to use a resin and a polymerizable monomer (monomer-type polymerizable compound) having an ethylenically unsaturated bond-containing group.

(Polymerizable compound)

Examples of the polymerizable compound include a compound having an ethylenically unsaturated bond-containing group, a compound having a cyclic ether group, a compound having a methylol group, and a compound having an alkoxymethyl group. The compound having an ethylenically unsaturated bond-containing group can be preferably used as a radically polymerizable compound. In addition, the compound having a cyclic ether group can be preferably used as a cationically polymerizable compound.

Examples of a resin-type polymerizable compound include a resin which includes a repeating unit having a polymerizable group.

A molecular weight of the monomer-type polymerizable compound (polymerizable monomer) is preferably less than 2,000 and more preferably 1,500 or less. The lower limit of the molecular weight of the polymerizable monomer is preferably 100 or more and more preferably 200 or more. A weight-average molecular weight (Mw) of the resin-type polymerizable compound is preferably 2,000 to 2,000,000. The upper limit of the weight-average molecular weight is preferably 1,000,000 or less and more preferably 500,000 or less. The lower limit of the weight-average molecular weight is preferably 3,000 or more and more preferably 5,000 or more.

The compound having an ethylenically unsaturated bond-containing group as the polymerizable monomer is preferably a trifunctional to pentadecafunctional (meth)acrylate compound and more preferably a trifunctional to hexafunctional (meth)acrylate compound. Specific examples thereof include compounds described in paragraph Nos. 0095 to 0108 of JP2009-288705A, paragraph No. 0227 of JP2013-029760A, paragraph Nos. 0254 to 0257 of JP2008-292970A, paragraph Nos. 0034 to 0038 of JP2013-253224A, paragraph No. 0477 of JP2012-208494A, JP2017-048367A, JP6057891B, JP6031807B, and JP2017-194662A, the contents of which are incorporated herein by reference.

Examples of the compound having an ethylenically unsaturated bond-containing group include dipentaerythritol tri(meth)acrylate (as a commercially available product, KAYARAD D-330 manufactured by Nippon Kayaku Co., Ltd.), dipentaerythritol tetra(meth)acrylate (as a commercially available product, KAYARAD D-320 manufactured by Nippon Kayaku Co., Ltd.), dipentaerythritol penta(meth)acrylate (as a commercially available product, KAYARAD D-310 manufactured by Nippon Kayaku Co., Ltd.), dipentaerythritol hexa(meth)acrylate (as a commercially available product, KAYARAD DPHA manufactured by Nippon Kayaku Co., Ltd., NK ESTER A-DPH-12E manufactured by Shin-Nakamura Chemical Co., Ltd.), and a compound having a structure in which a (meth)acryloyl group of these compounds is bonded through an ethylene glycol and/or a propylene glycol residue (for example, SR454 and SR499 which are commercially available products from Sartomer Company Inc.).

In addition, as the compound having an ethylenically unsaturated bond-containing group, diglycerin ethylene oxide (EO)-modified (meth)acrylate (as a commercially available product, M-460 manufactured by TOAGOSEI CO., LTD.), pentaerythritol tetraacrylate (NK ESTER A-TMMT manufactured by Shin-Nakamura Chemical Co., Ltd.), 1,6-hexanediol diacrylate (KAYARAD HDDA manufactured by Nippon Kayaku Co., Ltd.), RP-1040 (manufactured by Nippon Kayaku Co., Ltd.), DPHA-40H (manufactured by Nippon Kayaku Co., Ltd.), ARONIX TO-2349 (manufactured by TOAGOSEI CO., LTD.), NK OLIGO UA-7200 (manufactured by Shin-Nakamura Chemical Co., Ltd.), 8UH-1006 and 8UH-1012 (manufactured by Taisei Fine Chemical Co., Ltd.), Light Acrylate POB-A0, UA-306H, UA-306T, UA-306I, AH-600, T-600, AI-600, and LINC-202UA (all of which are manufactured by KYOEISHA CHEMICAL Co., LTD.), and the like can also be used.

In addition, as the compound having an ethylenically unsaturated bond-containing group, it is also preferable

to use a trifunctional (meth)acrylate compound such as trimethylolpropane tri(meth)acrylate, trimethylolpropane propyleneoxide-modified tri(meth)acrylate, trimethylolpropane ethyleneoxide-modified tri(meth)acrylate, isocyanuric acid ethyleneoxide-modified tri(meth)acrylate, and pentaerythritol tri(meth)acrylate. Examples of a commercially available product of the trifunctional (meth)acrylate compound include ARONIX M-309, M-310, M-321, M-350, M-360, M-313, M-315, M-306, M-305, M-303, M-452, and M-450 (manufactured by TOAGOSEI CO., LTD.), NK ESTER A9300, A-GLY-9E, A-GLY-20E, A-TMM-3, A-TMM-3L, A -TMM-3LM-N, A-TMPT, and TMPT (manufactured by Shin-Nakamura Chemical Co., Ltd.), and KAYARAD GPO-303, TMPTA, THE-330, TPA-330, and PET-30 (manufactured by Nippon Kayaku Co., Ltd.).

In addition, as the compound having an ethylenically unsaturated bond-containing group, a compound having an acid group such as a carboxyl group, a sulfo group, and a phosphoric acid group can also be used. Examples of a commercially available product of such a compound include ARONIX M-305, M-510, M-520, and ARONIX TO-2349 (manufactured by TOAGOSEI CO., LTD.).

As the compound having an ethylenically unsaturated bond-containing group, a compound having a caprolactone structure can also be used. With regard to the compound having a caprolactone structure, reference can be made to the description in paragraph Nos. 0042 to 0045 of JP2013-253224A, the content of which is incorporated herein by reference. Examples of the compound having a caprolactone structure include DPCA-20, DPCA-30, DPCA-60, and DPCA-120, each of which is commercially available as KAYARAD DPCA series from Nippon Kayaku Co., Ltd.

As the compound having an ethylenically unsaturated bond-containing group, a compound having an ethylenically unsaturated bond-containing group and an alkyleneoxy group can also be used. Such a compound is preferably a compound having an ethylenically unsaturated bond-containing group and an ethyleneoxy group and/or a propyleneoxy group, more preferably a compound having an ethylenically unsaturated bond-containing group and an ethyleneoxy group, and still more preferably a 3- to 6-functional (meth)acrylate compound having 4 to 20 ethyleneoxy groups. Examples of a commercially available product thereof include SR-494 (manufactured by Sartomer Company Inc.) which is a tetrafunctional (meth)acrylate having 4 ethyleneoxy groups, and KAYARAD TPA-330 (manufactured by Nippon Kayaku Co., Ltd.) which is a trifunctional (meth)acrylate having 3 isobutyleneoxy groups.

As the compound having an ethylenically unsaturated bond-containing group, a polymerizable compound having a fluorene skeleton can also be used. Examples of a commercially available product thereof include OGSOL EA-0200 and EA-0300 (manufactured by Osaka Gas Chemicals Co., Ltd., (meth)acrylate monomer having a fluorene skeleton).

As the compound having an ethylenically unsaturated bond-containing group, it is also preferable to use a compound which does not substantially include environmentally regulated substances such as toluene. Examples of a commercially available product of such a compound include KAYARAD DPHA LT and KAYARAD DPEA-12 LT (manufactured by Nippon Kayaku Co., Ltd.).

Examples of the compound having a cyclic ether group include a compound having an epoxy group and a compound having an oxetanyl group, and a compound having an epoxy group is preferable. Examples of the compound having an epoxy group include a compound having 1 to 100 epoxy groups in one molecule. The upper limit of the number of epoxy groups may be, for example, 10 or less or 5 or less. The lower limit of the number of epoxy groups is preferably 2 or more. As the epoxy compound having an epoxy group, compounds described in paragraph Nos. 0034 to 0036 of JP2013-011869A, paragraph Nos. 0147 to 0156 of JP2014-043556A, and paragraph Nos. 0085 to 0092 of JP2014-089408A, and compounds described in JP2017-179172A can also be used, the contents of which are incorporated herein by reference.

The compound having a cyclic ether group may be a low-molecular-weight compound (for example, having a molecular weight of less than 1,000) or a high-molecular-weight compound (macromolecule) (for example, having a molecular weight of 1,000 or more, and in a case of a polymer, having a weight-average molecular weight of 1,000 or more). The weight-average molecular weight of the cyclic ether group is preferably 200 to 100,000 and more preferably 500 to 50,000. The upper limit of the weight-average molecular weight is preferably 10,000 or less, more preferably 5,000 or less, and still more preferably 3,000 or less.

As the compound having a cyclic ether group, the compounds described in paragraph Nos. 0034 to 0036 of JP2013-011869A, the compounds described in paragraph Nos. 0147 to 0156 of JP2014-043556A, the compounds paragraph Nos. 0085 to 0092 of JP2014-089408A, and the compounds described in JP2017-179172A can also be used.

Examples of a commercially available product of the compound having a cyclic ether group include DENACOL EX-212L, EX-212, EX-214L, EX-214, EX-216L, EX-216, EX-321L, EX-321, EX-850L, and EX-850 (all of which are manufactured by Nagase ChemteX Corporation); ADEKA RESIN EP-4000S, EP-4003S, EP-4010S, and EP-4011S (all of which are manufactured by ADEKA Corporation); NC-2000, NC-3000, NC-7300, XD-1000, EPPN-501, and EPPN-502 (all of which are manufactured by ADEKA Corporation); CELLOXIDE 2021P, CELLOXIDE 2081, CELLOXIDE 2083, CELLOXIDE 2085, EHPE3150, EPOLEAD PB 3600, and PB 4700 (all of which are manufactured by Daicel Corporation); CYCLOMER P ACA 200M, ACA230AA, ACAZ250, ACAZ251, ACAZ300, and ACA Z320 (all of which are manufactured by Daicel Corporation); jER 1031S, jER 157S65, jER 152, jER 154, and jER 157S70 (all of which are manufactured by Mitsubishi Chemical Corporation); ARON OXETANE OXT-121, OXT-221, OX-SQ, and PNOX (all of which are manufactured by TOAGOSEI CO., LTD.); ADEKA GLYCILOL ED-505 (manufactured by ADEKA Corporation, epoxy group-containing monomer); MARPROOF G-0150M, G-0105SA, G-0130SP, G-0250SP, G-1005S, G-1005SA, G-1010S, G-2050M, G-01100, and G-01758 (manufactured by NOF Corporation, epoxy group-containing polymer); OXT-101, OXT-121, OXT-212, and OXT-221 (all of which are manufactured by TOAGOSEI CO., LTD., oxetanyl group-containing monomer); and OXE-10 and OXE-30 (both of which are manufactured by OSAKA ORGANIC CHEMICAL INDUSTRY LTD., oxetanyl group-containing monomer).

Examples of the compound having a methylol group (hereinafter, also referred to as a methylol compound) include a compound in which a methylol group is bonded to a nitrogen atom or a carbon atom which forms an aromatic ring. In addition, examples of the compound having an alkoxymethyl group (hereinafter, also referred to as an alkoxymethyl compound) include a compound in which an alkoxymethyl group is bonded to a nitrogen atom or a carbon atom which forms an aromatic ring. As the compound in which an alkoxymethyl group or a methylol group is bonded to a nitrogen atom, for example, alkoxy methylated melamine, methylolated melamine, alkoxy methylated benzoguanamine, methylolated benzoguanamine, alkoxy methylated glycoluril, methylolated glycoluril, alkoxy methylated urea, or methylolated urea is preferable. In addition, compounds described in paragraphs 0134 to 0147 of JP2004-295116A and paragraphs 0095 to 0126 of JP2014-089408A can also be used.

(Resin)

A resin can be used as the curable compound in the composition according to the embodiment of the present invention. It is preferable that the curable compound contains at least a resin. The resin is blended in, for example, an application for dispersing a pigment or the like in the composition or an application as a binder. Mainly, a resin which is used for dispersing a pigment or the like in the composition is also referred to as a dispersant. However, such applications of the resin are merely exemplary, and the resin can also be used for other purposes in addition to such applications. A resin having a polymerizable group also corresponds to the polymerizable compound.

A weight-average molecular weight of the resin is preferably 3,000 to 2,000,000. The upper limit is preferably 1,000,000 or less and more preferably 500,000 or less. The lower limit is preferably 4,000 or more and more preferably 5,000 or more.

Examples of the resin include a (meth)acrylic resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide resin, a polyamideimide resin, a polyolefin resin, a cyclic olefin resin, a polyester resin, a styrene resin, a vinyl acetate resin, a polyvinyl alcohol resin, a polyvinyl acetal resin, a polyurethane resin, and a polyurea resin. These resins may be used singly or as a mixture of two or more kinds thereof. From the viewpoint of improving heat resistance, as the cyclic olefin resin, a norbornene resin is preferable. Examples of a commercially available product of the norbornene resin include ARTON series (for example, ARTON F4520) manufactured by JSR Corporation. In addition, as the resin, resins described in Examples of WO2016/088645A, resins described in JP2017-057265A, resins described in JP2017-032685A, resins described in JP2017-075248A, resins described in JP2017-066240A, resins described in JP2017-167513A, resins described in JP2017-173787A, resins described in paragraph Nos. 0041 to 0060 of JP2017-206689A, resins paragraph Nos. 0022 to 0071 of JP2018-010856A, block polyisocyanate resins described in JP2016-222891A, resins described in JP2020-122052A, resins described in 2020-111656A, resins described in JP2020-139021A, and resins including a constitutional unit having a ring structure in the main chain and a constitutional unit having a biphenyl group in the side chain, which are described in JP2017-138503A, can also be used. In addition, as the resin, a resin having a fluorene skeleton can also be preferably used. With regard to the resin having a fluorene skeleton, reference can be made to the description in US2017/0102610A, the content of which is incorporated herein by reference.

As the resin, it is also preferable to use a resin having a glass transition temperature of 150°C or higher. According to this aspect, the heat resistance and light resistance of the film can be enhanced. Furthermore, it is also possible to increase heat resistance of a pattern shape (suppression of deterioration of rectangularity of the pattern due to heating) in a case where the pattern is formed. The glass transition temperature of the resin is preferably 160°C or higher and more preferably 180°C or higher. In the present specification, as the glass transition temperature (Tg) of the resin, a theoretical value represented by the following expression is used for a resin in which a structure is known, and a catalog value is used for a resin in which a structure is unknown.

$$1/Tg = (W1/Tg1) + (W2/Tg2) + ... + (Wn/Tgn)$$

The above expression is a calculation expression in a case where the resin is composed of n kinds of monomer components of a monomer 1, a monomer 2, ..., and a monomer n, and in the above expression, Tg represents the glass transition temperature (unit: K) of the resin, Tg1 to Tgn represent a glass transition temperature (unit: K) of a homopolymer of each monomer, and W1 to Wn represent a mass fraction of each monomer in all monomer components.

As the resin, it is preferable to use a resin having an acid group. Examples of the acid group include a carboxyl group, a phosphoric acid group, a sulfo group, and a phenolic hydroxy group. Among these acid groups, one kind may be used singly, or two or more kinds may be used in combination. The resin having an acid group can also be used as a dispersant. An acid value of the resin having an acid group is preferably 30 to 500 mgKOH/g. The lower limit is preferably 50 mgKOH/g or more and more preferably 70 mgKOH/g or more. The upper limit is preferably 400 mgKOH/g or less, more preferably 200 mgKOH/g or less, still more preferably 150 mgKOH/g or less, and most preferably 120 mgKOH/g or less.

As the resin, it is also preferable to contain a resin including a repeating unit derived from a compound represented by Formula (ED1) and/or a compound represented by Formula (ED2) (hereinafter, these compounds will also be referred to as an "ether dimer").

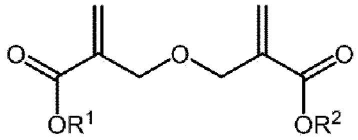

(ED1)

In Formula (ED1), $R^1$ and $R^2$ each independently represent a hydrogen atom or a hydrocarbon group having 1 to 25 carbon atoms, which may have a substituent.

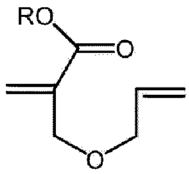

(ED2)

In Formula (ED2), R represents a hydrogen atom or an organic group having 1 to 30 carbon atoms. Specific examples of Formula (ED2) can be found in the description of JP2010-168539A.

Specific examples of the ether dimer can be found in paragraph No. 0317 of JP2013-029760A, the contents of which are incorporated herein by reference.

As the resin, it is also preferable to use a resin having a polymerizable group. As the polymerizable group, an ethylenically unsaturated bond-containing group or a cyclic ether group is preferable, and an ethylenically unsaturated bond-containing group is more preferable.

As the resin, it is also preferable to use a resin including a repeating unit derived from a compound represented by Formula (X).

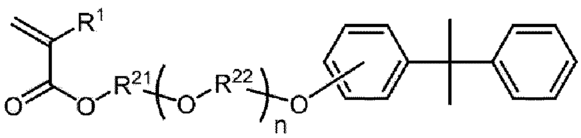

(X)

In the formula, $R^1$ represents a hydrogen atom or a methyl group, $R^{21}$ and $R^{22}$ each independently represent an alkylene group, and n represents an integer of 0 to 15. The number of carbon atoms in the alkylene group represented by $R^{21}$ and $R^{22}$ is preferably 1 to 10, more preferably 1 to 5, still more preferably 1 to 3, and particularly preferably 2 or 3. n represents an integer of 0 to 15, and is preferably an integer of 0 or 5, more preferably an integer of 0 to 4, and still more preferably an integer of 0 to 3.

Examples of the compound represented by Formula (X) include ethylene oxide- or propylene oxide- modified (meth)acrylate of para-cumylphenol. Examples of a commercially available product thereof include ARONIX M-110 (manufactured by TOAGOSEI CO., LTD.).

The resin preferably includes a resin as a dispersant. Examples of the dispersant include an acidic dispersant (acidic resin) and a basic dispersant (basic resin). Here, the acidic dispersant (acidic resin) represents a resin in which the amount of the acid group is larger than the amount of the basic group. The acidic dispersant (acidic resin) is preferably a resin in which the amount of the acid group is 70 mol% or more in a case where the total amount of the acid group and the basic group is 100 mol%. The acid group included in the acidic dispersant (acidic resin) is preferably a carboxyl group. An acid value of the acidic dispersant (acidic resin) is preferably 10 to 105 mgKOH/g. In addition, the basic dispersant (basic resin) represents a resin in which the amount of the basic group is larger than the amount of the acid

group. The basic dispersant (basic resin) is preferably a resin in which the amount of the basic group is more than 50 mol% in a case where the total amount of the acid group and the basic group is 100 mol%. The basic group included in the basic dispersant is preferably an amino group.

It is also preferable that the resin used as a dispersant is a graft resin. With regard to details of the graft resin, reference can be made to the description in paragraph Nos. 0025 to 0094 of JP2012-255128A, the contents of which are incorporated herein by reference.

It is also preferable that the resin used as a dispersant is a polyimine-based dispersant including a nitrogen atom in at least one of the main chain or the side chain. As the polyimine-based dispersant, a resin having a main chain which has a partial structure having a functional group of pKa 14 or less, and a side chain which has 40 to 10000 atoms, in which at least one of the main chain or the side chain has a basic nitrogen atom, is preferable. The basic nitrogen atom is not particularly limited as long as it is a nitrogen atom exhibiting basicity. With regard to the polyimine-based dispersant, reference can be made to the description in paragraph Nos. 0102 to 0166 of JP2012-255128A, the contents of which are incorporated herein by reference.

It is also preferable that the resin used as a dispersant is a resin having a structure in which a plurality of polymer chains are bonded to a core portion. Examples of such a resin include dendrimers (including star polymers). In addition, specific examples of the dendrimer include polymer compounds C-1 to C-31 described in paragraph Nos. 0196 to 0209 of JP2013-043962A.

It is also preferable that the resin used as a dispersant are a resin including a repeating unit having an ethylenically unsaturated bond-containing group in the side chain. A content of the repeating unit having an ethylenically unsaturated bond-containing group in the side chain is preferably 10 mol% or more, more preferably 10 to 80 mol%, and still more preferably 20 to 70 mol% with respect to the total repeating units of the resin.

In addition, as the dispersant, block copolymers (EB-1) to (EB-9) described in paragraph Nos. 0219 to 0221 of JP6432077B, a resin described in JP2018-087939A, polyethyleneimine having a polyester side chain, described in WO2016/104803A, a block copolymer described in WO2019/125940A, a block polymer having an acrylamide structural unit, described in JP2020-066687A, a block polymer having an acrylamide structural unit, described in JP2020-066688A, a dispersant described in WO2016/104803A, a resin described in JP2019-095548A, or the like can also be used.

A commercially available product is also available as the dispersant, and specific examples thereof include DISPERBYK series manufactured by BYK Chemie Japan, Solsperse series manufactured by Lubrizol Japan Ltd., Efka series manufactured by BASF SE, and AJISPER series manufactured by Ajinomoto Fine-Techno Co., Inc. In addition, products described in paragraph No. 0129 of JP2012-137564A and products described in paragraph No. 0235 of JP2017-194662A can also be used as the dispersant.

A content of the curable compound in the total solid content of the composition is preferably 1% to 95% by mass. The lower limit is preferably 2% by mass or more, more preferably 5% by mass or more, still more preferably 7% by mass or more, and particularly preferably 10% by mass or more. The upper limit is preferably 94% by mass or less, more preferably 90% by mass or less, still more preferably 85% by mass or less, and particularly preferably 80% by mass or less.

In a case where the composition according to the embodiment of the present invention contains a polymerizable compound as the curable compound, a content of the polymerizable compound in the total solid content of the composition is preferably 1% to 85% by mass. The lower limit is preferably 2% by mass or more, more preferably 3% by mass or more, and still more preferably 5% by mass or more. The upper limit is preferably 80% by mass or less and more preferably 70% by mass or less.

In a case where the composition according to the embodiment of the present invention contains a polymerizable monomer as the curable compound, a content of the polymerizable monomer in the total solid content of the composition is preferably 1% to 50% by mass. The lower limit is preferably 2% by mass or more, more preferably 3% by mass or more, and still more preferably 5% by mass or more. The upper limit is preferably 30% by mass or less and more preferably 20% by mass or less.

In a case where the composition according to the embodiment of the present invention contains a compound having an ethylenically unsaturated bond-containing group as the curable compound, a content of the compound having an ethylenically unsaturated bond-containing group in the total solid content of the composition is preferably 1% to 70% by mass. The lower limit is preferably 2% by mass or more, more preferably 3% by mass or more, and still more preferably 5% by mass or more. The upper limit is preferably 65% by mass or less and more preferably 60% by mass or less.

In a case where the composition according to the embodiment of the present invention contains a resin as the curable compound, a content of the resin in the total solid content of the composition is preferably 1% to 85% by mass. The lower limit is preferably 2% by mass or more, more preferably 5% by mass or more, still more preferably 7% by mass or more, and particularly preferably 10% by mass or more. The upper limit is preferably 80% by mass or less, more preferably 75% by mass or less, still more preferably 70% by mass or less, and particularly preferably 40% by mass or less.

In a case where the composition according to the embodiment of the present invention contains a resin as a

dispersant, a content of the resin as a dispersant in the total solid content of the composition is preferably 0.1% to 40% by mass. The upper limit is more preferably 25% by mass or less and still more preferably 20% by mass or less. The lower limit is preferably 0.5% by mass or more and more preferably 1% by mass or more. In addition, the content of the resin as a dispersant is preferably 1 to 100 parts by mass with respect to 100 parts by mass of the above-described specific infrared absorbing compound. The upper limit is preferably 80 parts by mass or less and more preferably 75 parts by mass or less. The lower limit is preferably 2.5 parts by mass or more and more preferably 5 parts by mass or more.

The composition according to the embodiment of the present invention may contain one curable compound or two or more kinds of curable compounds. In a case of containing two or more kinds of curable compounds, it is preferable that the total content thereof is within the above-described range.

«Coloring agent derivative»

The composition according to the embodiment of the present invention may further contain a coloring agent derivative. The coloring agent derivative is used as a dispersion aid. Examples of the coloring agent derivative include a compound having a structure in which an acid group or a basic group is bonded to a coloring agent skeleton.

Examples of the coloring agent skeleton constituting the coloring agent derivative include a squarylium coloring agent skeleton, a pyrrolopyrrole coloring agent skeleton, a diketo pyrrolopyrrole coloring agent skeleton, a quinacridone coloring agent skeleton, an anthraquinone coloring agent skeleton, a dianthraquinone coloring agent skeleton, a benzoisoindole coloring agent skeleton, a thiazine indigo coloring agent skeleton, an azo coloring agent skeleton, a quinophthalone coloring agent skeleton, a phthalocyanine coloring agent skeleton, a naphthalocyanine coloring agent skeleton, a dioxazine coloring agent skeleton, a perylene coloring agent skeleton, a perinone coloring agent skeleton, a benzimidazolone coloring agent skeleton, a benzothiazole coloring agent skeleton, a benzimidazole coloring agent skeleton, and a benzoxazole coloring agent skeleton. Among these, a squarylium coloring agent skeleton, a pyrrolopyrrole coloring agent skeleton, a diketo pyrrolopyrrole coloring agent skeleton, a phthalocyanine coloring agent skeleton, a quinacridone coloring agent skeleton, or benzimidazolone coloring agent skeleton is preferable, and a squarylium coloring agent skeleton or a pyrrolopyrrole coloring agent skeleton is more preferable.

Examples of the acid group include a carboxyl group, a sulfo group, a phosphoric acid group, a boronic acid group, a carboxylic acid amide group, a sulfonic acid amide group, an imidic acid group, and salts of these group. Examples of an atom or atomic group constituting the salts include alkali metal ions ($Li^+$, $Na^+$, $K^+$, and the like), alkaline earth metal ions ($Ca^{2+}$, $Mg^{2+}$, and the like), an ammonium ion, an imidazolium ion, a pyridinium ion, and a phosphonium ion. As the carboxylic acid amide group, a group represented by $-NHCOR^{X1}$ is preferable. As the sulfonic acid amide group, a group represented by $-NHSO_2R^{X2}$ is preferable. As the imidic acid group, a group represented by $-SO_2NHSO_2R^{X3}$, $-CONHSO_2R^{X4}$, $-CONHCOR^{X5}$, or $-SO_2NHCOR^{X6}$ is preferable, and $-SO_2NHSO_2R^{X3}$ is more preferable. $R^{X1}$ to $R^{X6}$ each independently represent an alkyl group or an aryl group. The alkyl group and the aryl group represented by $R^{X1}$ to $R^{X6}$ may have a substituent. As the substituent, a halogen atom is preferable and a fluorine atom is more preferable.

Examples of the basic group included in the pigment derivative include an amino group, a pyridinyl group, or a salt thereof, a salt of an ammonium group, and a phthalimidomethyl group. Examples of an atom or atomic group constituting the salts include a hydroxide ion, a halogen ion, a carboxylate ion, a sulfonate ion, and a phenoxide ion.

Examples of the coloring agent derivative include compounds described in JP1981-118462A (JP-S56-118462A), compounds described in JP1988-264674A (JP-S63-264674A), compounds described in JP1989-217077A (JP-H01-217077A), compounds described in JP1992-009961A (JP-H03-009961A), compounds described in JP1992-026767A (JP-H03-026767A), compounds described in JP1992-153780A (JP-H03-153780A), compounds described in JP1992-045662A (JP-H03-045662A), compounds described in JP1993-285669A (JP-H04-285669A), compounds described in JP1995-145546A (JP-H06-145546A), compounds described in JP1995-212088A (JP-H06-212088A), compounds described in JP1995-240158A (JP-H06-240158A), compounds described in JP1999-030063A (JP-H10-030063A), compounds described in JP1999-195326A (JP-H10-195326A), compounds described in paragraph Nos. 0086 to 0098 of WO2011/024896A, compounds described in paragraph Nos. 0063 to 0094 of WO2012/102399A, compounds described in paragraph No. 0082 of WO2017/038252A, compounds described in paragraph No. 0171 of JP2015-151530A, compounds described in paragraph Nos. 0162 to 0183 of JP2011-252065A, compounds described in JP2003-081972A, compounds described in JP5299151B, compounds described in JP2015-172732A, compounds described in JP2014-199308A, compounds described in JP2014-085562A, compounds described in JP2014-035351A, compounds described in JP2008-081565A, compounds described in JP2019-109512A, compounds described in JP2019-133154A, and diketopyrrolopyrrole compounds having a thiol linking group, described in WO2020/002106A.

A content of the coloring agent derivative is preferably 1 to 50 parts by mass with respect to 100 parts by mass of the above-described specific infrared absorbing compound. The lower limit value is preferably 3 parts by mass or more and more preferably 5 parts by mass or more. The upper limit value is preferably 40 parts by mass or less and

more preferably 30 parts by mass or less. As the coloring agent derivative, one kind may be used alone, or two or more kinds may be used in combination. In a case of using two or more kinds thereof, the total amount thereof is preferably within the above-described range.

<<Solvent>>

The composition according to the embodiment of the present invention preferably contains a solvent. Examples of the solvent include water and an organic solvent, and an organic solvent is preferable. Examples of the organic solvent include an ester-based solvent, a ketone-based solvent, an alcohol-based solvent, an amide-based solvent, an ether-based solvent, and a hydrocarbon-based solvent. The details of the organic solvent can be found in paragraph No. 0223 of WO2015/166779A, the content of which is incorporated herein by reference. In addition, an ester-based solvent in which a cyclic alkyl group is substituted or a ketone-based solvent in which a cyclic alkyl group is substituted can also be preferably used. Specific examples of the organic solvent include polyethylene glycol monomethyl ether, dichloromethane, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, 3-pentanone, 4-heptanone, cyclohexanone, 2-methylcyclohexanone, 3-methylcyclohexanone, 4-methylcyclohexanone, cycloheptanone, cyclooctanone, cyclohexyl acetate, cyclopentanone, ethylcarbitol acetate, butylcarbitol acetate, propylene glycol monomethyl ether, propylene glycol monomethyl ether acetate, 3-methoxy-N,N-dimethylpropanamide, 3-butoxy-N,N-dimethylpropanamide, propylene glycol diacetate, 3-methoxybutanol, methyl ethyl ketone, γ-butyrolactone, propylene glycol diacetate, sulfolane, anisole, 1,4-diacetoxybutane, diethylene glycol monoethyl ether acetate, butane diacetate-1,3-diyl, dipropylene glycol methyl ether acetate, diacetone alcohol, 2-methoxypropyl acetate, 2-methoxy-1-propanol, and isopropyl alcohol. In this case, it may be better to reduce the content of aromatic hydrocarbons (such as benzene, toluene, xylene, and ethylbenzene) as the organic solvent (for example, 50 parts per million (ppm) by mass or less, 10 ppm by mass or less, or 1 ppm by mass or less with respect to the total amount of the organic solvent) in consideration of environmental aspects and the like.

In the present invention, an organic solvent having a low metal content is preferably used. For example, the metal content in the organic solvent is preferably 10 mass parts per billion (ppb) or less. Optionally, an organic solvent having a metal content at a mass parts per trillion (ppt) level may be used. For example, such an organic solvent is available from Toyo Gosei Co., Ltd. (The Chemical Daily, November 13, 2015).

Examples of a method for removing impurities such as a metal from the organic solvent include distillation (such as molecular distillation and thin-film distillation) and filtration using a filter. The filter pore size of the filter used for the filtration is preferably 10 μm or less, more preferably 5 μm or less, and still more preferably 3 μm or less. As a material of the filter, polytetrafluoroethylene, polyethylene, or nylon is preferable.

The organic solvent may include an isomer (a compound having the same number of atoms and a different structure). In addition, only one kind of isomers may be included, or a plurality of isomers may be included.

The organic solvent preferably has the content of peroxides of 0.8 mmol/L or less, and more preferably, the organic solvent does not substantially contain peroxides.

A content of the solvent in the composition is preferably 10% to 97% by mass. The lower limit is preferably 30% by mass or more, more preferably 40% by mass or more, still more preferably 50% by mass or more, even still more preferably 60% by mass or more, and particularly preferably 70% by mass or more. The upper limit is preferably 96% by mass or less and more preferably 95% by mass or less. The composition may contain only one kind of solvent, or may contain two or more kinds thereof. In a case of containing two or more kinds thereof, the total amount thereof is preferably within the above-described range.

«Photopolymerization initiator»

In a case where the composition according to the embodiment of the present invention contains the polymerizable compound, it is preferable that the composition according to the embodiment of the present invention further contains a photopolymerization initiator. The photopolymerization initiator is not particularly limited, and can be appropriately selected from known photopolymerization initiators. For example, a compound having photosensitivity to light in a range from an ultraviolet range to a visible range is preferable. The photopolymerization initiator is preferably a photoradical polymerization initiator.

Examples of the photopolymerization initiator include a halogenated hydrocarbon derivative (for example, a compound having a triazine skeleton or a compound having an oxadiazole skeleton), an acylphosphine compound, a hexaarylbiimidazole, an oxime compound, an organic peroxide, a thio compound, a ketone compound, an aromatic onium salt, an α-hydroxyketone compound, and an α-aminoketone compound. From the viewpoint of exposure sensitivity, as the photopolymerization initiator, a trihalomethyltriazine compound, a benzyldimethylketal compound, an α-hydroxyketone compound, an α-aminoketone compound, an acylphosphine compound, a phosphine oxide compound, a metallocene compound, an oxime compound, a triarylimidazole dimer, an onium compound, a benzothiazole compound, a

benzophenone compound, an acetophenone compound, a cyclopentadiene-benzene-iron complex, a halomethyl oxadiazole compound, or a 3-aryl-substituted coumarin compound is preferable, a compound selected from an oxime compound, an α-hydroxyketone compound, an α-aminoketone compound, and an acylphosphine compound is more preferable, and an oxime compound is still more preferable. In addition, as the photopolymerization initiator, compounds described in paragraphs 0065 to 0111 of JP2014-130173A, compounds described in JP6301489B, peroxide-based photopolymerization initiators described in MATERIAL STAGE, p. 37 to 60, vol. 19, No. 3, 2019, photopolymerization initiators described in WO2018/221177A, photopolymerization initiators described in WO2018/110179A, photopolymerization initiators described in JP2019-043864A, photopolymerization initiators described in JP2019-044030A, peroxide initiators described in JP2019-167313A, aminoacetophenone-based initiators described in JP2020-055992A, and oxime-based photopolymerization initiators described in JP2013-190459A, the contents of which are incorporated herein by reference.

Examples of a commercially available product of the α-hydroxyketone compound include Omnirad 184, Omnirad 1173, Omnirad 2959, and Omnirad 127 (all of which are manufactured by IGM Resins B.V), Irgacure 184, Irgacure 1173, Irgacure 2959, and Irgacure 127 (all of which are manufactured by BASF SE). Examples of a commercially available product of the α-aminoketone compound include Omnirad 907, Omnirad 369, Omnirad 369E, and Omnirad 379EG (all of which are manufactured by IGM Resins B.V), Irgacure 907, Irgacure 369, Irgacure 369E, and Irgacure 379EG (all of which are manufactured by BASF SE). Examples of a commercially available product of the acylphosphine compound include Omnirad 819 and Omnirad TPO (both of which are manufactured by IGM Resins B.V), Irgacure 819 and Irgacure TPO (both of which are manufactured by BASF SE).

Examples of the oxime compound include the compounds described in JP2001-233842A, the compounds described in JP2000-080068A, the compounds described in JP2006-342166A, the compounds described in J. C. S. Perkin II (1979, pp. 1653 to 1660), the compounds described in J. C. S. Perkin II (1979, pp. 156 to 162), the compounds described in Journal of Photopolymer Science and Technology (1995, pp. 202 to 232), the compounds described in JP2000-066385A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and compounds described in WO2013/167515A. Specific examples of the oxime compound include 3-benzoyloxyiminobutane-2-one, 3-acetoxyiminobutane-2-one, 3-propionyloxyiminobutane-2-one, 2-acetoxyiminopentane-3-one, 2-acetoxyimino-1-phenylpropane-1-one, 2-benzoyloxyimino-1-phenylpropane-1-one, 3-(4-toluene sulfonyloxy)iminobutane-2-one, and 2-ethoxycarbonyloxyimino-1-phenylpropane-1-one. Examples of a commercially available product thereof include Irgacure OXE01, Irgacure OXE02, Irgacure OXE03, and Irgacure OXE04 (all of which are manufactured by BASF SE), TR-PBG-304 (manufactured by TRONLY), and ADEKA OPTOMER N-1919 (manufactured by ADEKA Corporation; photopolymerization initiator 2 described in JP2012-014052A). In addition, as the oxime compound, it is also preferable to use a compound having no colorability or a compound having high transparency and being resistant to discoloration. Examples of a commercially available product thereof include ADEKA ARKLS NCI-730, NCI-831, and NCI-930 (all of which are manufactured by ADEKA Corporation).

An oxime compound having a fluorene ring can also be used as the photopolymerization initiator. Specific examples of the oxime compound having a fluorene ring include compounds described in JP2014-137466A, compounds described in JP6636081B, and compounds described in KR10-2016-0109444A.

As the photopolymerization initiator, an oxime compound having a skeleton in which at least one benzene ring of a carbazole ring is a naphthalene ring can also be used. Specific examples of such an oxime compound include the compounds described in WO2013/083505A.

An oxime compound having a fluorine atom can also be used as the photopolymerization initiator. Specific examples of the oxime compound having a fluorine atom include compounds described in JP2010-262028A, Compounds 24 and 36 to 40 described in JP2014-500852A, and Compound (C-3) described in JP2013-164471A.

An oxime compound having a nitro group can be used as the photopolymerization initiator. The oxime compound having a nitro group is also preferably used in the form of a dimer. Specific examples of the oxime compound having a nitro group include a compound described in paragraph Nos. 0031 to 0047 of JP2013-114249A and paragraph Nos. 0008 to 0012 and 0070 to 0079 of JP2014-137466A, a compound described in paragraph Nos. 0007 to 0025 of JP4223071B, and ADEKAARKLS NCI-831 (manufactured by ADEKA Corporation).

An oxime compound having a benzofuran skeleton can also be used as the photopolymerization initiator. Specific examples thereof include OE-01 to OE-75 described in WO2015/036910A.

In the present invention, as the photopolymerization initiator, an oxime compound in which a substituent having a hydroxy group is bonded to a carbazole skeleton can also be used. Examples of such a photopolymerization initiator include compounds described in WO2019/088055A.

Specific examples of the oxime compound which are preferably used in the present invention are shown below, but the present invention is not limited thereto.

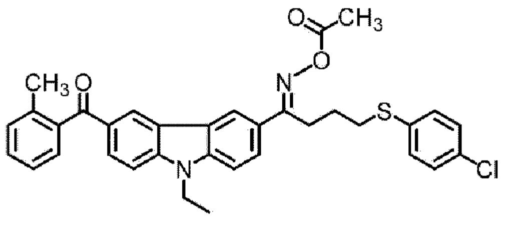 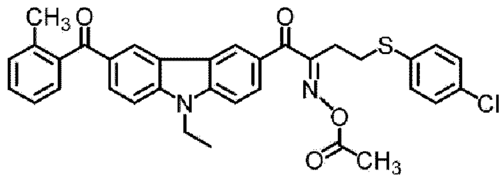

(C-1) (C-2)

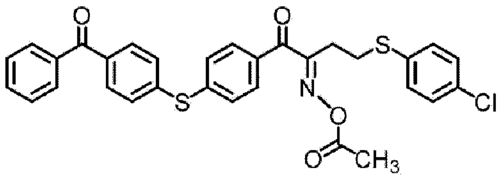 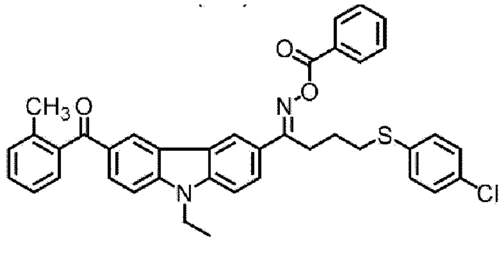

(C-3) (C-4)

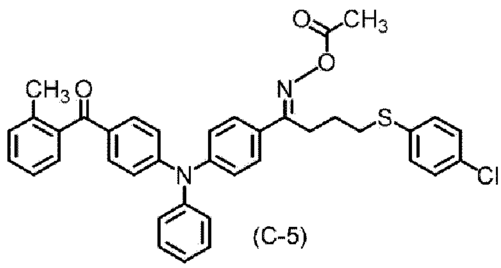 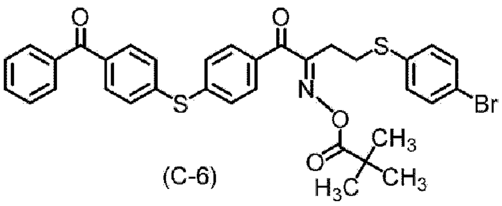

(C-5) (C-6)

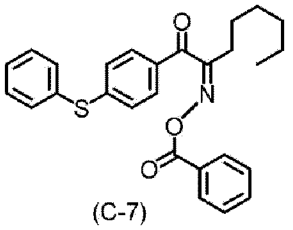 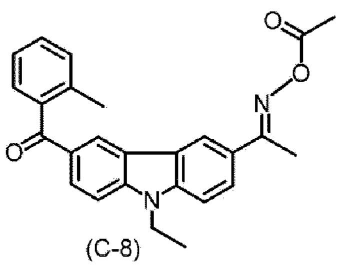

(C-7) (C-8)

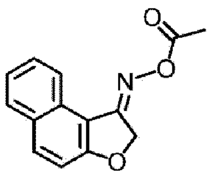

(C-9)

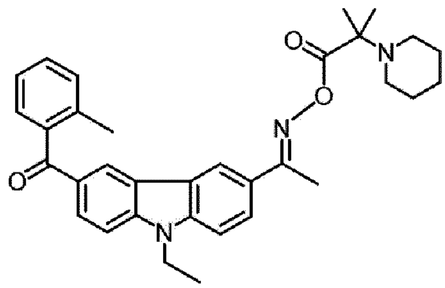

(C-10)

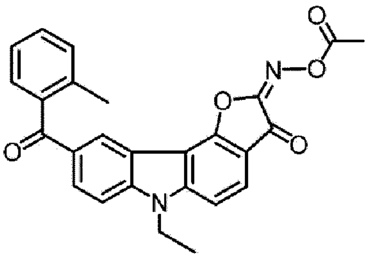

(C-11)

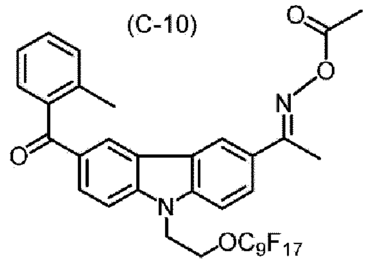

(C-12)

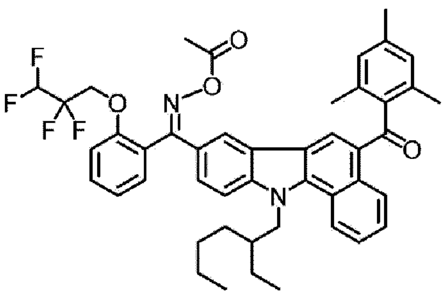

(C-13)

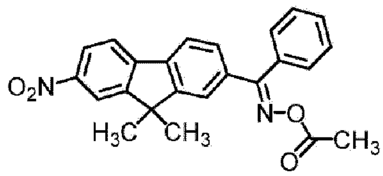

(C-14)

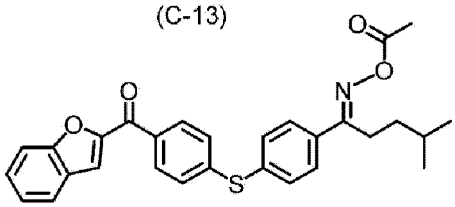

(C-15)

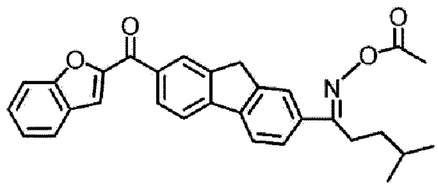

(C-16)

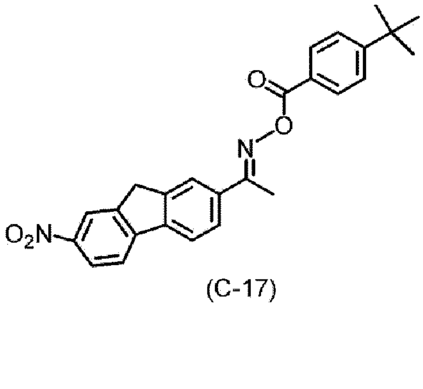

(C-17)

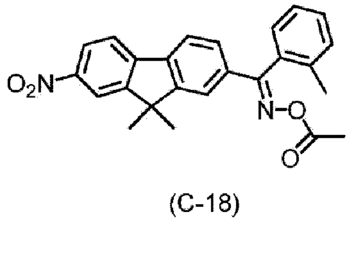

(C-18)

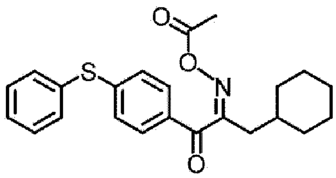

(C-19)

The oxime compound is preferably a compound having a maximal absorption wavelength in a wavelength range of 350 to 500 nm and more preferably a compound having a maximal absorption wavelength in a wavelength range of 360 to 480 nm. In addition, from the viewpoint of sensitivity, a molar absorption coefficient of the oxime compound at a wavelength of 365 nm or 405 nm is preferably high, more preferably 1000 to 300000, still more preferably 2000 to 300000, and particularly preferably 5000 to 200000. The molar absorption coefficient of a compound can be measured using a known method. For example, it is preferable that the molar absorption coefficient can be measured using a spectrophotometer (Cary-5 spectrophotometer, manufactured by Varian Medical Systems, Inc.) and ethyl acetate as a solvent at a concentration of 0.01 g/L.

As the photopolymerization initiator, a bifunctional or tri- or higher functional photoradical polymerization initiator may be used. By using such a photoradical polymerization initiator, two or more radicals are generated from one molecule of the photoradical polymerization initiator, and as a result, good sensitivity is obtained. In addition, in a case of using a compound having an asymmetric structure, crystallinity is reduced so that solubility in a solvent or the like is improved, precipitation is to be difficult over time, and temporal stability of the composition can be improved. Specific examples of the bifunctional or tri- or higher functional photoradical polymerization initiator include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A; the compound (E) and compound (G) described in JP2013-522445A; Cmpd 1 to 7 described in WO2016/034963A; the oxime ester-based photoinitiators described in paragraph No. 0007 of JP2017-523465A; the photoinitiators described in paragraph Nos. 0020 to 0033 of JP2017-167399A; the photopolymerization initiator (A) described in paragraph Nos. 0017 to 0026 of JP2017-151342A; and the oxime ester-based photoinitiators described in JP6469669B.

A content of the photopolymerization initiator in the total solid content of the composition is preferably 0.1% to 40% by mass, more preferably 0.5% to 35% by mass, and still more preferably 1% to 30% by mass. The composition may contain only one kind of the photopolymerization initiator or two or more kinds thereof. In a case of containing two or more kinds thereof, the total amount thereof is preferably within the above-described range.

<<Curing agent>>

In a case where the composition according to the embodiment of the present invention contains the compound having a cyclic ether group, the composition according to the embodiment of the present invention preferably further contains a curing agent. Examples of the curing agent include an amine compound, an acid anhydride compound, an amide compound, a phenol compound, polyvalent carboxylic acid, and a thiol compound. Specific examples of the curing agent include succinic acid, trimellitic acid, pyromellitic acid, N,N-dimethyl-4-aminopyridine, and pentaerythritol tetrakis(3-mercaptopropionate). As the curing agent, compounds described in paragraph Nos. 0072 to 0078 of JP2016-075720A or compounds described in JP2017-036379A can also be used.

A content of the curing agent is preferably 0.01 to 20 parts by mass, more preferably 0.01 to 10 parts by mass, and still more preferably 0.1 to 6.0 parts by mass with respect to 100 parts by mass of the compound having a cyclic ether group.

<<Chromatic colorant>>

The composition according to the embodiment of the present invention can contain a chromatic colorant. In the present invention, "chromatic colorant" denotes a colorant other than a white colorant and a black colorant. It is preferable that the chromatic colorant is a colorant having an absorption in a wavelength range of 400 nm or more and less than 650 nm.

Examples of the chromatic colorant include red colorants, green colorants, blue colorants, yellow colorants, violet colorants, and orange colorants. The chromatic colorant may be a pigment or a dye. The coloring material may be used in combination of the pigment and the dye. In addition, the pigment may be either an inorganic pigment or an organic pigment. In addition, as the pigment, a material in which a part of an inorganic pigment or an organic-inorganic pigment is substituted with an organic chromophore can also be used. By substituting an inorganic pigment or an organic-inorganic pigment with an organic chromophore, hue design can be easily performed.

An average primary particle diameter of the pigment is preferably 1 to 200 nm. The lower limit is preferably 5 nm or more and more preferably 10 nm or more. The upper limit is preferably 180 nm or less, more preferably 150 nm or less, and still more preferably 100 nm or less. In a case where the average primary particle diameter of the pigment is within the above-described range, dispersion stability of the pigment in the composition is good. In the present invention, the primary particle diameter of the pigment can be determined from a captured image obtained by observing primary particles of the pigment using a transmission electron microscope. Specifically, a projected area of the primary particles of the pigment is determined, and the corresponding equivalent circle diameter is calculated as the primary particle diameter of the pigment. In addition, the average primary particle diameter in the present invention is an arithmetic average of the primary particle diameters with respect to 400 primary particles of the pigment. In addition, the primary particle of the pigment refers to a particle which is independent without aggregation.

It is preferable that the chromatic colorant includes a pigment. A content of the pigment in the chromatic colorant is preferably 50% by mass or more, more preferably 70% by mass or more, still more preferably 80% by mass or more, and particularly preferably 90% by mass or more. Examples of the pigment include the following pigments:

Color Index (C. I.) Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 213, 214, 215, 228, 231, 232 (methine-based), 233 (quinoline-based), 234 (aminoketone-based), 235 (aminoketone-based), 236 (aminoketone-based), and the like (all of which are yellow pigments);

C. I. Pigment Orange 2, 5, 13, 16, 17:1, 31, 34, 36, 38, 43, 46, 48, 49, 51, 52, 55, 59, 60, 61, 62, 64, 71, and 73 (all of which are orange pigments);

C. I. Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 269, 270, 272, 279, 291, 294 (xanthene-based, Organo Ultramarine, Bluish Red), 295 (monoazo-based), 296 (diazo-based), 297 (aminoketone-based), and the like (all of which are red pigments);

C. I. Pigment Green 7, 10, 36, 37, 58, 59, 62, 63, 64 (phthalocyanine-based), 65 (phthalocyanine-based), 66 (phthalocyanine-based), and the like (all of which are green pigments);

C. I. Pigment Violet 1, 19, 23, 27, 32, 37, 42, 60 (triarylmethane-based), 61 (xanthene-based), and the like (all of which are violet pigments); and

C. I. Pigment Blue 1, 2, 15, 15:1, 15:2, 15:3, 15:4, 15:6, 16, 22, 29, 60, 64, 66, 79, 80, 87 (monoazo-based), 88 (methine-based), and the like (all of which are blue pigments).

In addition, as the green colorant, a halogenated zinc phthalocyanine pigment having an average number of halogen atoms in one molecule of 10 to 14, an average number of bromine atoms in one molecule of 8 to 12, and an average number of chlorine atoms in one molecule of 2 to 5 can also be used. Specific examples thereof include the compounds described in WO2015/118720A. In addition, as the green colorant, a compound described in CN2010-6909027A, a phthalocyanine compound described in WO2012/102395A, which has phosphoric acid ester as a ligand, a phthalocyanine compound described in JP2019-008014A, a phthalocyanine compound described in JP2018-180023A, a compound described in JP2019-038958A, a core-shell type coloring agent described in JP2020-076995A, and the like can also be used.

In addition, as the blue colorant, an aluminum phthalocyanine compound having a phosphorus atom can also be used. Specific examples thereof include the compounds described in paragraph Nos. 0022 to 0030 of JP2012-247591A and paragraph No. 0047 of JP2011-157478A.

In addition, as the yellow colorant, compounds described in JP2017-201003A, compounds described in JP2017-197719A, compounds described in paragraph Nos. 0011 to 0062 and 0137 to 0276 of JP2017-171912A, compounds described in paragraph Nos. 0010 to 0062 and 0138 to 0295 of JP2017-171913A, compounds described in paragraph Nos. 0011 to 0062 and 0139 to 0190 of JP2017-171914A, compounds described in paragraph Nos. 0010 to 0065 and 0142 to 0222 of JP2017-171915A, quinophthalone compounds described in paragraph Nos. 0011 to 0034 of JP2013-054339A, quinophthalone compounds described in paragraph Nos. 0013 to 0058 of JP2014-026228A, isoindoline compounds described JP2018-062644A, quinophthalone compounds described in JP2018-203798A, quinophthalone compounds described in JP2018-062578A, quinophthalone compounds described in JP6432076B, quinophthalone compounds described in JP2018-155881A, quinophthalone compounds described in JP2018-111757A, quinophthalone compounds described in JP2018-040835A, quinophthalone compounds described in JP2017-197640A, quinophthalone compounds described in JP2016-145282A, quinophthalone compounds described in JP2014-085565A,

quinophthalone compounds described in JP2014-021139A, quinophthalone compounds described in JP2013-209614A, quinophthalone compounds described in JP2013-209435A, quinophthalone compounds described in JP2013-181015A, quinophthalone compounds described in JP2013-061622A, quinophthalone compounds described in JP2013-032486A, quinophthalone compounds described in JP2012-226110A, quinophthalone compounds described in JP2008-074987A, quinophthalone compounds described in JP2008-081565A, quinophthalone compounds described in JP2008-074986A, quinophthalone compounds described in JP2008-074985A, quinophthalone compounds described in JP2008-050420A, quinophthalone compounds described in JP2008-031281A, quinophthalone compounds described in JP1973-032765A (JP-S48-032765A), quinophthalone compounds described in JP2019-008014A, quinophthalone compounds described in JP6607427B, methine dyes described in JP2019-073695A, methine dyes described in JP2019-073696A, methine dyes described in JP2019-073697A, methine dyes described in JP2019-073698A, compounds described in KR10-2014-0034963A, compounds described in JP2017-095706A, compounds described in TW2019-20495A, compounds described in JP6607427B, compounds described in JP2020-033525A, compounds described in JP2020-033524A, compounds described in JP2020-033523A, compounds described in JP2020-033522A, compounds described in JP2020-033521A, compounds described in WO2020/045200A, compounds described in WO2020/045199A, compounds described in WO2020/045197A, azo compounds described in JP2020-093994A, perylene compounds described in JP2020-083982A, perylene compounds described in WO2020/105346A, and quinophthalone compounds described in JP2020-517791A can also be used. In addition, from the viewpoint of improving a color value, a multimerized compound of these compounds is also preferably used.

As the red colorant, diketopyrrolopyrrole compounds described in JP2017-201384A, in which the structure has at least one substituted bromine atom, diketopyrrolopyrrole compounds described in paragraph Nos. 0016 to 0022 of JP6248838B, diketopyrrolopyrrole compounds described in WO2012/102399A, diketopyrrolopyrrole compounds described in WO2012/117965A, naphtholazo compounds described in JP2012-229344A, red pigments described in JP6516119B, red pigments described in JP6525101B, brominated diketopyrrolopyrrole compounds described in paragraph No. 0229 of JP2020-090632A, anthraquinone compounds described in KR10-2019-0140741A, anthraquinone compounds described in KR10-2019-0140744A, perylene compounds described in JP2020-079396A, and the like can also be used. In addition, as the red colorant, a compound having a structure that an aromatic ring group in which a group bonded with an oxygen atom, a sulfur atom, or a nitrogen atom is introduced to an aromatic ring is bonded to a diketopyrrolopyrrole skeleton can be used.

Regarding diffraction angles preferably possessed by various pigments, descriptions of JP6561862B, JP6413872B, JP6281345B, and JP2020-026503A can be referred to, the contents of which are incorporated herein by reference. In addition, in the pyrrolopyrrole-based pigment, it is also preferable to use a pyrrolopyrrole-based pigment in which a crystallite size in a plane direction corresponding to the maximum peak in the X-ray diffraction pattern among eight planes ($\pm 1$ $\pm 1$ $\pm 1$) of the crystal lattice planes is 140 Å or less. In addition, it is also preferable that physical properties of the pyrrolopyrrole-based pigment are set as described in paragraph Nos. 0028 to 0073 of JP2020-097744A.

A dye can also be used as the chromatic colorant. As the dye, a known dye can be used without any particular limitation. Examples thereof include a pyrazoleazo-based dye, an anilinoazo-based dye, a triarylmethane-based dye, an anthraquinone-based dye, an anthrapyridone-based dye, a benzylidene-based dye, an oxonol-based dye, a pyrazolotriazoleazo-based dye, a pyridoneazo-based dye, a cyanine-based dye, a phenothiazine-based dye, a pyrrolopyrazoleazomethine-based dye, a xanthene-based dye, a phthalocyanine-based dye, a benzopyran-based dye, an indigo-based dye, and a pyrromethane-based dye. In addition, as the dye, the thiazole compound described in JP2012-158649A, the azo compound described in JP2011-184493A, the azo compound described in JP2011-145540A, the triarylmethane dye polymer described in KR10-2020-0028160A, or the xanthene compound described in JP2020-117638A can also be preferably used.

As the chromatic colorant, the phthalocyanine compound described in WO2020/174991A can be used.

In a case where the composition according to the embodiment of the present invention contains a chromatic colorant, a content of the chromatic colorant in the total solid content of the composition according to the embodiment of the present invention according to the embodiment of the present invention is preferably 1% to 50% by mass. In a case where the composition according to the embodiment of the present invention contains two or more kinds of chromatic colorants, it is preferable that the total content of the two or more kinds of chromatic colorants is within the above-described range.

<<Coloring material which allows transmission of infrared rays and shields visible light>>

The composition according to the embodiment of the present invention can also contain a coloring material which allows transmission of infrared rays and shields visible light (hereinafter, also referred to as a "coloring material which shields visible light"). A composition containing the coloring material which shields visible light is preferably used as a composition for forming an infrared transmitting filter.

It is preferable that the coloring material which shields visible light is a coloring material which absorbs light in

a wavelength range of violet to red. In addition, it is preferable that the coloring material which shields visible light is a coloring material which shields light in a wavelength range of 450 to 650 nm. In addition, it is preferable that the coloring material which shields visible light is a coloring material which allows transmission of light in a wavelength range of 900 to 1500 nm. It is preferable that the coloring material which shields visible light satisfies at least one of the following requirement (A) or (B).

(A): coloring material which shields visible light includes two or more kinds of chromatic colorants, and a combination of the two or more chromatic colorants forms black.
(B): coloring material which shields visible light includes an organic black colorant.

Examples of the chromatic colorant include the above-described chromatic colorants. Examples of the organic black colorant include a bisbenzofuranone compound, an azomethine compound, a perylene compound, and an azo compound. Among these, a bisbenzofuranone compound or a perylene compound is preferable. Examples of the bisbenzofuranone compound include the compounds described in JP2010-534726A, JP2012-515233A, JP2012-515234A, and the like, and the bisbenzofuranone compound is available, for example, as "Irgaphor Black" manufactured by BASF SE. Examples of the perylene compound include compounds described in paragraph Nos. 0016 to 0020 of JP2017-226821A, and C. I. Pigment Black 31 and 32. Examples of the azomethine compound include compounds described in JP1989-170601A (JP-H01-170601A) and JP1990-034664A (JP-H02-034664A). For example, "CHROMOFINE BLACK A1103" (manufactured by Dainichiseika Color & Chemicals Mfg. Co., Ltd.) is available.

In a case where a combination of the two or more chromatic colorants forms black, examples of the combination of the chromatic colorants include the following aspects (1) to (8).

(1) aspect in which the coloring material which shields visible light contains a yellow colorant, a blue colorant, a violet colorant, and a red colorant
(2) aspect in which the coloring material which shields visible light contains a yellow colorant, a blue colorant, and a red colorant
(3) aspect in which the coloring material which shields visible light contains a yellow colorant, a violet colorant, and a red colorant
(4) aspect in which the coloring material which shields visible light contains a yellow colorant and a violet colorant
(5) aspect in which the coloring material which shields visible light contains a green colorant, a blue colorant, a violet colorant, and a red colorant
(6) aspect in which the coloring material which shields visible light contains a violet colorant and an orange colorant
(7) aspect in which the coloring material which shields visible light contains a green colorant, a violet colorant, and a red colorant
(8) aspect in which the coloring material which shields visible light contains a green colorant and a red colorant

In a case where the composition according to the embodiment of the present invention contains a coloring material which shields visible light, a content of the coloring material which shields visible light in the total solid content of the composition is preferably 1% to 50% by mass. The lower limit is preferably 5% by mass or more, more preferably 10% by mass or more, still more preferably 20% by mass or more, and particularly preferably 30% by mass or more.

<<Surfactant>>

The composition according to the embodiment of the present invention preferably contains a surfactant. As the surfactant, various surfactants such as a fluorine-based surfactant, a nonionic surfactant, a cationic surfactant, an anionic surfactant, and a silicone-based surfactant can be used. The surfactant is preferably a silicone-based surfactant or a fluorine-based surfactant. Examples of the surfactant include surfactants described in paragraph Nos. 0238 to 0245 of WO2015/166779A and surfactants described in JP2020-008634A, the contents of which are incorporated herein by reference.

Examples of the fluorine-based surfactant include surfactants described in paragraph Nos. 0060 to 0064 of JP2014-041318A (paragraph Nos. 0060 to 0064 of the corresponding WO2014/017669A) and the like, surfactants described in paragraph Nos. 0117 to 0132 of JP2011-132503A, and surfactants described in JP2020-008634A, the contents of which are incorporated herein by reference. Examples of a commercially available product of the fluorine-based surfactant include: MEGAFACE F-171, F-172, F-173, F-176, F-177, F-141, F-142, F-143, F-144, F-437, F-475, F-477, F-479, F-482, F-554, F-555-A, F-556, F-557, F-558, F-559, F-560, F-561, F-565, F-563, F-568, F-575, F-780, EXP, MFS-330, R-01, R-40, R-40-LM, R-41, R-41-LM, RS-43, R-43, TF-1956, RS-90, R-94, RS-72-K, and DS-21 (all of which are manufactured by DIC Corporation); FLUORAD FC430, FC431, and FC171 (all of which are manufactured by Sumitomo 3M Ltd.); SURFLON S-382, SC-101, SC-103, SC-104, SC-105, SC-1068, SC-381, SC-383, S-393, and

KH-40 (all of which are manufactured by Asahi Glass Co., Ltd.); POLYFOX PF636, PF656, PF6320, PF6520, and PF7002 (all of which are manufactured by OMNOVA Solutions Inc.); and FTERGENT 208G, 215M, 245F, 601AD, 601ADH2, 602A, 610FM, 710FL, 710FM, 710FS, and FTX-218 (all of which are manufactured by NEOS COMPANY LIMITED).

In addition, as the fluorine-based surfactant, an acrylic compound, which has a molecular structure having a functional group containing a fluorine atom and in which, by applying heat to the molecular structure, the functional group containing a fluorine atom is broken to volatilize a fluorine atom, can also be suitably used. Examples of such a fluorine-based surfactant include MEGAFACE DS series manufactured by DIC Corporation (The Chemical Daily, February 22, 2016; Nikkei Business Daily, February 23, 2016) such as MEGAFACE DS-21.

In addition, it is also preferable that a polymer of a fluorine atom-containing vinyl ether compound having a fluorinated alkyl group or a fluorinated alkylene ether group, and a hydrophilic vinyl ether compound is used as the fluorine-based surfactant. Examples of such a fluorine-based surfactant include fluorine-based surfactants described in JP2016-216602A, the contents of which are incorporated herein by reference.

A block polymer can also be used as the fluorine-based surfactant. As the fluorine-based surfactant, a fluorine-containing polymer compound including a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used. In addition, fluorine-containing surfactants described in paragraph Nos. 0016 to 0037 of JP2010-032698A, or the following compounds are also exemplified as the fluorine-based surfactant used in the present invention.

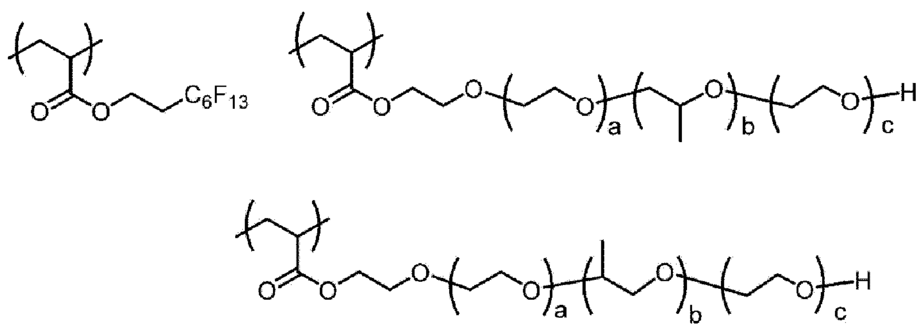

62% 38%

a+c=14
b=17

A weight-average molecular weight of the compound is preferably 3,000 to 50,000 and, for example, 14,000. In the compound, "%" representing the proportion of a repeating unit is mol%.

In addition, as the fluorine-based surfactant, a fluorine-containing polymer having an ethylenically unsaturated bond-containing group in the side chain can be used. Specific examples thereof include compounds described in paragraph Nos. 0050 to 0090 and paragraph Nos. 0289 to 0295 of JP2010-164965A, and MEGAFACE RS-101, RS-102, RS-718K, and RS-72-K manufactured by DIC Corporation. In addition, as the fluorine-based surfactant, compounds described in paragraph Nos. 0015 to 0158 of JP2015-117327A can also be used.

In addition, from the viewpoint of environmental regulation, it is also preferable to use a surfactant described in WO2020/084854A as a substitute for the surfactant having a perfluoroalkyl group having 6 or more carbon atoms.

In addition, it is also preferable to use a fluorine-containing imide salt compound represented by Formula (fi-1) as the surfactant.

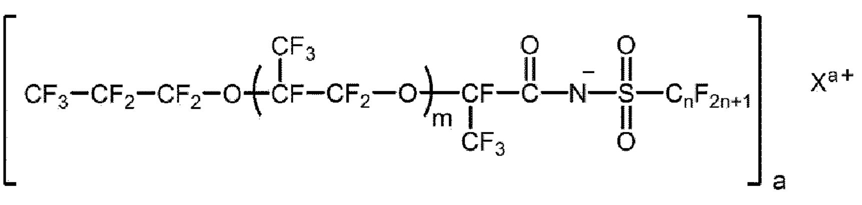

(fi-1)

In Formula (fi-1), m represents 1 or 2, n represents an integer of 1 to 4, a represents 1 or 2, and $X^{a+}$ represents an a-valent metal ion, a primary ammonium ion, a secondary ammonium ion, a tertiary ammonium ion, a quaternary

ammonium ion, or $NH_4^+$.

Examples of the nonionic surfactant include glycerol, trimethylolpropane, trimethylolethane, an ethoxylate and propoxylate thereof (for example, glycerol propoxylate or glycerol ethoxylate), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, sorbitan fatty acid esters, PLURONIC L10, L31, L61, L62, 10R5, 17R2, and 25R2 (manufactured by BASF SE), TETRONIC 304, 701, 704, 901, 904, and 150R1 (manufactured by BASF SE), SOLSPERSE 20000 (manufactured by Lubrizol Japan Ltd.), NCW-101, NCW-1001, and NCW-1002 (all of which are manufactured by FUJIFILM Wako Pure Chemical Corporation), PIONIN D-6112, D-6112-W, and D-6315 (all of which are manufactured by Takemoto Oil&Fat Co., Ltd.), and OLFINE E1010 and SURFYNOL 104, 400, and 440 (all of which are manufactured by Nissin Chemical Co., Ltd.).

Examples of the cationic surfactant include a tetraalkylammonium salt, an alkylamine salt, a benzalkonium salt, an alkylpyridium salt, and an imidazolium salt. Specific examples thereof include dihydroxyethylstearylamine, 2-heptadecenyl-hydroxyethylimidazoline, lauryldimethylbenzylammonium chloride, cetylpyridinium chloride, and stealamidemethylpyridium chloride.

Examples of the anionic surfactant include dodecylbenzene sulfonic acid, sodium dodecylbenzene sulfonate, sodium lauryl sulfate, sodium alkyldiphenyl ether disulfonate, sodium alkylnaphthalene sulfonate, sodium dialkyl sulfosuccinate, sodium stearate, potassium oleate, sodium dioctyl sulfosuccinate, sodium polyoxyethylene alkyl ether sulfate, sodium polyoxyethylene alkylphenyl ether sulfate, sodium dialkyl sulfosuccinate, sodium stearate, sodium oleate, and sodium t-octylphenoxyethoxypolyethoxyethyl sulfate.

Examples of the silicone-based surfactant include: DC3PA, SH7PA, DC11PA, SH21PA, SH28PA, SH29PA, SH30PA, SH8400, SH 8400 FLUID, FZ-2122, 67 Additive, 74 Additive, M Additive, and SF 8419 OIL (all of which are manufactured by DuPont Toray Specialty Materials K.K.); TSF-4300, TSF-4445, TSF-4460, and TSF-4452 (all of which are manufactured by Momentive Performance Materials Inc.); KP-341, KF-6000, KF-6001, KF-6002, and KF-6003 (all of which are manufactured by Shin-Etsu Chemical Co., Ltd.); and BYK-307, BYK-322, BYK-323, BYK-330, BYK-333, BYK-3760, and BYK-UV3510 (all of which are manufactured by BYK Chemie).

In addition, as the silicone-based surfactant, a compound having the following structure can also be used.

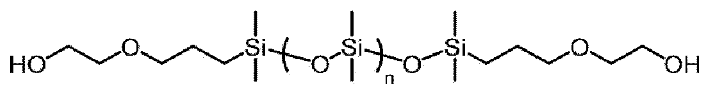

A content of the surfactant in the total solid content of the composition is preferably 0.001% to 1% by mass, more preferably 0.001% to 0.5% by mass, and still more preferably 0.001% to 0.2% by mass. The composition may contain only one kind of surfactant, or may contain two or more kinds thereof. In a case of containing two or more kinds thereof, the total amount thereof is preferably within the above-described range.

«Polymerization inhibitor»

The composition according to the embodiment of the present invention can contain a polymerization inhibitor. Examples of the polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-t-butylphenol), and an N-nitrosophenylhydroxylamine salt (an ammonium salt, a cerous salt, or the like), and p-methoxyphenol is preferable. A content of the polymerization inhibitor in the total solid content of the composition is preferably 0.0001% to 5% by mass. The composition may contain only one kind of polymerization inhibitor, or may contain two or more kinds thereof. In a case of containing two or more kinds thereof, the total amount thereof is preferably within the above-described range.

<<Silane coupling agent>>

The composition according to the embodiment of the present invention can contain a silane coupling agent. In the present specification, the silane coupling agent means a silane compound having a hydrolyzable group and other functional groups. In addition, the hydrolyzable group refers to a substituent directly linked to a silicon atom and capable of forming a siloxane bond due to at least one of a hydrolysis reaction or a condensation reaction. Examples of the hydrolyzable group include a halogen atom, an alkoxy group, and an acyloxy group, and an alkoxy group is preferable. That is, it is preferable that the silane coupling agent is a compound having an alkoxysilyl group. Examples of the functional group other than the hydrolyzable group include a vinyl group, a styryl group, a (meth)acryloyl group, a mercapto group, an epoxy group, an oxetanyl group, an amino group, a ureido group, a sulfide group, an isocyanate group, and a phenyl group, and a (meth)acryloyl group or an epoxy group is preferable. Examples of the silane coupling

agent include a compound described in paragraph Nos. 0018 to 0036 of JP2009-288703A and a compound described in paragraph Nos. 0056 to 0066 of JP2009-242604A, the content of which is incorporated herein by reference. A content of the silane coupling agent in the total solid content of the composition is preferably 0.01% to 15.0% by mass and more preferably 0.05% to 10.0% by mass. The composition may contain only one kind of silane coupling agent, or may contain two or more kinds thereof. In a case of containing two or more kinds thereof, the total amount thereof is preferably within the above-described range.

«Ultraviolet absorber»

The composition according to the embodiment of the present invention can contain an ultraviolet absorber. Examples of the ultraviolet absorber include a conjugated diene compound, an aminodiene compound, a salicylate compound, a benzophenone compound, a benzotriazole compound, an acrylonitrile compound, a hydroxyphenyltriazine compound, an indole compound, and a triazine compound. Specific examples of such a compound include compounds described in paragraph Nos. 0038 to 0052 of JP2009-217221A, paragraph Nos. 0052 to 0072 of JP2012-208374A, paragraph Nos. 0317 to 0334 of JP2013-068814A, and paragraph Nos. 0061 to 0080 of JP2016-162946A, the contents of which are incorporated herein by reference. Examples of a commercially available product of the ultraviolet absorber include UV-503 (manufactured by Daito Chemical Co., Ltd.), and Tinuvin series and Uvinul series manufactured by BASF SE. In addition, examples of the benzotriazole compound include MYUA series manufactured by Miyoshi Oil & Fat Co., Ltd. (The Chemical Daily, February 1, 2016). In addition, as the ultraviolet absorber, compounds described in paragraph Nos. 0049 to 0059 of JP6268967B, compounds described in paragraph Nos. 0059 to 0076 of WO2016/181987A, and thioaryl group-substituted benzotriazole type ultraviolet absorbers described in WO2020/137819A can also be used. A content of the ultraviolet absorber in the total solid content of the composition is preferably 0.01% to 30% by mass and more preferably 0.05% to 25% by mass. The composition may contain only one kind of ultraviolet absorber, or may contain two or more kinds thereof. In a case of containing two or more kinds thereof, the total amount thereof is preferably within the above-described range.

<<Antioxidant>>

The composition according to the embodiment of the present invention can contain an antioxidant. Examples of the antioxidant include a phenol compound, a phosphite ester compound, and a thioether compound. As the phenol compound, any phenol compound which is known as a phenol-based antioxidant can be used. Preferred examples of the phenol compound include a hindered phenol compound. A compound having a substituent at a site (ortho position) adjacent to a phenolic hydroxy group is preferable. As the substituent, a substituted or unsubstituted alkyl group having 1 to 22 carbon atoms is preferable. In addition, as the antioxidant, a compound having a phenol group and a phosphite ester group in the same molecule is also preferable. In addition, as the antioxidant, a phosphorus antioxidant can also be suitably used. Examples of the phosphorus antioxidant include tris[2-[[2,4,8,10-tetrakis(1,1-dimethylethyl)dibenzo[d,f][1,3,2]dioxaphosphepin-6-yl]oxy]ethyl ]amine, tris[2-[(4,6,9,11-tetra-tert-butyldibenzo[d,f][1,3,2]dioxaphosphepin-2-yl)oxy]ethyl]amine, and ethyl bis(2,4-di-tert-butyl-6-methylphenyl)phosphite. Examples of a commercially available product of the antioxidant include ADK STAB AO-20, ADK STAB AO-30, ADK STAB AO-40, ADK STAB AO-50, ADK STAB AO-50F, ADK STAB AO-60, ADK STAB AO-60G, ADK STAB AO-80, and ADK STAB AO-330 (all of which are manufactured by ADEKA Corporation). In addition, as the antioxidant, compounds described in paragraph Nos. 0023 to 0048 of JP6268967B, compounds described in WO2017/006600A, or compounds described in WO2017/164024A can also be used. A content of the antioxidant in the total solid content of the composition is preferably 0.01% to 20% by mass and more preferably 0.3% to 15% by mass. The composition may contain only one kind of antioxidant, or may contain two or more kinds thereof. In a case of containing two or more kinds thereof, the total amount thereof is preferably within the above-described range.

<<Other components>>

Optionally, the composition according to the embodiment of the present invention may further contain a sensitizer, a curing accelerator, a filler, a thermal curing accelerator, a plasticizer, and other auxiliary agents (for example, conductive particles, an antifoaming agent, a flame retardant, a leveling agent, a peeling accelerator, an aromatic chemical, a surface tension adjuster, or a chain transfer agent). By appropriately containing these components, properties such as film properties can be adjusted. The details of the components can be found in, for example, paragraph No. 0183 of JP2012-003225A (corresponding to paragraph No. 0237 of US2013/0034812A) and paragraph Nos. 0101 to 0104 and 0107 to 0109 of JP2008-250074A, the contents of which are incorporated herein by reference. In addition, optionally, the composition according to the embodiment of the present invention may contain a potential antioxidant. Examples of the potential antioxidant include a compound in which a portion that functions as the antioxidant is protected

by a protective group and the protective group is desorbed by heating the compound at 100°C to 250°C or by heating the compound at 80°C to 200°C in the presence of an acid/a base catalyst. Examples of the potential antioxidant include compounds described in WO2014/021023A, WO2017/030005A, and JP2017-008219A. Examples of a commercially available product of the potential antioxidant include ADEKAARKLS GPA-5001 (manufactured by ADEKA Corporation).

<Storage container>

A storage container of the composition according to the embodiment of the present invention is not particularly limited, and a well-known storage container can be used. In addition, as the storage container, it is also preferable to use a multilayer bottle having an interior wall constituted with six layers from six kinds of resins or a bottle having a 7-layer structure from 6 kinds of resins for the purpose of suppressing infiltration of impurities into raw materials or compositions. Examples of such a container include the containers described in JP2015-123351A. In addition, for the purpose of preventing metal elution from the container interior wall, improving temporal stability of the composition, and suppressing the alteration of components, it is also preferable that the container interior wall is formed of glass, stainless steel, or the like.

<Method of preparing composition>

The composition according to the embodiment of the present invention can be prepared by mixing the above-described components with each other. During the preparation of the composition, all the components may be dissolved or dispersed in a solvent at the same time to prepare the composition. Optionally, two or more solutions or dispersion liquids in which the respective components are appropriately blended may be prepared, and the solutions or dispersion liquids may be mixed with each other during use (during application) to prepare the composition.

In the preparation of the composition, a process of dispersing the pigment may be included. In the process for dispersing the pigment, examples of a mechanical force which is used for dispersing the pigment include compression, pressing, impact, shear, and cavitation. Specific examples of these processes include a beads mill, a sand mill, a roll mill, a ball mill, a paint shaker, a microfluidizer, a high-speed impeller, a sand grinder, a flow jet mixer, high-pressure wet atomization, and ultrasonic dispersion. In addition, in the pulverization of the pigment in a sand mill (beads mill), it is preferable to perform a treatment under the condition for increasing a pulverization efficiency by using beads having small diameters; increasing the filling rate of the beads; or the like. Incidentally, it is preferable to remove coarse particles by filtration, centrifugation, or the like after the pulverization treatment. In addition, as the process and the dispersing machine for dispersing the pigment, the process and the dispersing machine described in "Dispersion Technology Comprehension, published by Johokiko Co., Ltd., July 15, 2005", "Actual comprehensive data collection on dispersion technology and industrial application centered on suspension (solid/liquid dispersion system), published by Publication Department, Management Development Center, October 10, 1978", and paragraph No. 0022 of JP2015-157893A can be suitably used. In addition, in the process for dispersing the pigment, a refining treatment of pigments in a salt milling step may be performed. A material, a device, process conditions, and the like used in the salt milling step can be found in, for example, JP2015-194521A and JP2012-046629A.

During the preparation of the composition, it is preferable that the composition is filtered through a filter, for example, in order to remove foreign matter or to reduce defects. As the filter, any filter which is used in the related art for filtering or the like can be used without any particular limitation. Examples of a material of the filter include: a fluororesin such as polytetrafluoroethylene (PTFE) and polyvinylidene fluoride (PVDF); a polyamide-based resin such as nylon (for example, nylon-6 or nylon-6,6); and a polyolefin resin (including a polyolefin resin having a high density and an ultrahigh molecular weight) such as polyethylene or polypropylene (PP). Among these materials, polypropylene (including high-density polypropylene) or nylon is preferable.

The pore size of the filter is preferably 0.01 to 7.0 μm, more preferably 0.01 to 3.0 μm, and still more preferably 0.05 to 0.5 μm. In a case where the pore size of the filter is within the above-described range, fine foreign matters can be reliably removed. With regard to the pore size value of the filter, reference can be made to a nominal value of filter manufacturers. As the filter, various filters provided by Nihon Pall Corporation (DFA4201NXEY, DFA4201NAEY, DFA4201J006P, and the like), Toyo Roshi Kaisha., Ltd., Nihon Entegris K.K. (formerly Nippon Microlith Co., Ltd.), Kitz Micro Filter Corporation, and the like can be used.

In addition, it is preferable that a fibrous filter material is used as the filter. Examples of the fibrous filter material include polypropylene fiber, nylon fiber, and glass fiber. Examples of a commercially available product include SBP type series (SBP008 and the like), TPR type series (TPR002, TPR005, and the like), or SHPX type series (SHPX003 and the like), all manufactured by Roki Techno Co., Ltd.

In a case where a filter is used, a combination of different filters (for example, a first filter and a second filter) may be used. In this case, the filtering using each of the filters may be performed once, or twice or more. In addition, a combination of filters having different pore sizes in the above-described range may be used. In addition, the filtering

using the first filter may be performed only on the dispersion liquid, and the filtering using the second filter may be performed on a mixture of the dispersion liquid and other components.

<Film>

Next, the film according to the embodiment of the present invention will be described. The film according to the embodiment of the present invention is obtained from the above-described composition according to the embodiment of the present invention. The film according to the embodiment of the present invention can be preferably used as an optical filter. An application of the optical filter is not particularly limited, and examples thereof include an infrared cut filter and an infrared transmitting filter. Examples of the infrared cut filter include an infrared cut filter on a light-receiving side of a solid-state imaging element (for example, an infrared cut filter for a wafer level lens), an infrared cut filter on a back surface side (opposite to the light-receiving side) of the solid-state imaging element, and an infrared cut filter for an ambient light sensor (for example, an illuminance sensor that detects illuminance or tone of an environment in which an information terminal device is placed and adjusts tone of a display, or a color correction sensor that adjusts tone). In particular, the film according to the embodiment of the present invention can be preferably used as an infrared cut filter of a solid-state imaging element on a light-receiving side. Examples of the infrared transmitting filter include a filter which shields visible light and can selectively transmit infrared rays having a specific wavelength or higher.

In the film according to the embodiment of the present invention, it is preferable that an average value of transmittance of light having a wavelength of 800 nm or more and less than 1000 nm is less than 10% and an average value of transmittance of light having a wavelength of 1000 nm or more and less than 1500 nm is less than 5%. The average value of transmittance of light having a wavelength of 800 nm or more and less than 1000 nm is preferably less than 5%, more preferably less than 3%, and still more preferably less than 1%. The average value of transmittance of light having a wavelength of 1000 nm or more and less than 1500 nm is preferably less than 3%, more preferably less than 2%, and still more preferably less than 1%. In addition, in the film according to the embodiment of the present invention, an average value of transmittance of light having a wavelength of 1500 nm or more and less than 2000 nm is preferably less than 10% and more preferably less than 5%.

The film according to the embodiment of the present invention may be a film having a pattern or a film (flat film) not having a pattern. In addition, the film according to the embodiment of the present invention may be used in a state where it is laminated on a support, or the film according to the embodiment of the present invention may be peeled off from a support. Examples of the support include a semiconductor base material such as a silicon substrate, and a transparent base material.

A charge coupled device (CCD), a complementary metal-oxide semiconductor (CMOS), a transparent conductive film, or the like may be formed on the semiconductor base material used as the support. In addition, a black matrix which separates pixels from each other may be formed on the semiconductor base material. In addition, a base layer may be formed on a surface of the semiconductor base material. A surface contact angle of the base layer is preferably 20° to 70° in a case of being measured with diiodomethane. In addition, the surface contact angle of the base layer is preferably 30° to 80° in a case of being measured with water.

The transparent base material used as the support is not particularly limited as long as it is formed of a material which can allow transmission of at least visible light. Examples thereof include a base material formed of a material such as glass and resin. Examples of the resin include polyester resins such as polyethylene terephthalate and polybutylene terephthalate, polyolefin resins such as polyethylene, polypropylene, and ethylene vinyl acetate copolymer, norbornene resin, acrylic resins such as polyacrylate and polymethylmethacrylate, urethane resin, vinyl chloride resin, fluororesin, polycarbonate resin, polyvinyl butyral resin, and polyvinyl alcohol resin. Examples of the glass include soda lime glass, borosilicate glass, non-alkali glass, quartz glass, and copper-containing glass. Examples of the copper-containing glass include a phosphate glass containing copper and a fluorophosphate glass containing copper. As the copper-containing glass, a commercially available product may also be used. Examples of a commercially available product of the copper-containing glass include NF-50 (manufactured by AGC Techno Glass Co., Ltd.).

A thickness of the film according to the embodiment of the present invention can be adjusted according to the purpose. The thickness of the film is preferably 20 μm or less, more preferably 10 μm or less, and still more preferably 5 μm or less. The lower limit of the thickness of the film is preferably 0.1 μm or more and more preferably 0.2 μm or more.

The film according to the embodiment of the present invention can be used in combination with a color filter which includes a chromatic colorant. The color filter can be produced using a coloring composition containing a chromatic colorant. In a case where the film according to the embodiment of the present invention is used as an infrared cut filter and used in combination with a color filter, it is preferable that the color filter is disposed on an optical path of the film according to the embodiment of the present invention. For example, it is preferable that the film according to the embodiment of the present invention and the color filter are laminated and used as a laminate. In the laminate, the film according to the embodiment of the present invention and the color filter may be or may not be adjacent to each other in a thickness direction. In a case where the film according to the embodiment of the present invention is not adjacent

to the color filter in the thickness direction, the film according to the embodiment of the present invention may be formed on another support other than a support on which the color filter is formed, or another member (for example, a microlens or a planarizing layer) constituting a solid-state imaging element may be interposed between the film according to the embodiment of the present invention and the color filter.

The film according to the embodiment of the present invention can be used in various devices including a solid-state imaging element such as a charge coupled device (CCD) or a complementary metal-oxide semiconductor (CMOS), an infrared sensor, or an image display device.

<Method for producing film>

The film according to the embodiment of the present invention can be formed through a step of applying the composition according to the embodiment of the present invention.

Examples of the support are as described above. As a method of applying the composition, a known method can be used. Examples thereof include a dropping method (drop casting); a slit coating method; a spray method; a roll coating method; a spin coating method (spin coating); a cast coating method; a slit and spin method; a pre-wet method (for example, a method described in JP2009-145395A), various printing methods such as an inkjet (for example, on-demand type, piezo type, thermal type), a discharge printing such as nozzle jet, a flexo printing, a screen printing, a gravure printing, a reverse offset printing, and a metal mask printing method; a transfer method using molds and the like; and a nanoimprinting method. The application method using an ink jet method is not particularly limited, and examples thereof include a method (in particular, pp. 115 to 133) described in "Extension of Use of Ink Jet - Infinite Possibilities in Patent-" (published in February, 2005, S.B. Research Co., Ltd.) and methods described in JP2003-262716A, JP2003-185831A, JP2003-261827A, JP2012-126830A, and JP2006-169325A.

A composition layer formed by applying the composition may be dried (pre-baked). In a case of performing the pre-baking, the pre-baking temperature is preferably 150°C or lower, more preferably 120°C or lower, and still more preferably 110°C or lower. The lower limit may be set to, for example, 50°C or higher, or to 80°C or higher. The pre-baking time is preferably 10 seconds to 3000 seconds, more preferably 40 seconds to 2500 seconds, and still more preferably 80 seconds to 220 seconds. Drying can be performed using a hot plate, an oven, or the like.

The method of producing the film according to the embodiment of the present invention may further include a step of forming a pattern. Examples of the pattern forming method include a pattern forming method using a photolithography method and a pattern forming method using a dry etching method. Among these, the pattern forming method using a photolithography method is preferable. In a case where the film according to the embodiment of the present invention is used as a flat film, the step of forming a pattern is not necessarily performed. Hereinafter, the step of forming a pattern will be described in detail.

(Case where pattern is formed using photolithography method)

It is preferable that the pattern forming method using a photolithography method includes: a step (exposing step) of exposing the composition layer, which is formed by applying the composition according to the embodiment of the present invention, in a patterned manner; and a step (developing step) of forming a pattern by removing a non-exposed portion of the composition layer by development. Optionally, the pattern forming method may further include a step (post-baking step) of baking the developed pattern. Hereinafter, the respective steps will be described.

In the exposing step, the composition layer is exposed in a patterned manner. For example, the composition layer can be exposed in a patterned manner using a stepper exposure device or a scanner exposure device through a mask having a predetermined mask pattern. Thus, the exposed portion can be cured.

Examples of the radiation (light) which can be used during the exposure include g-rays and i-rays. In addition, light (preferably light having a wavelength of 180 to 300 nm) having a wavelength of 300 nm or less can also be used. Examples of the light having a wavelength of 300 nm or less include KrF-rays (wavelength: 248 nm) and ArF-rays (wavelength: 193 nm), and KrF-rays (wavelength: 248 nm) are preferable. In addition, a long-wave light source of 300 nm or more can be used.

In addition, in a case of exposure, the composition layer may be irradiated with light continuously to expose the composition layer, or the composition layer may be irradiated with light in a pulse to expose the composition layer (pulse exposure). The pulse exposure refers to an exposing method in which light irradiation and resting are repeatedly performed in a short cycle (for example, millisecond-level or less).

The irradiation amount (exposure amount) is, for example, preferably 0.03 to 2.5 J/$cm^2$ and more preferably 0.05 to 1.0 J/$cm^2$. The oxygen concentration during the exposure can be appropriately selected, and the exposure may also be performed, for example, in a low-oxygen atmosphere having an oxygen concentration of 19% by volume or less (for example, 15% by volume, 5% by volume, and substantially oxygen-free) or in a high-oxygen atmosphere having an oxygen concentration of more than 21% by volume (for example, 22% by volume, 30% by volume, and 50% by volume),

in addition to an atmospheric air. In addition, the exposure illuminance can be appropriately set, and can be usually selected from a range of 1000 $W/m^2$ to 100,000 $W/m^2$ (for example, 5,000 $W/m^2$, 15,000 $W/m^2$, or 35,000 $W/m^2$). Appropriate conditions of each of the oxygen concentration and the exposure illuminance may be combined, and for example, a combination of the oxygen concentration of 10% by volume and the illuminance of 10,000 $W/m^2$, a combination of the oxygen concentration of 35% by volume and the illuminance of 20,000 $W/m^2$, or the like is available.

Next, a pattern is formed by removing a non-exposed portion of the exposed composition layer by development. The non-exposed portion of the composition layer can be removed by development using a developer. As a result, a non-exposed portion of the composition layer in the exposing step is eluted into the developer, and only the photocured portion remains on the support. The temperature of the developer is preferably, for example, 20°C to 30°C. The development time is preferably 20 to 180 seconds. In addition, in order to improve residue removing properties, a step of removing the developer by shaking off per 60 seconds and supplying a fresh developer may be repeated multiple times.

Examples of the developer include an organic solvent and an alkali developer, and an alkali developer is preferably used. As the alkali developer, an alkaline aqueous solution (alkali developer) in which an alkaline agent is diluted with pure water is preferable. Examples of the alkaline agent include organic alkaline compounds such as ammonia, ethylamine, diethylamine, dimethylethanolamine, diglycol amine, diethanolamine, hydroxyamine, ethylenediamine, tetramethylammonium hydroxide, tetraethylammonium hydroxide, tetrapropylammonium hydroxide, tetrabutylammonium hydroxide, ethyltrimethylammonium hydroxide, benzyltrimethylammonium hydroxide, dimethylbis(2-hydroxyethyl)ammonium hydroxide, choline, pyrrole, piperidine, and 1,8-diazabicyclo[5.4.0]-7-undecene, and inorganic alkaline compounds such as sodium hydroxide, potassium hydroxide, sodium carbonate, sodium hydrogen carbonate, sodium silicate, and sodium metasilicate. In consideration of environmental aspects and safety aspects, the alkaline agent is preferably a compound having a high molecular weight. The concentration of the alkaline agent in the alkaline aqueous solution is preferably 0.001% to 10% by mass and more preferably 0.01% to 1% by mass. In addition, the developer may further contain a surfactant. As the surfactant, a nonionic surfactant is preferable. From the viewpoint of transportation, storage, and the like, the developer may be first produced as a concentrated solution and then diluted to a concentration required upon the use. The dilution factor is not particularly limited and, for example, can be set to be in a range of 1.5 to 100 times. In addition, it is also preferable to wash (rinse) with pure water after development. In addition, it is preferable that the rinsing is performed by supplying a rinsing liquid to the composition layer after development while rotating the support on which the composition layer after development is formed. In addition, it is preferable that the rinsing is performed by moving a nozzle discharging the rinsing liquid from a center of the support to a peripheral edge of the support. In this case, in the movement of the nozzle from the center of the support to the peripheral edge of the support, the nozzle may be moved while gradually decreasing the moving speed of the nozzle. By performing rinsing in this manner, in-plane variation of rinsing can be suppressed. In addition, the same effect can be obtained by gradually decreasing the rotating speed of the support while moving the nozzle from the center of the support to the peripheral edge of the support.

After the development, it is preferable to carry out an additional exposure treatment or a heating treatment (post-baking) after carrying out drying. The additional exposure treatment or the post-baking is a curing treatment after development in order to complete curing. The heating temperature in the post-baking is, for example, preferably 100°C to 240°C and more preferably 200°C to 240°C. The film after development is post-baked continuously or batchwise using a heating unit such as a hot plate, a convection oven (hot air circulation dryer), and a high-frequency heater under the above-described conditions. In a case of performing the additional exposure treatment, light used for the exposure is preferably light having a wavelength of 400 nm or less. In addition, the additional exposure treatment may be carried out by the method described in KR10-2017-0122130A.

(Case where pattern is formed using dry etching method)

The formation of a pattern using a dry etching method can be performed using a method including: applying the above-described composition to a support or the like to form a composition layer; curing the formed composition layer to form a cured composition layer; forming a patterned photoresist layer on the cured composition layer; and dry-etching the cured composition layer with etching gas by using the patterned photoresist layer as a mask. It is preferable that pre-baking treatment is performed in order to form the photoresist layer. The details of the pattern formation by the dry etching method can be found in paragraph Nos. 0010 to 0067 of JP2013-064993A, the content of which is incorporated herein by reference.

<Optical filter>

The optical filter according to the embodiment of the present invention has the above-described film according to the embodiment of the present invention. Examples of the type of the optical filter include an infrared cut filter and an infrared transmitting filter.

The optical filter according to the embodiment of the present invention may have a layer containing copper, a dielectric multi-layer film, or an ultraviolet absorbing layer in addition to the film according to the embodiment of the present invention. Examples of the ultraviolet absorbing layer include absorbing layers described in paragraph Nos. 0040 to 0070 and 0119 to 0145 of WO2015/099060A. Examples of the dielectric multi-layer film include dielectric multi-layer films described in paragraph Nos. 0255 to 0259 of JP2014-041318A. As the layer containing copper, a glass substrate (copper-containing glass substrate) formed of glass containing copper, or a layer (copper complex-containing layer) containing a copper complex may also be used. Examples of the copper-containing glass substrate include a phosphate glass including copper and a fluorophosphate glass including copper. Examples of a commercially available product of the copper-containing glass include NF-50 (manufactured by AGC Techno Glass Co., Ltd.), BG-60 and BG-61 (both of which are manufactured by Schott AG), and CD5000 (manufactured by Hoya Corporation).

<Solid-state imaging element>

The solid-state imaging element according to the embodiment of the present invention includes the film according to the embodiment of the present invention. The configuration of the solid-state imaging element is not particularly limited as long as it includes the film according to the embodiment of the present invention and functions as a solid-state imaging element. For example, the following configuration can be adopted.

The solid-state imaging element includes a plurality of photodiodes and transfer electrodes on the support, the photodiodes consisting of a light receiving area of the solid-state imaging element, and the transfer electrode consisting of polysilicon or the like. In the solid-state imaging element, a light-shielding film consisting of tungsten or the like which has openings through only light receiving sections of the photodiodes is provided on the photodiodes and the transfer electrodes, a device protective film consisting of silicon nitride or the like is formed on the light-shielding film so as to cover the entire surface of the light-shielding film and the light receiving sections of the photodiodes, and the film according to the embodiment of the present invention is formed on the device protective film. Furthermore, a configuration in which a light collecting unit (for example, a microlens; hereinafter, the same shall be applied) is provided above the device protective film and below the film according to the embodiment of the present invention (on a side thereof close the support), or a configuration in which a light collecting unit is provided on the film according to the embodiment of the present invention may be adopted. In addition, the color filter may have a structure in which a film which forms each pixel is embedded in a space which is partitioned in, for example, a lattice form by a partition wall. In this case, it is preferable that the partition wall has a lower refractive index than each pixel. Examples of an imaging device having such a structure include devices described in JP2012-227478A and JP2014-179577A.

<Image display device>

An image display device according to the embodiment of the present invention includes the film according to the embodiment of the present invention. Examples of the image display device include a liquid crystal display device or an organic electroluminescence (organic EL) display device. The definitions or details of image display devices are described in, for example, "Electronic Display Device (Akio Sasaki, Kogyo Chosakai Publishing Co., Ltd., published in 1990)", "Display Device (Sumiaki Ibuki, Sangyo Tosho Co., Ltd.)", and the like. In addition, the liquid crystal display device is described in, for example, "Liquid Crystal Display Technology for Next Generation (edited by Tatsuo Uchida, Kogyo Chosakai Publishing Co., Ltd., published in 1994)". The liquid crystal display device to which the present invention can be applied is not particularly limited, and can be applied to, for example, liquid crystal display devices employing various systems described in the "Liquid Crystal Display Technology for Next Generation". The image display device may be an image display device having a white organic EL element. It is preferable that the white organic EL element has a tandem structure. The tandem structure of the organic EL element is described in, for example, JP2003-045676A, or pp. 326 to 328 of "The Forefront of Organic EL Technology Development -Know-How Collection of High Brightness, High Precision, and Long Life" (Technical Information Institute, 2008). It is preferable that a spectrum of white light emitted from the organic EL element has high maximal emission peaks in a blue range (430 to 485 nm), a green range (530 to 580 nm), and a yellow range (580 to 620 nm). It is more preferable that the spectrum has a maximal emission peak in a red range (650 to 700 nm) in addition to the above-described emission peaks.

<Infrared sensor>

An infrared sensor according to the embodiment of the present invention includes the film according to the embodiment of the present invention. The configuration of the infrared sensor is not particularly limited as long as it functions as an infrared sensor. Hereinafter, an embodiment of the infrared sensor according to the present invention will be described using the drawing.

In Fig. 1, reference numeral 110 represents a solid-state imaging element. Infrared cut filters 111 and infrared

transmitting filters 114 are arranged in an imaging region of the solid-state imaging element 110. In addition, color filters 112 are arranged on the infrared cut filters 111. Microlenses 115 are disposed on an incidence ray hv side of the color filters 112 and the infrared transmitting filters 114. A planarizing layer 116 is formed so as to cover the microlenses 115.

The infrared cut filter 111 can be formed of the composition according to the embodiment of the present invention. The color filters 112 is not particularly limited as long as pixels which allow transmission of light having a specific wavelength in a visible range and absorbs the light are formed therein, and a known color filter in the related art for forming a pixel can be used. For example, pixels of red (R), green (G), and blue (B) are formed in the color filters. For example, the details of the color filters can be found in paragraph Nos. 0214 to 0263 of JP2014-043556A, the content of which is incorporated herein by reference. Characteristics of the infrared transmitting filter 114 can be selected according to the emission wavelength of the infrared LED to be used. The infrared transmitting filter 114 can be formed of the composition according to the embodiment of the present invention.

In the infrared sensor shown in Fig. 1, an infrared cut filter (other infrared cut filters) other than the infrared cut filter 111 may be further disposed on the planarizing layer 116. As the other infrared cut filters, for example, a layer containing copper and/or a dielectric multi-layer film may be provided. The details of the examples are as described above. In addition, as the other infrared cut filters, a dual band pass filter may be used.

## Examples

Hereinafter, the present invention will be described in detail with reference to Examples. Materials, used amounts, proportions, treatment details, treatment procedures, and the like shown in the following examples can be appropriately changed within a range not departing from the scope of the present invention. In addition, in the structural formulae, Bu represents a butyl group, Ph represents a phenyl group, Mes a 2,4,6-trimethylphenyl group (mesityl group), and Tf represents a trifluoromethylsulfonyl group.

<Measurement of weight-average molecular weight and number-average molecular weight>

For measurement of a weight-average molecular weight of a resin, HPC-8220GPC (manufactured by Tosoh Corporation) was used as a measurement device, TSKguard column SuperHZ-L was used as a guard column, directly connected columns of TSKgel SuperHZM-M, TSKgel SuperHZ4000, TSKgel SuperHZ3000, and TSKgel SuperHZ2000 were used as a column. In addition, a column temperature was set to 40°C, 10 μL of a tetrahydrofuran solution with a sample concentration of 0.1% by mass was injected into the column, tetrahydrofuran was allowed to flow as an elution solvent at a flow rate of 0.35 mL per minute, and the sample peak was detected with an RI (differential refractive index) detector. Thereafter, concentration was made using a calibration curve created using standard polystyrene.

<Preparation of dispersion liquid>

(Dispersion liquid IR1)

2 parts by mass of a compound A103 (infrared absorber, maximal absorption wavelength: 960 nm) having the following structure, 0.4 parts by mass of a pigment derivative IS-2, 1.6 parts by mass of a dispersant D-2, and 6 parts by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid IR1.

(Dispersion liquid IR2)

2 parts by mass of a compound A105 (infrared absorber, maximal absorption wavelength: 810 nm) having the following structure, 0.4 parts by mass of a pigment derivative B1, 1.6 parts by mass of a dispersant D-1, and 6 parts by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid IR2.

(Dispersion liquid IR3)

2 parts by mass of a compound 106 (infrared absorber, maximal absorption wavelength: 830 nm) having the following structure, 0.4 parts by mass of a pigment derivative IS-6, 1.6 parts by mass of a dispersant D-1, and 6 parts

by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid IR3.

(Dispersion liquid Bk1)

12.59 parts by mass of Irgaphor Black (manufactured by BASF SE, black colorant), 4.4 parts by mass of a dispersant D-3, and 83.01 parts by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid Bk1.

(Dispersion liquid Blue1)

12.59 parts by mass of C. I. Pigment Blue 16 (blue colorant), 4.4 parts by mass of a dispersant D-3, and 83.01 parts by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid Blue1.

(Dispersion liquid Yellow1)

11 parts by mass of a metal azo pigment 1 (yellow colorant) described below, 1.59 parts by mass of the pigment derivative B1, 4.4 parts by mass of a dispersant D-3, and 83.01 parts by mass of propylene glycol monomethyl ether acetate were mixed with each other, and using a beads mill (a high-pressure disperser with a pressure reducing mechanism, NANO-3000-10 (manufactured by Nippon BEE Chemical Co., Ltd.)) in which zirconia beads having a diameter of 0.3 mm were used, the mixed solution was mixed and dispersed for 3 hours to prepare a dispersion liquid Yellow1.

Compounds A103, A105, A106: compounds having the following structures

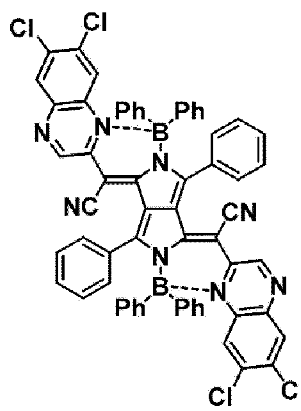

A103

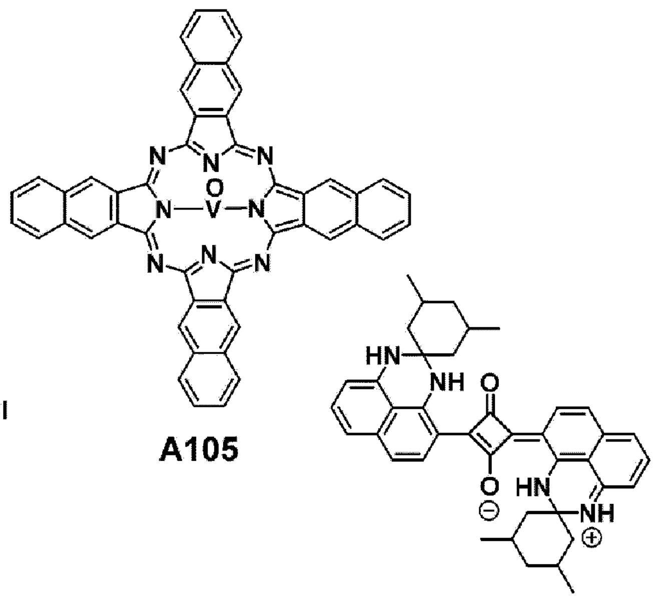

A105

A106

Metal azo pigment 1: metal azo pigment 1 produced by the following method. 46.2 g of diazobarbituric acid and 38.4 g of barbituric acid were added to 1,100 g of distilled water at 85°C. Next, a potassium hydroxide aqueous solution was added to the solution to adjust pH to approximately 5, and the solution was stirred for 90 minutes to produce

an azobarbituric acid precursor. Next, 1,500 g of distilled water at 82°C was added to the above-described azobarbituric acid precursor. Next, 10 g of 30% hydrochloric acid was added dropwise thereto. Next, 79.4 g of melamine was added thereto. Next, a mixture of 0.282 mol of approximately 25% zinc chloride solution and 0.0015 mol of approximately 30% copper(II) chloride solution was added dropwise thereto. Next, the solution to which these compounds had been added was allowed to stand for 3 hours at a temperature of 82°C, and KOH was added thereto to adjust pH to approximately 5.5. Next, the solution was heated to 90°C, and while maintaining the temperature at 90°C, 100 g of distilled water was added thereto to dilute the solution. Next, 21 g of 30% hydrochloric acid was added dropwise to the solution, and then the solution was subjected to a heating treatment at a temperature of 90°C for 12 hours. Next, a potassium hydroxide aqueous solution was added to the solution after the heating treatment to adjust pH to approximately 5. Next, a pigment was isolated from the solution by a suction filter, washed, dried in a vacuum drying cabinet at 80°C, and then ground in a standard laboratory mill for about 2 minutes to produce the metal azo pigment 1.

Pigment derivative IS-2: compound having the following structure

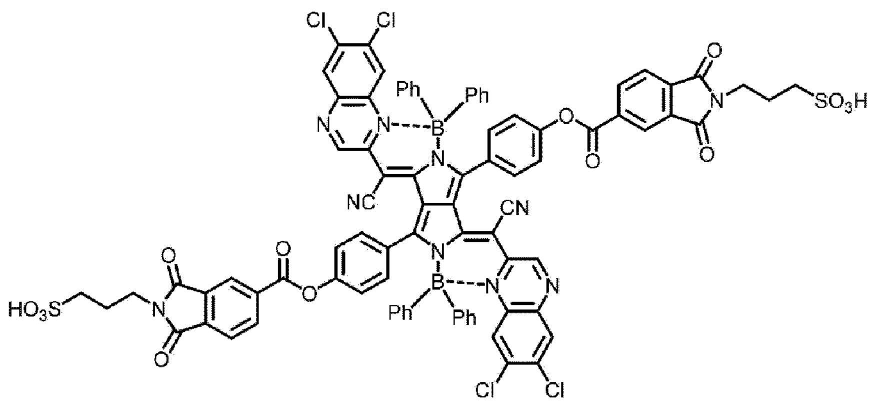

Pigment derivative IS-6: compound having the following structure

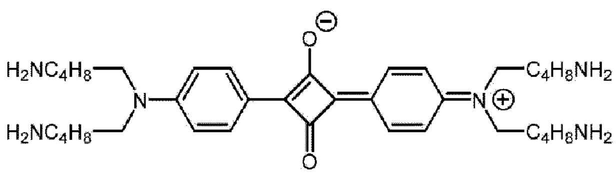

Pigment derivative B1: compound having the following structure

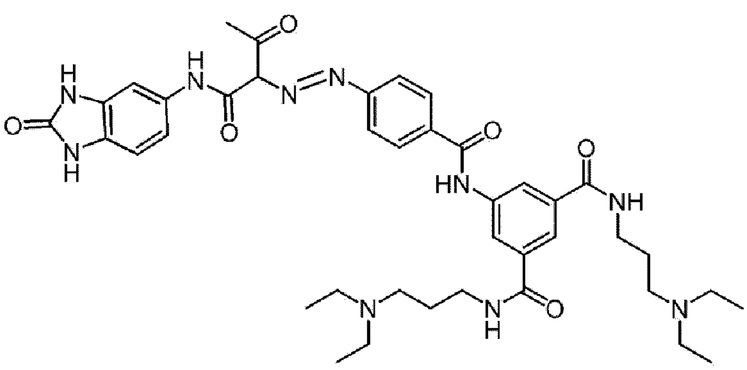

Dispersant D-1: resin having the following structure (the numerical value described together with the main chain indicates a molar ratio, and the numerical value described together with the side chain indicates the number of repeating units; weight-average molecular weight: 24,000)

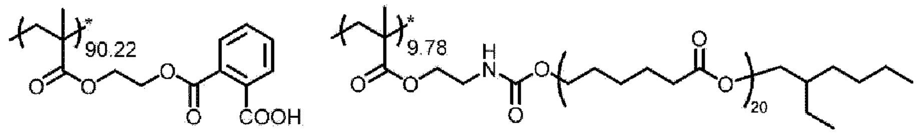

Dispersant D-2: resin having the following structure (the numerical value described together with the main chain indicates a molar ratio, and the numerical value described together with the side chain indicates the number of repeating units; weight-average molecular weight: 21,000)

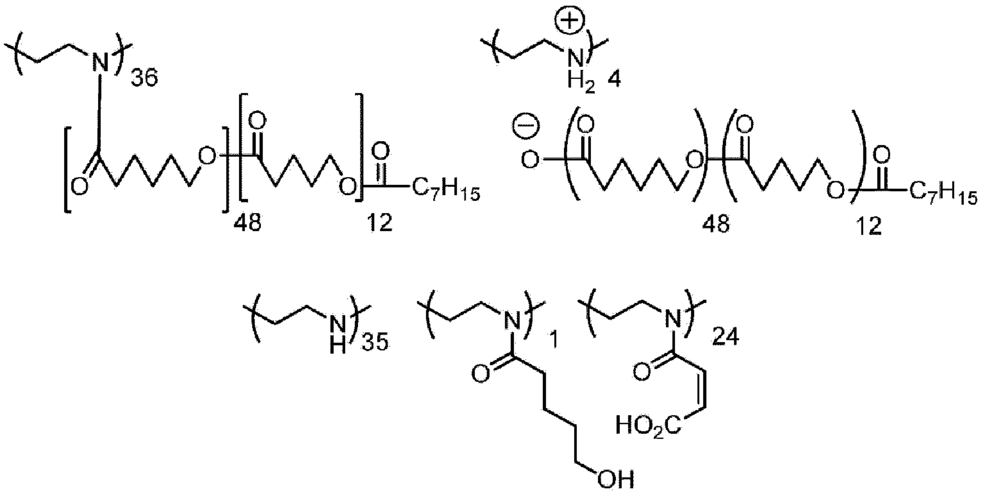

Dispersant D-3: resin having the following structure (the numerical value described together with the main chain indicates a molar ratio, and the numerical value described together with the side chain indicates the number of repeating units; weight-average molecular weight: 24,000)

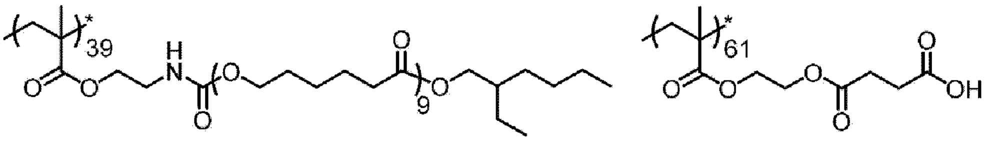

<Preparation of composition>

Materials other than a solvent, shown in the following tables, were mixed with each other at proportions shown in the following tables, and the solvent shown in the following tables was added thereto to adjust the concentration of solid contents to 20% by mass. Thereafter, the mixture was stirred and filtered through a nylon filter (manufactured by Nihon Pall Corporation) having a pore diameter of 0.45 μm to prepare a composition. The numerical value in the column of blending amount in the tables is a value of parts by mass expressed in terms of solid contents.

[Table 1]

| | Infrared absorber 1 | | Infrared absorber 2 | | Dispersion liquid | | Resin | | Photopolymerization initiator | | Polymerizable compound | | Surfactant | | Polymerization inhibitor | | Other additives | | Solvent |
|---|---|---|---|---|---|---|---|---|---|---|---|---|---|---|---|---|---|---|---|
| | Type | Blending amount | Type | Blending amount | Type | Blending amount | Type | Blending amount | Type | Blending amount | Type | Blending amount | Type | Blending amount | Type | Blending amount | Type | Blending amount | |
| Example 1 | A001 | 15 | A101 | 15 | - | - | B001 | 65 | - | - | - | - | F-1 | 0.003 | - | - | - | - | S001 |
| Example 2 | A001 | 15 | A101 | 15 | - | - | B002 | 50 | C-1 | 10 | M-1 | 10 | F-1 | 0.003 | G-1 | 0.003 | - | - | S001 |
| Example 3 | A001 | 15 | A102 | 15 | - | - | B002 | 50 | C-1 | 10 | M-1 | 10 | F-1 | 0.003 | G-1 | 0.003 | - | - | S001 |
| Example 4 | A001 | 15 | - | - | IR1 | 15 | B002 | 50 | C-1 | 10 | M-1 | 10 | F-1 | 0.003 | G-1 | 0.003 | - | - | S001 |
| Example 5 | A001 | 15 | A104 | 15 | - | - | B002 | 50 | C-1 | 10 | M-1 | 10 | F-1 | 0.003 | G-1 | 0.003 | - | - | S001 |
| Example 6 | A001 | 15 | - | - | IR2 | 15 | B002 | 50 | C-1 | 10 | M-1 | 10 | F-1 | 0.003 | G-1 | 0.003 | - | - | S001 |
| Example 7 | A001 | 15 | - | - | IR3 | 15 | B002 | 50 | C-1 | 10 | M-1 | 10 | F-1 | 0.003 | G-1 | 0.003 | - | - | S001 |
| Example 8 | A002 | 15 | - | - | IR1 | 15 | B002 | 50 | C-1 | 10 | M-1 | 10 | F-1 | 0.003 | G-1 | 0.003 | - | - | S001 |
| Example 9 | A001<br>A002 | 7.5<br>7.5 | - | - | IR1 | 15 | B002 | 45 | C-1 | 10 | M-1 | 10 | F-1 | 0.003 | G-1 | 0.003 | - | - | S001 |
| Example 10 | A003 | 15 | - | - | IR1 | 15 | B002 | 50 | C-1 | 10 | M-1 | 10 | F-1 | 0.003 | G-1 | 0.003 | - | - | S001 |
| Example 11 | A004 | 15 | - | - | IR1 | 15 | B002 | 50 | C-1 | 10 | M-1 | 10 | F-1 | 0.003 | G-1 | 0.003 | - | - | S001 |
| Example 12 | A005 | 15 | - | - | IR1 | 15 | B002 | 50 | C-1 | 10 | M-1 | 10 | F-1 | 0.003 | G-1 | 0.003 | - | - | S001 |
| Example 13 | A001 | 15 | - | - | IR1 | 15 | B003 | 50 | C-1 | 10 | M-1 | 10 | F-1 | 0.003 | G-1 | 0.003 | - | - | S001 |

(continued)

| | Infrared absorber 1 | | Infrared absorber 2 | | Dispersion liquid | | Resin | | Photopolymerization initiator | | Polymerizable compound | | Surfactant | | Polymerization inhibitor | | Other additives | | Solvent |
|---|---|---|---|---|---|---|---|---|---|---|---|---|---|---|---|---|---|---|---|
| | Type | Blending amount | Type | Blending amount | Type | Blending amount | Type | Blending amount | Type | Blending amount | Type | Blending amount | Type | Blending amount | Type | Blending amount | Type | Blending amount | |
| Example 14 | A001 | 15 | - | - | IR1 | 15 | B003 | 50 | C-2 | 10 | M-1 | 10 | F-1 | 0.003 | G-1 | 0.003 | - | - | S001 |
| Example 15 | A001 | 15 | - | - | IR1 | 15 | B003 | 50 | C-1 | 10 | M-2 | 10 | F-1 | 0.003 | G-1 | 0.003 | - | - | S001 |
| Example 16 | A001 | 15 | - | - | IR1 | 15 | B003 | 50 | C-1 | 10 | M-3 | 10 | F-1 | 0.003 | G-1 | 0.003 | - | - | S001 |
| Example 17 | A001 | 15 | - | - | IR1 | 15 | B003 | 50 | C-1 | 10 | M-1 | 10 | F-2 | 0.003 | G-1 | 0.003 | - | - | S001 |
| Example 18 | A001 | 15 | - | - | IR1 | 15 | B003 | 50 | C-1 | 10 | M-1 | 10 | F-3 | 0.003 | G-1 | 0.003 | - | - | S001 |
| Example 19 | A001 | 15 | - | - | IR1 | 15 | B003 | 50 | C-1 | 10 | M-1 | 10 | - | - | G-1 | 0.003 | - | - | S001 |
| Example 20 | A001 | 15 | - | - | IR1 | 15 | B003 | 55 | C-1 | 10 | - | - | F-1 | 0.003 | G-1 | 0.003 | - | - | S001 |

[Table 2]

| | Infrared absorber 1 | | Infrared absorber 2 | | Dispersion liquid | | Resin | | Photopolymerization initiator | | Polymerizable compound | | Surfactant | | Polymerization inhibitor | | Other additives | | Solvent |
|---|---|---|---|---|---|---|---|---|---|---|---|---|---|---|---|---|---|---|---|
| | Type | Blending amount | Type | Blending amount | Type | Blending amount | Type | Blending amount | Type | Blending amount | Type | Blending amount | Type | Blending amount | Type | Blending amount | Type | Blending amount | |
| Example 21 | A001 | 15 | - | - | IR1 | 15 | B004 | 50 | C-1 | 10 | M-1 | 10 | F-1 | 0.003 | G-1 | 0.003 | - | - | S001 |
| Example 22 | A001 | 15 | A102 | 15 | - | - | B004 | 50 | C-1 | 10 | M-1 | 10 | F-1 | 0.003 | G-1 | 0.003 | - | - | S002 |
| Example 23 | A001<br>A003 | 7.5<br>7.5 | - | - | IR1 | 15 | B002 | 45 | C-1 | 10 | M-1 | 10 | F-1 | 0.003 | G-1 | 0.003 | - | - | S001 |
| Example 24 | A001 | 15 | - | - | IR1 | 15 | B003 | 50 | C-1<br>C-2 | 5<br>5 | M-1 | 10 | F-1 | 0.003 | G-1 | 0.003 | - | - | S001 |
| Example 25 | A001 | 15 | A101 | 5 | IR1 | 10 | B003 | 50 | C-1 | 10 | M-1 | 10 | F-1 | 0.003 | G-1 | 0.003 | - | - | S001 |
| Example 26 | A001<br>A003 | 7.5<br>7.5 | - | - | IR1 | 15 | B002 | 45 | C-1 | 10 | M-1 | 10 | F-1<br>F-2 | 0.002<br>0.002 | G-1 | 0.003 | - | - | S001 |
| Example 27 | A001 | 15 | - | - | IR1 | 15 | BOOS | 50 | C-2 | 10 | M-1<br>M-3 | 5<br>5 | F-1 | 0.003 | G-1 | 0.003 | - | - | S001 |
| Example 28 | A001 | 15 | - | - | IR1 | 15 | B003<br>B002 | 30<br>20 | C-2 | 10 | M-1 | 10 | F-1 | 0.003 | G-1 | 0.003 | - | - | S001 |
| Example 29 | A001 | 15 | - | - | IR1 | 15 | B003 | 48 | C-2 | 10 | M-1 | 10 | F-1 | 0.003 | G-1 | 0.003 | U-1 | 2 | S001 |
| Example 30 | A001 | 15 | - | - | IR1 | 15 | B003 | 48 | C-2 | 10 | M-1 | 10 | F-1 | 0.003 | G-1 | 0.003 | U-2 | 2 | S001 |
| Example 31 | A001 | 15 | - | - | IR1 | 15 | B003 | 48 | C-2 | 10 | M-1 | 10 | F-1 | 0.003 | G-1 | 0.003 | U-3 | 2 | S001 |
| Example 32 | A001 | 15 | - | - | IR1<br>Bk1 | 10<br>25 | B003 | 30 | C-2 | 10 | M-1 | 10 | F-1 | 0.003 | G-1 | 0.003 | - | - | S001 |
| Example 33 | A001 | 15 | - | - | IR1<br>Blue1<br>Yellow1 | 10<br>12<br>13 | BOOS | 30 | C-2 | 10 | M-1 | 10 | F-1 | 0.003 | G-1 | 0.003 | - | - | S001 |
| Comparative Example 1 | A004 | 30 | - | - | - | - | B001 | 65 | - | - | - | - | F-1 | 0.003 | - | - | - | - | S001 |

(continued)

| | Infrared absorber 1 | | Infrared absorber 2 | | Dispersion liquid | | Resin | | Photopolymerization initiator | | Polymerizable compound | | Surfactant | | Polymerization inhibitor | | Other additives | | Solvent |
|---|---|---|---|---|---|---|---|---|---|---|---|---|---|---|---|---|---|---|---|
| | Type | Blending amount | Type | Blending amount | Type | Blending amount | Type | Blending amount | Type | Blending amount | Type | Blending amount | Type | Blending amount | Type | Blending amount | Type | Blending amount | |
| Comparative Example 2 | - | - | A101 | 30 | - | - | B001 | 65 | - | - | - | - | F-1 | 0.003 | - | - | - | - | S001 |

Details of the materials shown in the above tables are as follows.

(Infrared absorber)

[Compound represented by Formula (1)]

A001: compound having the following structure (maximal absorption wavelength: 1470 nm)
A002: compound having the following structure (maximal absorption wavelength: 1470 nm)
A003: compound having the following structure (maximal absorption wavelength: 1730 nm)
A004: compound having the following structure (maximal absorption wavelength: 1470 nm)
A005: compound having the following structure (maximal absorption wavelength: 1410 nm)

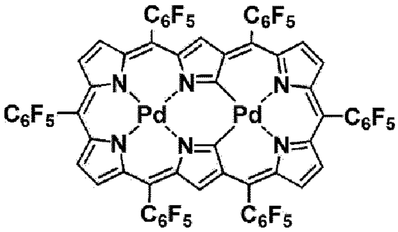

A001

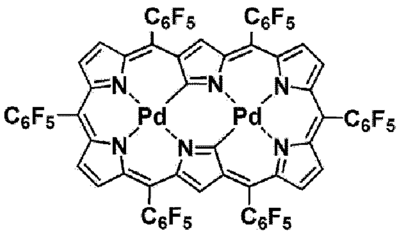

A002

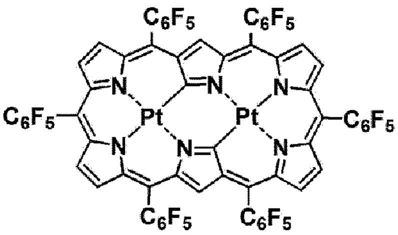

A003

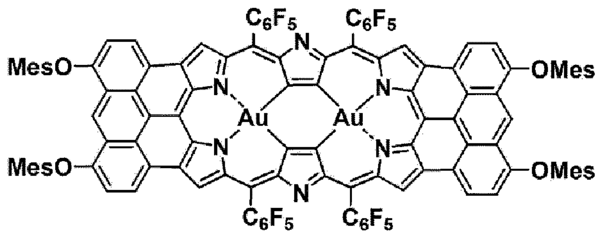

A004

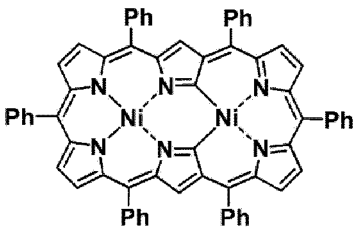

A005

[Infrared absorber other than compound represented by Formula (1)]

A101: compound A101 having the following structure (maximal absorption wavelength: 1090 nm)
A102: compound A102 having the following structure (maximal absorption wavelength: 790 nm)
A104: compound A104 having the following structure (maximal absorption wavelength: 800 nm)

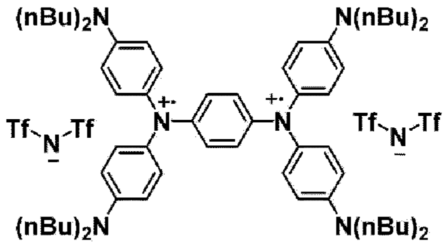

A101

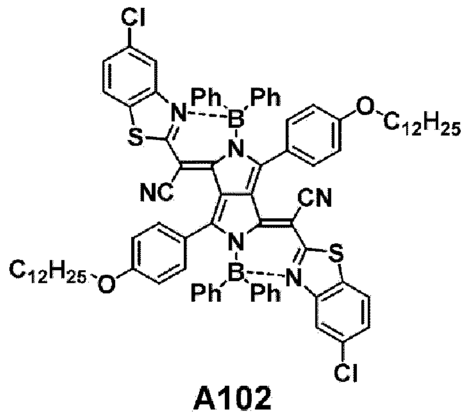

A102

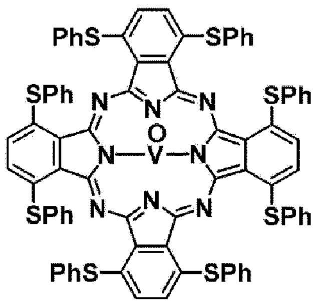

A104

(Dispersion liquid)

IR1, IR2, IR3, Bk1, Blue1, Yellow1: dispersion liquids IR1, IR2, IR3, Bk1, Blue1, and Yellow1 described above

(Resin)

B001: polymethyl methacrylate (weight-average molecular weight: 24,000, degree of dispersion: 1.8, glass transition temperature: 75°C)

B002: resin having the following structure (resin having an acid group; the numerical value described together with the main chain indicates a molar ratio of a repeating unit; weight-average molecular weight: 20,000, degree of dispersion: 1.9, glass transition temperature: 100°C)

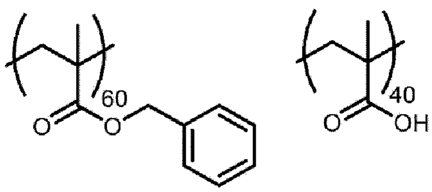

B003: resin having the following structure (resin having an acid group; the numerical value described together with the main chain indicates a molar ratio of a repeating unit; weight-average molecular weight: 15,000, degree of dispersion: 2.1, glass transition temperature: 120°C)

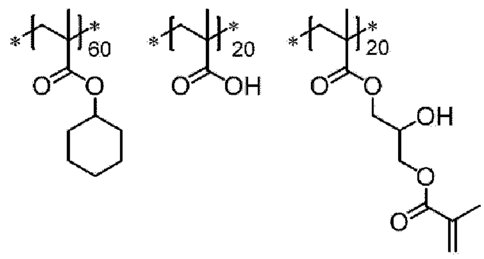

B004: resin having the following structure (polyimide resin; weight-average molecular weight: 25,000, degree of dispersion: 2.2, glass transition temperature: 310°C)

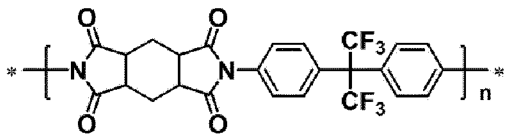

(Polymerizable compound)

M-1: ARONIX M-305 (manufactured by TOAGOSEI CO., LTD.; mixture of pentaerythritol triacrylate and pentaerythritol tetraacrylate; content of the pentaerythritol triacrylate is 55% by mass to 63% by mass)
M-2: KAYARAD RP-1040 (manufactured by Nippon Kayaku Co., Ltd., ethylene oxide-modified pentaerythritol tetraacrylate)
M-3: ARONIX M-510 (manufactured by TOAGOSEI CO., LTD., polybasic acid-modified acrylic oligomer)

(Photopolymerization initiator)

C-1: Irgacure OXE01 (manufactured by BASF SE, oxime ester-based initiator)
C-2: Irgacure OXE02 (manufactured by BASF SE, oxime ester-based initiator)

(Surfactant)

F-1: MEGAFACE RS-72-K (manufactured by DIC Corporation, fluorine-based surfactant)
F-2: compound having the following structure (weight-average molecular weight: 14,000; a numerical value "%" representing the proportion of a repeating unit is mol%)

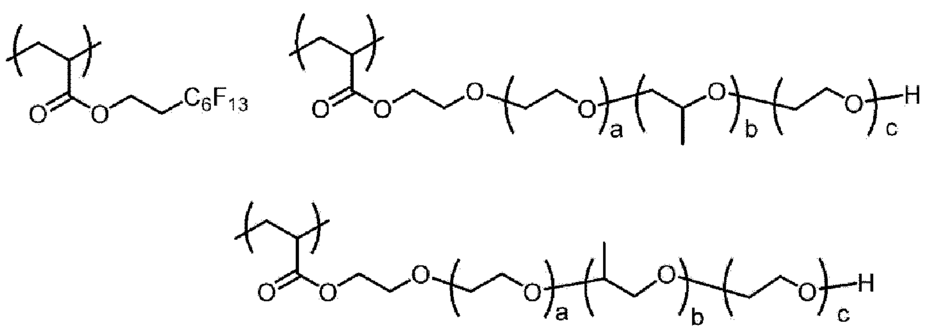

62% 38%

a+c=14
b=17

F-3: KF-6001 (manufactured by Shin-Etsu Chemical Co., Ltd., both-terminal carbinol-modified polydimethylsiloxane; hydroxyl value: 62 mgKOH/g)

(Polymerization inhibitor)

G-1: p-methoxyphenol

(Other additives)

U-1: Uvinul 3050 (manufactured by BASF SE, ultraviolet absorber)
U-2: Tinuvin 477 (manufactured by BASF SE, hydroxyphenyltriazine-based ultraviolet absorber)
U-3: Tinuvin 326 (manufactured by BASF SE, ultraviolet absorber)

(Solvent)

S001: propylene glycol monomethyl ether acetate
S002: propylene glycol monomethyl ether

<Evaluation of infrared shielding properties, heat resistance, and light resistance>

A glass substrate was spin-coated with each composition so that a film thickness after film formation was 1.0 μm, using an i-ray stepper exposure device FPA-3000 i5+ (manufactured by Canon Inc.), the entire surface was exposed with an exposure amount of 1000 mJ/cm$^2$. Next, the glass substrate was heated using a hot plate at 200°C for 2 minutes to manufacture a film.

-Regarding evaluation of infrared shielding properties-

With the glass substrate on which the above-described film had been formed, using an ultraviolet-visible-near infrared spectrophotometer (U-4100, manufactured by Hitachi High-Tech Corporation), a transmittance in a wavelength range of 400 to 2000 nm was measured, an average value (average transmittance 1) of transmittance in a wavelength range of 800 nm or more and less than 1000 nm, an average value (average transmittance 2) of transmittance in a wavelength range of 1000 nm or more and less than 1500 nm, and an average value (average transmittance 3) of transmittance in a wavelength range of 1500 nm or more and less than 2000 nm was respectively obtained, and infrared shielding properties were evaluated according to the following standard.

A: average value of transmittance was less than 5%.
B: average value of transmittance was 5% or more and less than 10%.
C: average value of transmittance was 10% or more.

-Regarding evaluation of light resistance-

With the glass substrate on which the above-described film had been formed, using an ultraviolet-visible-near infrared spectrophotometer (U-4100, manufactured by Hitachi High-Tech Corporation), a transmittance in a wavelength range of 400 to 2000 nm was measured. Next, the glass substrate on which the above-described film had been formed was irradiated with light at 100,000 lux for 20 hours (corresponding to 2 million lux·h) using a xenon lamp, and then a transmittance of the film after the irradiation by the xenon lamp was measured. An amount of change in transmittance (ΔT1) at each wavelength in a wavelength range of 800 to 2000 nm before and after the irradiation by the xenon lamp was obtained, and based on the largest value of ΔT1 in the entire measurement wavelength range, light resistance was evaluated according to the following standard. As the value of ΔT1 is smaller, the light resistance is better.

$$\text{Change in transmittance } (\Delta T1) = |\text{Transmittance of film before irradiation by xenon lamp} - \text{Transmittance of film after irradiation by xenon lamp}|$$

A: ΔT1 was less than 3%.
B: ΔT1 was 3% or more and less than 5%.
C: ΔT1 was 5% or more.

-Regarding evaluation of heat resistance-

With the glass substrate on which the above-described film had been formed, using an ultraviolet-visible-near infrared spectrophotometer (U-4100, manufactured by Hitachi High-Tech Corporation), a transmittance in a wavelength range of 400 to 1600 nm was measured. Next, the glass substrate on which the above-described film had been formed was heated at 200°C for 10 minutes using a hot plate. An amount of change in transmittance (ΔT2) at each wavelength in a wavelength range of 1000 to 1500 nm before and after the heating was obtained, and based on the largest value of ΔT2 in the entire measurement wavelength range, heat resistance was evaluated according to the following standard. As the value of ΔT2 is smaller, the heat resistance is better.

$$\text{Change in transmittance } (\Delta T2) = |\text{Transmittance of film before heating} - \text{Transmittance of film after heating}|$$

A: ΔT2 was less than 5%.
B: ΔT2 was 5% or more and less than 10%.
C: ΔT2 was 10% or more.

<Evaluation of pattern formability>

A glass substrate was spin-coated with each composition so that a film thickness after film formation was 1.0 μm, and then heated on a hot plate at 100°C for 2 minutes. Next, using an i-ray stepper exposure device FPA-3000 i5+ (manufactured by Canon Inc.), the glass substrate was exposed through a mask having a 1 μm Bayer pattern at an exposure amount of 1000 mJ/cm$^2$. Next, puddle development was performed at 23°C for 60 seconds using a 0.3% by mass of tetramethylammonium hydroxide (TMAH) aqueous solution. Thereafter, the coating film was rinsed with a spin shower, washed with pure water, and heated using a hot plate at 200°C for 5 minutes to form a pattern (pixel). The glass substrate on which the pixel had been formed was observed with a microscope at a magnification of 10,000 times, and pattern formability was evaluated according to the following evaluation standard.

A: pattern could be formed.
B: pattern could not be formed.

[Table 3]

| | Evaluation result | | | | | |
|---|---|---|---|---|---|---|
| | Infrared shielding properties | | | Heat resistance | Light resistance | Pattern formability |
| | Average transmittance 1 | Average transmittance 2 | Average transmittance 3 | | | |
| Example 1 | B | A | C | B | B | B |
| Example 2 | B | A | C | B | B | A |
| Example 3 | B | A | C | A | A | A |
| Example 4 | B | A | C | A | A | A |
| Example 5 | A | A | C | A | A | A |
| Example 6 | A | A | C | A | A | A |
| Example 7 | A | A | C | A | A | A |
| Example 8 | A | A | C | A | A | A |
| Example 9 | A | A | C | A | A | A |

(continued)

| | Evaluation result | | | | | |
|---|---|---|---|---|---|---|
| | Infrared shielding properties | | | Heat resistance | Light resistance | Pattern formability |
| | Average transmittance 1 | Average transmittance 2 | Average transmittance 3 | | | |
| Example 10 | B | A | A | A | A | A |
| Example 11 | A | A | C | A | A | A |
| Example 12 | A | A | C | A | A | A |
| Example 13 | A | A | C | A | A | A |
| Example 14 | A | A | C | A | A | A |
| Example 15 | A | A | C | A | A | A |
| Example 16 | A | A | C | A | A | A |
| Example 17 | A | A | C | A | A | A |
| Example 18 | A | A | C | A | A | A |
| Example 19 | A | A | C | A | A | A |
| Example 20 | A | A | C | B | A | A |
| Example 21 | B | A | C | A | A | A |
| Example 22 | B | A | C | A | A | A |
| Example 23 | A | A | A | A | A | A |
| Example 24 | A | A | C | A | A | A |
| Example 25 | A | A | C | A | A | A |
| Example 26 | A | A | A | A | A | A |
| Example 27 | A | A | C | A | A | A |
| Example 28 | A | A | C | A | A | A |
| Example 29 | A | A | C | A | A | A |
| Example 30 | A | A | C | A | A | A |
| Example 31 | A | A | C | A | A | A |
| Example 32 | A | A | C | A | A | A |
| Example 33 | A | A | C | A | A | A |
| Comparative Example 1 | C | A | C | B | B | B |
| Comparative Example 2 | B | B | C | C | C | B |

As shown in the table, the compositions of Examples were capable of forming a film having excellent heat resistance, light resistance, and infrared shielding properties.

Explanation of References

110: solid-state imaging element
111: infrared cut filter
112: color filter

114: infrared transmitting filter
115: microlens
116: planarizing layer

## Claims

1. A composition comprising:

an infrared absorber; and
a curable compound,
wherein the infrared absorber contains a compound represented by Formula (1) and a compound other than the compound represented by Formula (1),

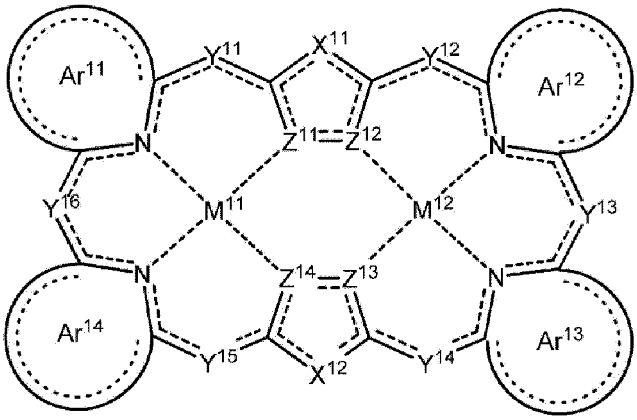

(1)

in Formula (1), $Ar^{11}$ to $Ar^{14}$ each independently represent a 5-membered nitrogen-containing aromatic ring which may be fused to form a polycyclic aromatic ring,
$Y^{11}$ to $Y^{16}$ each independently represent a nitrogen atom or $CR^{Y11}$, where $R^{Y11}$ represents a hydrogen atom or a substituent,
$X^{11}$ and $X^{12}$ each independently represent a nitrogen atom or $CR^{X11}$, where $R^{X11}$ represents a hydrogen atom or a substituent,
$Z^{11}$ and $Z^{14}$ each independently represent a carbon atom or a nitrogen atom,
$M^{11}$ and $M^{12}$ each independently represent a metal atom to which a ligand may be coordinated,
a bond shown by a dotted line between $Z^{11}$ and $M^{11}$ represents a covalent bond in a case where $Z^{11}$ is the carbon atom, and represents a coordinate bond or a covalent bond in a case where $Z^{11}$ is the nitrogen atom,
a bond shown by a dotted line between $Z^{12}$ and $M^{12}$ represents a covalent bond in a case where $Z^{12}$ is the carbon atom, and represents a coordinate bond or a covalent bond in a case where $Z^{12}$ is the nitrogen atom,
a bond shown by a dotted line between $Z^{13}$ and $M^{12}$ represents a covalent bond in a case where $Z^{13}$ is the carbon atom, and represents a coordinate bond or a covalent bond in a case where $Z^{13}$ is the nitrogen atom,
a bond shown by a dotted line between $Z^{14}$ and $M^{11}$ represents a covalent bond in a case where $Z^{14}$ is the carbon atom, and represents a coordinate bond or a covalent bond in a case where $Z^{14}$ is the nitrogen atom,
a bond shown by a dotted line between $M^{11}$ and N represents a coordinate bond or a covalent bond, and
a bond shown by a dotted line between $M^{12}$ and N represents a coordinate bond or a covalent bond.

2. The composition according to claim 1, wherein the compound other than the compound represented by Formula (1) is a compound in which a maximal absorption wavelength is present on a shorter wavelength side than the compound represented by Formula (1).

3. The composition according to claim 1 or 2,

wherein the compound represented by Formula (1) is at least one selected from a compound represented by Formula (1-1) or a compound represented by Formula (1-2),

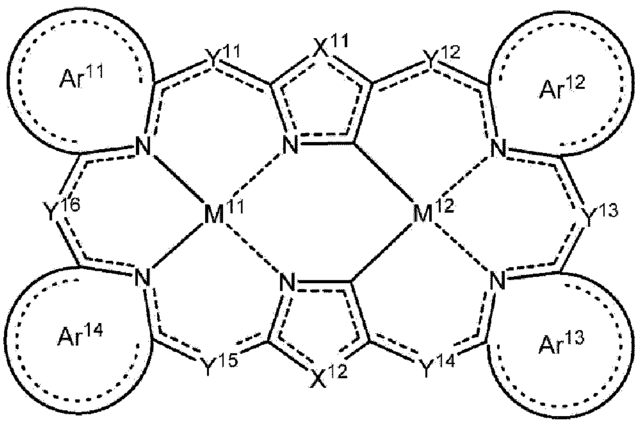

(1-1)

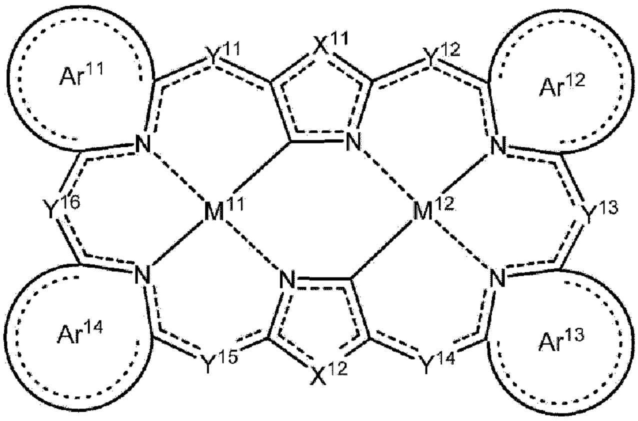

(1-2)

in Formula (1-1) and Formula (1-2), $Ar^{11}$ to $Ar^{14}$ each independently represent a 5-membered nitrogen-containing aromatic ring which may be fused to form a polycyclic aromatic ring,

$Y^{11}$ to $Y^{16}$ each independently represent a nitrogen atom or $CR^{Y11}$, where $R^{Y11}$ represents a hydrogen atom or a substituent,

$X^{11}$ and $X^{12}$ each independently represent a nitrogen atom or $CR^{X11}$, where $R^{X11}$ represents a hydrogen atom or a substituent,

$M^{11}$ and $M^{12}$ each independently represent a metal atom to which a ligand may be coordinated,

a bond shown by a dotted line between $M^{11}$ and N represents a coordinate bond, and a bond shown by a solid line between $M^{11}$ and N represents a covalent bond, and

a bond shown by a dotted line between $M^{12}$ and N represents a coordinate bond, and a bond shown by a solid line between $M^{12}$ and N represents a covalent bond.

**4.** The composition according to any one of claims 1 to 3,
wherein a maximal absorption wavelength of the compound represented by Formula (1) is present in a wavelength range of 1200 to 1500 nm.

**5.** A composition comprising:

an infrared absorber; and

a curable compound,

wherein the infrared absorber contains a metal complex in which a porphyrin compound having (4n + 2) $\pi$ electrons constituting a shortest ring which is capable of resonating around a metal atom is coordinated to the metal atom, and a compound other than the metal complex, where n is an integer of 6 to 15.

**6.** The composition according to claim 5,
wherein the compound other than the metal complex is a compound in which a maximal absorption wavelength is present on a shorter wavelength side than the metal complex.

7. The composition according to claim 5 or 6,
wherein a maximal absorption wavelength of the metal complex is present in a wavelength range of 1200 to 1500 nm.

8. The composition according to any one of claims 1 to 7,
wherein the curable compound contains a resin having an acid group.

9. The composition according to any one of claims 1 to 8,
wherein the curable compound contains a polymerizable compound.

10. The composition according to any one of claims 1 to 9,
wherein the curable compound contains a resin having a glass transition temperature of 150°C or higher.

11. A film formed of the composition according to any one of claims 1 to 10.

12. An optical filter comprising:
the film according to claim 11.

13. A solid-state imaging element comprising:
the film according to claim 11.

14. An image display device comprising:
the film according to claim 11.

15. An infrared sensor comprising:
the film according to claim 11.

FIG. 1

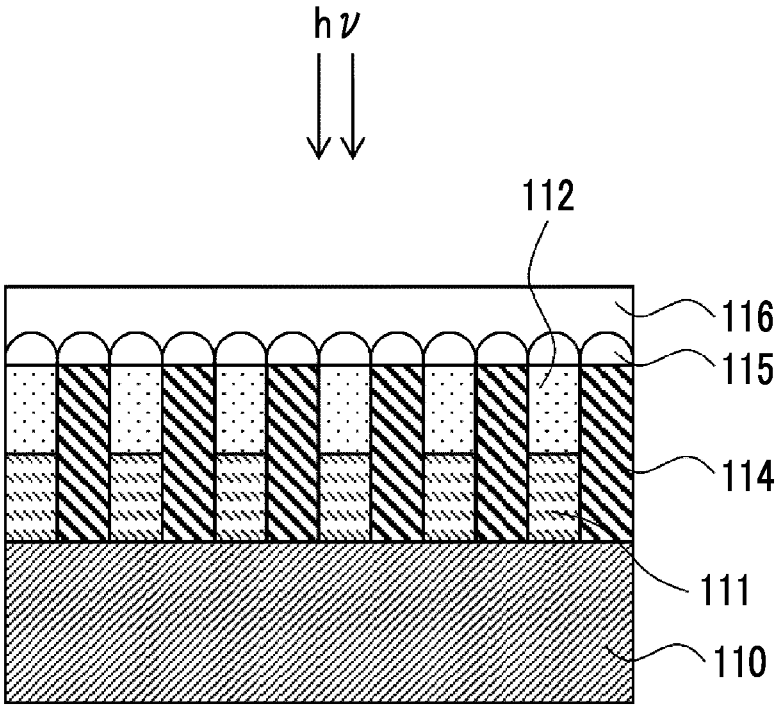

## INTERNATIONAL SEARCH REPORT

International application No.
**PCT/JP2021/045750**

**A. CLASSIFICATION OF SUBJECT MATTER**

***G02B 5/22***(2006.01)i; ***C08K 5/34***(2006.01)i; ***C08L 101/12***(2006.01)i; ***H01L 27/144***(2006.01)i; ***H01L 27/146***(2006.01)i; ***H01L 31/0232***(2014.01)i
FI: G02B5/22; C08L101/12; C08K5/34; H01L27/146 D; H01L27/144 K; H01L31/02 D

According to International Patent Classification (IPC) or to both national classification and IPC

**B. FIELDS SEARCHED**

Minimum documentation searched (classification system followed by classification symbols)

G02B5/22; C08K5/34; C08L101/12; H01L27/144; H01L27/146; H01L31/0232

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-182028 A (FUJIFILM CORP) 12 September 2013 (2013-09-12) claims, paragraphs [0020], [0202], [0228] | 1-15 |
| Y | WANG, Yue et al. Near-Infrared-III-Absorbing and -Emitting Dyes: Energy-Gap Engineering of Expanded Porphyrinoids via Metallation. Angewandte Chemie International Edition. 29 May 2020, vol. 59, pp. 16161-16166 fig. 1 | 1-15 |
| Y | WO 2019/177009 A1 (FUJIFILM CORP) 19 September 2019 (2019-09-19) paragraph [0304] | 10 |
| A | MURANAKA, Atsuya et al. Application of the Perimeter Model to the Assignment of the Electronic Absorption Spectra of Gold(III) Hexaphyrins with [4n+2] and [4n] π-Electron Systems. Chemistry a European Journal. 26 March 2009, vol. 15, pp. 3744-3751 entire text, all drawings | 1-15 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 January 2022** | **01 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

## INTERNATIONAL SEARCH REPORT
**Information on patent family members**

International application No.
**PCT/JP2021/045750**

| Patent document cited in search report | Publication date (day/month/year) | Patent family member(s) | Publication date (day/month/year) |
|---|---|---|---|
| JP 2013-182028 A | 12 September 2013 | (Family: none) | |
| WO 2019/177009 A1 | 19 September 2019 | US 2020/0355999 A1<br>paragraph [0522]<br>TW 201938700 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006209059 A
- JP 2009263614 A
- JP 2011068731 A
- WO 2015166873 A
- JP 2011208101 A
- JP 6065169 B
- WO 2016181987 A
- JP 2015176046 A
- WO 2016190162 A
- JP 2016074649 A
- JP 2017067963 A
- WO 2017135359 A
- JP 2017114956 A
- JP 6197940 B
- WO 2016120166 A
- JP 2009108267 A
- JP 2002194040 A
- JP 2015172004 A
- JP 2015172102 A
- JP 2008088426 A
- JP 2017031394 A
- JP 2017082029 A
- JP 2008528706 A
- JP 2012012399 A
- JP 2007092060 A
- WO 2018043564 A
- JP 2012077153 A
- JP 2006343631 A
- JP 2013195480 A
- JP 6081771 B
- WO 2020071470 A
- JP 5733804 B
- JP 2016006476 A
- WO 2017119394 A
- JP 2017197437 A
- JP 2017025311 A
- WO 2016154782 A
- JP 5884953 B
- JP 6036689 B
- JP 5810604 B
- WO 2017213047 A
- JP 2018054760 A
- JP 2018040955 A
- JP 2018002773 A
- JP 2018041047 A
- JP 2017179131 A
- JP 2017141215 A
- JP 2017068120 A
- JP 6251530 B
- JP 2020075959 A
- KR 1020190135217 A
- JP 2009288705 A
- JP 2013029760 A
- JP 2008292970 A
- JP 2013253224 A
- JP 2012208494 A
- JP 2017048367 A
- JP 6057891 B
- JP 6031807 B
- JP 2017194662 A
- JP 2013011869 A
- JP 2014043556 A
- JP 2014089408 A
- JP 2017179172 A
- JP 2004295116 A
- WO 2016088645 A
- JP 2017057265 A
- JP 2017032685 A
- JP 2017075248 A
- JP 2017066240 A
- JP 2017167513 A
- JP 2017173787 A
- JP 2017206689 A
- JP 2018010856 A
- JP 2016222891 A
- JP 2020122052 A
- JP 2020139021 A
- JP 2017138503 A
- US 20170102610 A
- JP 2010168539 A
- JP 2012255128 A
- JP 2013043962 A
- JP 6432077 B
- JP 2018087939 A
- WO 2016104803 A
- WO 2019125940 A
- JP 2020066687 A
- JP 2020066688 A
- JP 2019095548 A
- JP 2012137564 A
- JP 56118462 A
- JP S56118462 A
- JP 63264674 A
- JP S63264674 A
- JP 1217077 A
- JP H01217077 A
- JP 4009961 A
- JP H03009961 A

- JP 4026767 A
- JP H03026767 A
- JP 4153780 A
- JP H03153780 A
- JP 4045662 A
- JP H03045662 A
- JP 5285669 A
- JP H04285669 A
- JP 7145546 A
- JP H06145546 A
- JP 7212088 A
- JP H06212088 A
- JP 7240158 A
- JP H06240158 A
- JP 11030063 A
- JP H10030063 A
- JP 11195326 A
- JP H10195326 A
- WO 2011024896 A
- WO 2012102399 A
- WO 2017038252 A
- JP 2015151530 A
- JP 2011252065 A
- JP 2003081972 A
- JP 5299151 B
- JP 2015172732 A
- JP 2014199308 A
- JP 2014085562 A
- JP 2014035351 A
- JP 2008081565 A
- JP 2019109512 A
- JP 2019133154 A
- WO 2020002106 A
- WO 2015166779 A
- JP 2014130173 A
- JP 6301489 B
- WO 2018221177 A
- WO 2018110179 A
- JP 2019043864 A
- JP 2019044030 A
- JP 2019167313 A
- JP 2020055992 A
- JP 2013190459 A
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- JP 2014137466 A
- JP 6636081 B
- KR 1020160109444 A
- WO 2013083505 A
- JP 2010262028 A
- JP 2014500852 A
- JP 2013164471 A
- JP 2013114249 A
- JP 4223071 B
- WO 2015036910 A
- WO 2019088055 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- JP 2016075720 A
- JP 2017036379 A
- WO 2015118720 A
- CN 20106909027 A
- WO 2012102395 A
- JP 2019008014 A
- JP 2018180023 A
- JP 2019038958 A
- JP 2020076995 A
- JP 2012247591 A
- JP 2011157478 A
- JP 2017201003 A
- JP 2017197719 A
- JP 2017171912 A
- JP 2017171913 A
- JP 2017171914 A
- JP 2017171915 A
- JP 2013054339 A
- JP 2014026228 A
- JP 2018062644 A
- JP 2018203798 A
- JP 2018062578 A
- JP 6432076 B
- JP 2018155881 A
- JP 2018111757 A
- JP 2018040835 A
- JP 2017197640 A
- JP 2016145282 A
- JP 2014085565 A
- JP 2014021139 A
- JP 2013209614 A
- JP 2013209435 A
- JP 2013181015 A
- JP 2013061622 A
- JP 2013032486 A
- JP 2012226110 A
- JP 2008074987 A
- JP 2008074986 A

- JP 2008074985 A
- JP 2008050420 A
- JP 2008031281 A
- JP 48032765 A
- JP 6607427 B
- JP 2019073695 A
- JP 2019073696 A
- JP 2019073697 A
- JP 2019073698 A
- KR 1020140034963 A
- JP 2017095706 A
- TW 201920495 A
- JP 2020033525 A
- JP 2020033524 A
- JP 2020033523 A
- JP 2020033522 A
- JP 2020033521 A
- WO 2020045200 A
- WO 2020045199 A
- WO 2020045197 A
- JP 2020093994 A
- JP 2020083982 A
- WO 2020105346 A
- JP 2020517791 A
- JP 2017201384 A
- JP 6248838 B
- WO 2012117965 A
- JP 2012229344 A
- JP 6516119 B
- JP 6525101 B
- JP 2020090632 A
- KR 1020190140741 A
- KR 1020190140744 A
- JP 2020079396 A
- JP 6561862 B
- JP 6413872 B
- JP 6281345 B
- JP 2020026503 A
- JP 2020097744 A
- JP 2012158649 A
- JP 2011184493 A
- JP 2011145540 A
- KR 1020200028160 A
- JP 2020117638 A
- WO 2020174991 A
- JP 2010534726 A
- JP 2012515233 A
- JP 2012515234 A
- JP 2017226821 A
- JP 1170601 A
- JP H01170601 A
- JP 2034664 A
- JP H02034664 A
- JP 2020008634 A
- JP 2014041318 A
- WO 2014017669 A
- JP 2011132503 A
- JP 2016216602 A
- JP 2010032698 A
- JP 2010164965 A
- JP 2015117327 A
- WO 2020084854 A
- JP 2009288703 A
- JP 2009242604 A
- JP 2009217221 A
- JP 2012208374 A
- JP 2013068814 A
- JP 2016162946 A
- JP 6268967 B
- WO 2020137819 A
- WO 2017006600 A
- WO 2017164024 A
- JP 2012003225 A
- US 20130034812 A
- JP 2008250074 A
- WO 2014021023 A
- WO 2017030005 A
- JP 2017008219 A
- JP 2015123351 A
- JP 2015157893 A
- JP 2015194521 A
- JP 2012046629 A
- JP 2009145395 A
- JP 2003262716 A
- JP 2003185831 A
- JP 2003261827 A
- JP 2012126830 A
- JP 2006169325 A
- KR 1020170122130 A
- JP 2013064993 A
- WO 2015099060 A
- JP 2012227478 A
- JP 2014179577 A
- JP 2003045676 A

**Non-patent literature cited in the description**

- *The Chemical Daily,* 13 November 2015
- *MATERIAL STAGE,* 2019, vol. 19 (3), 37-60
- *Journal of Photopolymer Science and Technology,* 1995, 202-232
- *The Chemical Daily,* 22 February 2016
- *Nikkei Business Daily,* 23 February 2016
- **MIYOSHI OIL ; FAT CO., LTD.** *The Chemical Daily,* 01 February 2016
- Dispersion Technology Comprehension. Johokiko Co., Ltd, 15 July 2005
- Extension of Use of Ink Jet - Infinite Possibilities in Patent. S.B. Research Co., Ltd, February 2005

- **AKIO SASAKI.** Electronic Display Device. Kogyo Chosakai Publishing Co., Ltd, 1990
- Liquid Crystal Display Technology for Next Generation. Kogyo Chosakai Publishing Co., Ltd, 1994
- The Forefront of Organic EL Technology Development -Know-How Collection of High Brightness, High Precision, and Long Life. Technical Information Institute, 2008, 326-328